# EUROPEAN PATENT APPLICATION

(11) **EP 3 569 605 A1**
(43) Date of publication of application: **20.11.2019**
(21) Application number: 18173230.6
(22) Date of filing: 18.05.2018
(51) Int. Cl.: C07F 15/00, C09K 11/00, H01L 51/50, H05B 33/10

(54) **NOVEL ELECTROLUMINESCENT METAL COMPLEXES AND AN ORGANIC ELECTROLUMINESCENCE DEVICE COMPRISING THE SAME**

(71) Applicant: Idemitsu Kosan Co., Ltd., Chiyoda-ku, Tokyo 100-8321 (JP)
(72) Inventor: MURER, Peter, 4104 Oberwil (CH); ALLENBACH, Stephan, 4334 Sisseln (CH); NAGASHIMA, Hideaki, Sodegaura-shi Chiba 299-0293 (JP); SCHÄFER, Thomas, 4410 Liestal (BL) (CH); CHEBOTAREVA, Natalia, 68220 Hagenthal le Bas (FR)
(74) Representative: Hollah, Dorothee

(57) **Abstract**

Metal complexes comprising a imidazo[1,2-a]-imidazoyl-type substituent comprising a ligand of the general formula (**IA**), (**IB**), (**IC**), organic electronic devices, especially OLEDs (Organic Light-Emitting Diodes) which comprise such complexes, a light-emitting layer comprising at least one inventive metal complex, an apparatus selected from the group consisting of illuminating elements, stationary visual display units and mobile visual display units comprising such an OLED, and the use of such a metal complex for electrophotographic photoreceptors, photoelectric converters, organic solar cells (organic photovoltaics), switching elements, organic light emitting field effect transistors (OLEFETs), image sensors, dye lasers and electroluminescent devices.

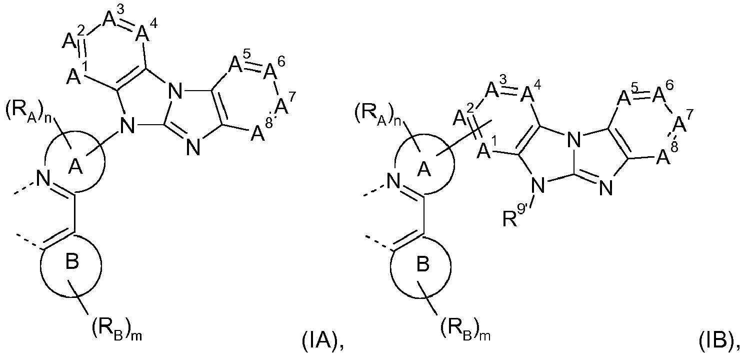

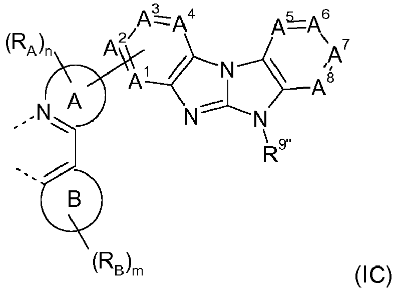

## Description

The present invention relates to metal complexes comprising a imidazo[1,2-a]-imidazoyl-type substituent comprising ligand of the general formula (**IA**), (**IB**), (**IC**), to organic electronic devices, especially OLEDs (Organic Light-Emitting Diodes) which comprise such complexes, to a light-emitting layer comprising at least one inventive metal complex, to an apparatus selected from the group consisting of illuminating elements, stationary visual display units and mobile visual display units comprising such an OLED, and to the use of such a metal complex for electrophotographic photoreceptors, photoelectric converters, organic solar cells (organic photovol-taics), switching elements, organic light emitting field effect transistors (OLEFETs), image sensors, dye lasers and electroluminescent devices.

Organic light-emitting diodes (OLEDs) exploit the propensity of materials to emit light when they are excited by electrical current. OLEDs are of particular interest as an alternative to cathode ray tubes and liquid-crystal displays for production of flat visual display units. Owing to the very compact design and the intrinsically low power consumption, devices comprising OLEDs are suitable especially for mobile applications, for example for applications in cellphones, smartphones, digital cameras, mp3 players, laptops, etc. In addition, white OLEDs give great advantages over the illumination technologies known to date, especially a particularly high efficiency.

The art proposes numerous materials which emit light on excitation by electrical current. Materials which emit light on excitation by electrical current comprising imidazo[1,2-a]-imidazoyl-type groups are not explicitly mentioned in the art.

US 2014/0021447 A1 describes heteroleptic complexes having at least one diarylamino or carbazole group connected at the 3-position of the pyridine unit useful as light emitting material.

US 2014/0306205 A1 discloses a compound having the following formula: 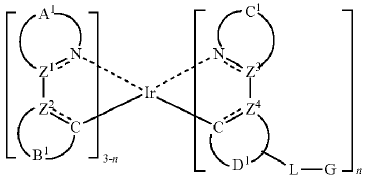 wherein L represents a single bond or a linking group and G represents a fused ring with 3 or more rings. L is connected to the ligand unit which is bonded to the iridium atom via the sp²-carbon atom.

WO 2013/142633 A1 relates to green luminescent materials of the following formula and their use in electronic devices: 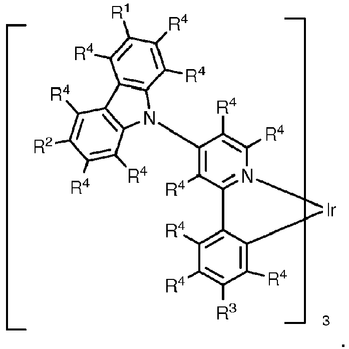 The complexes mentioned in WO 2013/142633 A1 are homoleptic.

US 2010/0270540 A1 relates to iridium complexes with phosphorescent properties and organic light emitting diodes with improved heat-resistance and light emitting properties containing the same.

WO 2011/141120 A1 concerns metal complexes having improved solubility having the general formula M(L)ₙ(L')ₘ and comprising a part M(L)ₙ:

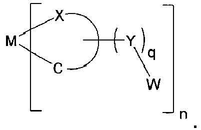

However, also nowhere in US 2014/0021447 A1, US 2014/0306205 A1, WO 2013/142633 A1, US 2010/0270540 A1 and WO 2011/141120 A1 imidazo[1,2-a]-imidazoyl-type groups and derivatives thereof are suggested.

One important application for phosphorescent emissive molecules is a full color display. Industry standards for such a display call for pixels adapted to emit the particular colors: saturated red, green and blue pixels. The color may be measured using CIE coordinates, which are well-known to a person skilled in the art.

There is therefore a need to provide further phosphorescent emissive molecules emitting with high quantum efficiency and good color purity in the red, green and blue area of the electromagnetic spectrum.

It is an object of the present invention to provide further emissive molecules with improved properties based on transition metal complexes, preferably emitting in the green to yellow region, preferably in green to yellow-green region, of the visible electromagnetic spectrum. In the meaning of the present application, the inventive metal complexes preferably having a λₘₐₓ of 510 to 590 nm, more preferably of 520 to 590 nm, even more preferably of 520 to 550 nm.
It is a further object of the present invention to provide organic electronic devices, preferably OLEDs, having a good overall performance and - compared with the organic electronic devices known in the art - a high efficiency.

The object is achieved by a metal complex comprising at least one ligand of formulae (IA), (IB) or (IC) 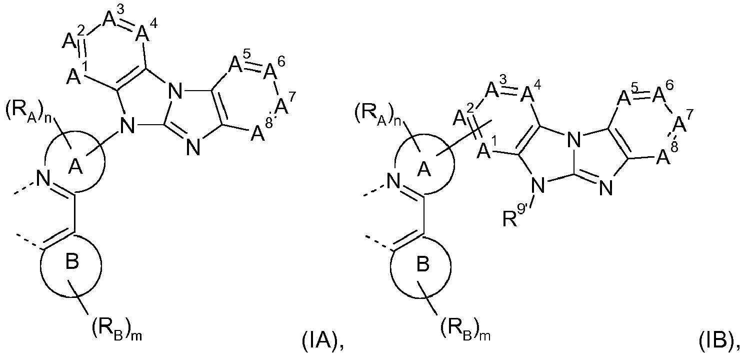 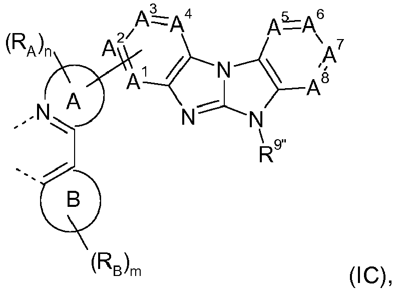 preferably of formula (IA),
wherein
ring A is a heterocyclic group having 5 to 30 ring atoms, preferably a five or six membered heterocyclic ring, more preferably a five or six membered heteroaromatic ring,
ring B is an aromatic hydrocarbon group having 6 to 30 ring atoms, preferably an aromatic hydrocarbon group having 5 or 6 ring carbon atoms or a heterocyclic group having 5 to 30 ring atoms, preferably a heterocyclic group having 5 or 6 ring atoms, more preferably a heteroaromatic group having 6 ring atoms,
wherein A-B represents a bonded pair of hydrocarbon or heterocyclic rings coordinated to the metal via a nitrogen atom on ring A and via an sp² hybridized carbon atom on ring B,
R_{A} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 carbon atoms, a substituted or unsubstituted heterocyclic group having 5 to 30 ring atoms, CN, an -OR^{c'} group, an -SR^{c'} group or an SiR^{d'}R^{e'}R^{f'} group;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
n is 0, 1 or 2, preferably 0 or 1,
R_{B} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, a substituted or unsubstituted heterocyclic group having 5 to 30 ring atoms, CN, an -OR^{c'} group, an -SR^{c'} group or an SiR^{d'}R^{e'}R^{f'} group;
and one of R_{B} may be -SR^{a'}, -OR^{a'} or -NR^{a'}R^{b'},
one of R_{A} and one of R_{B} may be connected to each other and form a bridge, for example 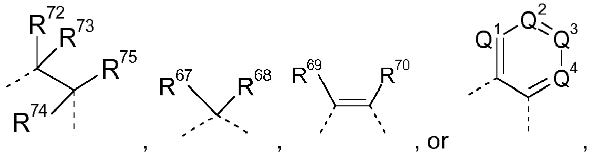 preferably 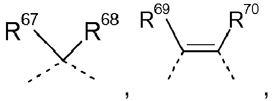 or 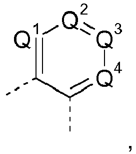 wherein
   R⁶⁷, R⁶⁸, R⁶⁹, R⁷⁰, R⁷², R⁷³, R⁷⁴ and R⁷⁵ are each independently hydrogen, deuterium, C₁-C₄-alkyl, C₁-C₄-haloalkyl, substituted or unsubstituted phenyl, or substituted or unsubstituted heteroaryl having 5 or 6 ring atoms;
   Q¹, Q², Q³ and Q⁴ are each independently CR⁷¹ or N, wherein preferably 0 or 1 group Q¹, Q², Q³ or Q⁴ are N and the remaining groups Q¹, Q², Q³ and Q⁴ are CR⁷¹;
   R⁷¹ is hydrogen, deuterium, C₁-C₄-alkyl, C₁-C₄-fluoroalkyl, substituted or unsubstituted phenyl, or substituted or unsubstituted heteroaryl having 5 or 6 ring atoms;
   R^{a'}, R^{b'} are each independently a substituted or unsubstituted aromatic hydrocarbon group having 6 to 30 ring carbon atoms, a substituted or unsubstituted heterocyclic group having 5 to 30 ring atoms,
   m is 0, 1, 2 or 3, preferably 0, 1 or 2,
   in the case that m is ≥ 2, two adjacent residues R_{B} may form together a ring, preferably a five or six membered ring, which is unsubstituted or substituted and may be fused with one or more, preferably one, further unsubstituted or substituted carbocyclic or heterocyclic five or six membered ring,
   A¹ is CR¹ or N, A² is CR² or N, A³ is CR³ or N, A⁴ is CR⁵ or N, A⁵ is CR⁵ or N, A⁶ is CR⁶ or N, A⁷ is CR⁷ or N and A⁸ is CR⁸ or N, whereby preferably 0, 1 or 2, more preferably 0 or 1, most preferably 0 of A¹ to A⁸ are N,
   wherein - in formula (IB) and (IC) one of A¹, A², A³ and A⁴ is CR¹, CR², CR³ respectively CR⁴, wherein R¹, R², R³ respectively R⁴ is a bonding site to the ring A,
   R¹, R², R³, R⁴, R⁵, R⁶, R⁷ and R⁸ are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted heterocyclic group, having 5 to 30 ring atoms, CN, an -OR^{c'} group, an -SR^{c'} group or an SiR^{d'}R^{e'}R^{f'} group; provided that, two substituents selected from R¹, R², R³, R⁴ respectively from R⁵, R⁶, R⁷ and R⁸ may be bonded to each other to form a ring structure,
   R^{9'}, R^{9"} are each independently a substituted or unsubstituted aromatic hydrocarbon group having 6 to 30 ring carbon atoms, or a substituted or unsubstituted heterocyclic group having 5 to 30 ring atoms, and
   the metal is selected from Ir and Pt,
   wherein the dotted lines are bonding sites.

It has been found by the inventors of the present invention that the inventive metal complexes mentioned above preferably emit light in the green to yellow area, more preferably in the green to yellow-green area of the visible electromagnetic spectrum. I.e. the inventive metal complexes preferably having a λₘₐₓ of 510 to 590 nm, more preferably of 520 to 590 nm, even more preferably of 520 to 550 nm. The preferred CIE-y coordinate of the inventive metal complexes is preferably higher than 0.45, even more preferably higher than 0.55. This enables for example the production of white OLEDs, or full-color displays.

It has been further found by the inventors of the present application that the metal complexes comprising a imidazo[1,2-a] -imidazoyl substituent comprising ligand according to the present invention are useful as material for organic electronic devices, preferably OLEDs, having a good overall performance, especially good operational lifetimes and/or low voltage, and - compared with the organic electronic devices known in the art - a high efficiency.

Any colour can be expressed by the chromaticity coordinates x and y on the CIE chromaticity diagram. The boundaries of this horseshoe-shaped diagram are the plots of monochromatic light, called spectrum loci, and all the colours in the visible spectrum fall within or on the boundary of this diagram. The arc near the centre of the diagram is called the Planckian locus, which is the plot of the coordinates of black body radiation at the temperatures from 1000 K to 20000 K, described as CCT.

The correlated colour temperature (CCT) is the temperature of a blackbody radiator that has a colour that most closely matches the emission from a nonblackbody radiator.

I.e. the inventive metal complexes preferably having a λₘₐₓ of 510 to 590 nm, more preferably of 520 to 590 nm, even more preferably of 520 to 550 nm.

The metal complexes of the present invention preferably emit green to yellow light (λₘₐₓ of 510 to 590 nm), more preferably green to yellow green light (λₘₐₓ of 520 to 590 nm, even more preferably λₘₐₓ of 520 to 550 nm), preferably with a FWHM (full width at half maximum) of 20 nm to 140 nm, more preferably of 40 nm to 100 nm, most preferably 50 nm to 90 nm.

The metal complex according to the present invention is preferably - at room temperature (i.e. at 25 °C) - a phosphorescent emitter.

The phosphosphorescent emitters according to the present invention emit preferably from triplet excited states. Phosphorescence may be preceded by a transition from a triplet excited state to an intermediate non-triplet state from which the emissive decay occurs. For example, organic molecules coordinated to lanthanide elements often phosphoresce from excited states localized on the lanthanide metal. However, such materials do not phosphoresce directly from a triplet excited state but instead emit from an atomic excited state centered on the lanthanide metal ion. The europium diketonate complexes illustrate one group of these types of species.

The absolute photoluminescence quantum yield of the metal complexes of the present invention (measured at room temperature (in the context of the present invention "room temperature" is 25°C) is in general at least 50%, preferably at least 70%, e.g. 50 to 95 %, more preferably 70 to 95 %.

The determination of the photoluminescence spectra of the inventive metal complexes is described below.

FIG. 1 is a schematic illustration showing an example of the structure of an organic electroluminescence device according to an embodiment of the invention.

The residues mentioned in the specification of the present application generally have the following preferred meanings, if said residues are not further specified in specific embodiments mentioned below:
The aromatic hydrocarbon group having 6 to 30 ring carbon atoms, preferably 6 to 18 ring carbon atoms, may be a non-condensed aromatic hydrocarbon group or a condensed aromatic hydrocarbon group. Specific examples thereof include phenyl group, naphthyl group, phenanthryl group, biphenyl group, terphenyl group, quaterphenyl group, fluoranthenyl group, triphenylenyl group, phenanthrenyl group, fluorenyl group, anthracenyl, chrysenyl, spirofluorenyl group, 9,9-diphenylfluorenyl group, 9,9'-spirobi[9H-fluorene]-2-yl group, 9,9-dimethylfluorenyl group, benzo[c]phenanthrenyl group, benzo[a]triphenylenyl group, naphtho[1,2-c]phenanthrenyl group, naphtho[1,2-a]triphenylenyl group, dibenzo[a,c]triphenylenyl group, and benzo[b]fluoranthenyl group, with phenyl group, naphthyl group, biphenyl group, terphenyl group, phenanthryl group, triphenylenyl group, fluorenyl group, spirobifluorenyl group, and fluoranthenyl group being preferred, and phenyl group, 1-naphthyl group, 2-naphthyl group, biphenyl-2-yl group, biphenyl-3-yl group, biphenyl-4-yl group, phenanthrene-9-yl group, phenanthrene-3-yl group, phenanthrene-2-yl group, triphenylene-2-yl group, 9,9-dimethylfluorene-2-yl group, fluoranthene-3-yl group being more preferred. The aromatic hydrocarbon group is substituted or unsubstituted. More preferred is a unsubstituted or substituted phenyl group or a unsubstituted or substituted biphenyl group. Most preferred is a unsubstituted or substituted phenyl group.

The heterocyclic group having 5 to 30 ring atoms, preferably 5 to 18 ring atoms, may be a non-condensed heterocyclic group or a condensed heterocyclic group. Specific examples thereof include the residues of pyrrole ring, isoindole ring, benzofuran ring, isobenzofuran ring, benzothiophene, dibenzothiophene ring, isoquinoline ring, quinoxaline ring, phenanthridine ring, phenanthroline ring, pyridine ring, pyrazine ring, pyrimidine ring, pyridazine ring, triazine ring, indole ring, quinoline ring, acridine ring, carbazole ring, furan ring, thiophene ring, oxazole ring, oxadiazole ring, benzoxazole ring, thiazole ring, thiadiazole ring, benzothiazole ring, triazole ring, imidazole ring, benzimidazole ring, dibenzofuran ring and benzo[c]dibenzofuran ring, and the residues of derivatives of these rings, with the residues of dibenzofuran ring, carbazole ring, dibenzothiophene ring, and derivatives of these rings being preferred, and the residues of dibenzofuran-2-yl group, dibenzofuran-4-yl group, 9-phenylcarbazole-3-yl group, 9-phenylcarbazole-2-yl group, dibenzothiophene-2-yl group, and dibenzothiophene-4-yl group being more preferred. The heterocyclic group is substituted or unsubstituted. More preferred are the residues of a benzofuran ring, which may be unsubstituted or substituted. Suitable dibenzofuran rings are shown below.

Examples of the alkyl group having 1 to 30 carbon atoms include methyl group, ethyl group, n-propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group, 1-methylpentyl group, with methyl group, ethyl group, n-propyl group, isopropyl group, n-butyl group, s-butyl group, isobutyl group, t-butyl group being preferred. The alkyl group is substituted or unsubstituted.

Examples of the cycloalkyl group having 3 to 20 carbon atoms include cyclopropyl group, cyclobutyl group, cyclopentyl group, cyclohexyl group, cyclooctyl group, and adamantyl group, with cyclopentyl group, and cyclohexyl group being preferred. The cycloalkyl group is substituted or unsubstituted.

Examples of an aralkyl group having 7 to 24 carbon atoms, preferably 7 to 20 carbon atoms, include 2-phenylpropane-2-yl group, 2-phenylethyl group, 1-phenylisopropyl group, 2-phenylisopropyl group, phenyl-t-butyl group, 1-α-naphthylethyl group, 2-α-naphthylethyl group, 1-α-naphthylisopropyl group, 2-α-naphthylisopropyl group, 1-β-naphthylethyl group, 2-β-naphthylethyl group, 1-β-naphthylisopropyl group, 2-β-naphthylisopropyl group. The aralkyl group is substituted or unsubstituted.

Examples of the alkylene group (i.e. alkane-diyl group) having 1 to 30 carbon atoms represented include methylene group, ethylene group, n-propylene group, isopropylene group, n-butylene group, s-butylene group, isobutylene group, t-butylene group, n-pentylene group, n-hexylene group, n-heptylene group, n-octylene group, n-nonylene group, n-decylene group, n-undecylene group, n-dodecylene group, n-tridecylene group, n-tetradecylene group, n-pentadecylene group, n-hexadecylene group, n-heptadecylene group, n-octadecylene group, neopentylene group, 1-methylpentylene group, with methylene group, ethylene group, n-propylene group, isopropylene group, n-butylene group, s-butylene group, isobutylene group, t-butylene group being preferred. More preferred is a methylene group or an ethylene group. The alkylene group is substituted or unsubstituted.

Examples of the cycloalkylene group (i.e. cycloalkane-diyl group) having 3 to 20 carbon atoms include cyclopropylene group, cyclobutylene group, cyclopentylene group, cyclohexylene group, cyclooctylene group, and adamantylene group, with cyclopentylene group, and cyclohexylene group being preferred. The cycloalkylene group is substituted or unsubstituted.

The arylene group is preferably a divalent aromatic hydrocarbon group having 6 to 30 ring carbon atoms may be a non-condensed divalent aromatic hydrocarbon group or a condensed divalent aromatic hydrocarbon group. Specific examples thereof include phenylene group, naphthylene group, phenanthrylene group, biphenyl-diyl group, fluoranthen-diyl group, phenanthrene-diyl group, fluorene-diyl group, spirofluorene-diyl group, 9,9-diphenylfluorene-diyl group, 9,9'-spirobi[9H-fluorene]-2-diyl group, 9,9-dimethylfluorene-diyl group, with phenylene group, naphthylene group, biphenyl-diyl group, fluorene-diyl group, spirobifluorene-diyl group, and fluoranthene-diyl group being preferred, and 1,2-phenylene group, 1,3-phenylene group, 1,4-phenylene group, 1,4-naphthylene group, 1,8-naphthylene group, 2,6-naphthylene group, 2,7-naphthylene group, biphenyl-2,2'-diyl group, biphenyl-2,3'-diyl group, biphenyl-2,4'-diyl group, biphenyl-2,5'-diyl group, biphenyl-2,6'-diyl group, biphenyl-3,3'-diyl group, biphenyl-3,4'-diyl group, biphenyl-3,5'-diyl group, biphenyl-3,6'-diyl group, biphenyl-4,4'-diyl group, biphenyl-4,5'-diyl group, biphenyl-4,6'-diyl group, biphenyl-5,5'-diyl group, biphenyl-5,6'-diyl group, biphenyl-6,6'-diyl group, phenanthrene-9,10-diyl group, phenanthrene-2,3-diyl group, phenanthrene-2,7-diyl group, phenanthrene-2,8-diyl group, phenanthrene-2,6-diyl group, phenanthrene-2,9-diyl group, phenanthrene-2,10-diyl group, phenanthrene-3,9-diyl group, phenanthrene-3,10-diyl group, 9,9-dimethylfluorene-3,7-diyl group, 9,9-dimethylfluorene-1,4-diyl group, fluoranthene-3,9-diyl group, fluoranthene-3,8-diyl group, fluoranthene-3,4-diyl group, fluoranthene-3,5-diyl group, fluoranthene-3,6-diyl group, fluoranthene-2,9-diyl group, fluoranthene-2,8-diyl group, fluoranthene-2,4-diyl group, fluoranthene-2,5-diyl group, fluoranthene-2,6-diyl group, fluoranthene-1,9-diyl group, fluoranthene-1,8-diyl group, fluoranthene-1,4-diyl group, fluoranthene-1,5-diyl group, fluoranthene-1,6-diyl group being more preferred. Most preferred are a 1,2-phenylene group, 1,3-phenylene group, 1,4-phenylene group, 1,4-naphthylene group, 1,8-naphthylene group, 2,6-naphthylene group, 2,7-naphthylene group, biphenyl-2,2'-diyl group, biphenyl-2,3'-diyl group, biphenyl-2,4'-diyl group, biphenyl-2,5'-diyl group, biphenyl-2,6'-diyl group, biphenyl-3,3'-diyl group, biphenyl-3,4'-diyl group, biphenyl-3,5'-diyl group, biphenyl-3,6'-diyl group, biphenyl-4,4'-diyl group, biphenyl-4,5'-diyl group, biphenyl-4,6'-diyl group, biphenyl-5,5'-diyl group, biphenyl-5,6'-diyl group and a biphenyl-6,6'-diyl group. The arylene group is substituted or unsubstituted.

The heteroarylene group is preferably a divalent heterocyclic group having 5 to 30 ring atoms may be a non-condensed heterocyclic group or a condensed heterocyclic group. Specific examples thereof include the divalent residues of pyrrole ring, isoindole ring, benzofuran ring, isobenzofuran ring, dibenzothiophene ring, isoquinoline ring, quinoxaline ring, phenanthridine ring, pyridine ring, pyrazine ring, pyrimidine ring, pyridazine ring, triazine ring, indole ring, quinoline ring, acridine ring, carbazole ring, furan ring, thiophene ring, oxazole ring, oxadiazole ring, benzoxazole ring, thiazole ring, thiadiazole ring, benzothiazole ring, triazole ring, imidazole ring, benzimidazole ring, dibenzofuran ring, and benzo[c]dibenzofuran ring, and the divalent residues of derivatives of these rings, with the divalent residues of dibenzofuran ring, carbazole ring, dibenzothiophene ring, and derivatives of these divalent rings being preferred. The heteroarylene group is substituted or unsubstituted.

Examples of the optional substituent(s) indicated by "substituted or unsubstituted" and "may be substituted" referred to above or hereinafter include a cyano group, an alkyl group having 1 to 30, preferably 1 to 6 carbon atoms, a cycloalkyl group having 3 to 20, preferably 5 to 12 carbon atoms, a fluoroalkyl group having 1 to 20, preferably 1 to 5 carbon-atoms, a silyl group, an aromatic hydrocarbon group having 6 to 30 ring carbon atoms, preferably 6 to 18 ring carbon atoms, an aryloxy group having 6 to 30, preferably 6 to 18 ring carbon atoms, an aralkyl group having 7 to 24, preferably 7 to 20 carbon atoms, an arylthio group having 6 to 30, preferably 6 to 18 ring carbon atoms, an arylamino group having 6 to 30 carbon atoms, preferably 6 to 18 carbon atoms, and a heterocyclic group having 5 to 30 ring atoms, preferably 5 to 18 ring atoms.

The optional substituent is preferably a cyano group, an alkyl group having 1 to 30 carbon atoms, an aromatic hydrocarbon group having 6 to 30 ring carbon atoms, preferably 6 to 18 ring carbon atoms, and an heterocyclic group having 5 to 30 ring atoms, preferably 5 to 18 ring atoms; more preferably a phenyl group, a biphenyl group a fluorenyl group, a residue based on a dibenzofuran ring, a residue based on a carbazole ring, a residue based on a dibenzothiophene ring, and their derivatives, a methyl group, an ethyl group, an n-propyl group, an isopropyl group, an n-butyl group, an s-butyl group, an isobutyl group, a t-butyl group, a cyclopentyl group, and a cyclohexyl group.

The optional substituent mentioned above may be further substituted by one or more of the optional substituents mentioned above.

The number of the optional substituents depends on the group which is substituted by said substituent(s). Preferred are 1, 2, 3 or 4 optional substituents, more preferred are 1, 2 or 3 optional substituents, most preferred are 1 or 2 optional substituents. In a further preferred embodiment, the groups mentioned above are unsubstituted.

Examples of silyl groups include arylsilyl groups having 6 to 30 carbon atoms, preferably 6 to 18 carbon atoms, including triphenylsilyl group.

Examples of halogen atoms include fluorine.

Examples of a fluoroalkyl group having 1 to 20 carbon atoms include the alkyl groups mentioned above wherein the hydrogen atoms thereof are partly or entirely substituted by halogen atoms.

Examples of an aryloxy group having 6 to 30 ring carbon atoms include those having an aryl portion selected from the aromatic hydrocarbon groups mentioned above.

Examples of an arylthio group having 6 to 30 ring carbon atoms include those having an aryl portion selected from the aromatic hydrocarbon groups mentioned above.

Examples of an arylamino group having 6 to 30 ring carbon atoms include those having an aryl portion selected from the aromatic hydrocarbon groups mentioned above.

The term of "XX to YY carbon atoms" referred to by "a substituted or unsubstituted group ZZ having XX to YY carbon atoms" used herein is the number of carbon atoms of the unsubstituted group ZZ and does not include any carbon atom in the substituent of the substituted group ZZ. " YY" is larger than "XX" and each of "XX" and "YY" represents an integer of 1 or more.

The term of "XX to YY atoms" referred to by "a substituted or unsubstituted group ZZ having XX to YY atoms" used herein is the number of atoms of the unsubstituted group ZZ and does not include any atom in the substituent of the substituted group ZZ. "YY" is larger than "XX" and each of "XX" and "YY" represents an integer of 1 or more.

The term of "unsubstituted group ZZ" referred to by "a substituted or unsubstituted group ZZ" used herein means the group ZZ wherein no hydrogen atom is substituted by a substituent.

The number of "ring carbon atoms" referred to herein means the number of the carbon atoms included in the atoms which are members forming the ring itself of a compound in which a series of atoms is bonded to form the ring (for example, a monocyclic compound, a fused ring compound, a cross-linked compound, a carbocyclic compound, and a heterocyclic compound). If the ring has a substituent, the carbon atom in the substituent is not included in the ring carbon atom. The same applies to the number of "ring carbon atom" described below, unless otherwise noted. For example, a benzene ring has 6 ring carbon atoms, a naphthalene ring has 10 ring carbon atoms, a pyridinyl group has 5 ring carbon atoms, and a furanyl group has 4 ring carbon atoms. If a benzene ring or a naphthalene ring has, for example, an alkyl substituent, the carbon atom in the alkyl substituent is not counted as the ring carbon atom of the benzene or naphthalene ring. In case of a fluorene ring to which a fluorene substituent is bonded (inclusive of a spirofluorene ring), the carbon atom in the fluorene substituent is not counted as the ring carbon atom of the fluorene ring.

The number of "ring atom" referred to herein means the number of the atoms which are members forming the ring itself (for example, a monocyclic ring, a fused ring, and a ring assembly) of a compound in which a series of atoms is bonded to form the ring (for example, a monocyclic compound, a fused ring compound, a cross-linked compound, a carbocyclic compound, and a heterocyclic compound). The atom not forming the ring (for example, hydrogen atom(s) for saturating the valence of the atom which forms the ring) and the atom in a substituent, if the ring is substituted, are not counted as the ring atom. The same applies to the number of "ring atoms" described below, unless otherwise noted. For example, a pyridine ring has 6 ring atoms, a quinazoline ring has 10 ring atoms, and a furan ring has 5 ring atoms. The hydrogen atom on the ring carbon atom of a pyridine ring or a quinazoline ring and the atom in a substituent are not counted as the ring atom. In case of a fluorene ring to which a fluorene substituent is bonded (inclusive of a spirofluorene ring), the atom in the fluorene substituent is not counted as the ring atom of the fluorene ring.

The definition of "hydrogen atom" used herein includes isotopes different in the neutron numbers, i.e., light hydrogen (protium), heavy hydrogen (deuterium), and tritium.

The term "unsubstituted" referred to by "substituted or unsubstituted" means that a hydrogen atom is not substituted by the group mentioned above.

### Metal complexes according to the present invention

**The group** 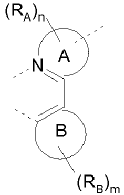 In the group 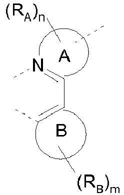
ring A is a heterocyclic group having 5 to 30 ring atoms, preferably a five or six membered heterocyclic ring, more preferably a five or six membered heteroaromatic ring, most preferably a six membered heteroaromatic ring, further most preferably a pyridyl ring;
ring B is an aromatic hydrocarbon group having 6 to 30 ring atoms, preferably an aromatic hydrocarbon group having 5 or 6 ring carbon atoms, or a heterocyclic group having 5 to 30 ring atoms, preferably a heterocyclic group having 5 or 6 ring atoms, more preferably a heteroaromatic group having 6 ring atoms; preferably, ring B is an aromatic hydrocarbon group having 6 to 30 ring atoms, preferably an aromatic hydrocarbon group having 5 or 6 ring carbon atoms, more preferably a phenyl group;
wherein A-B represents a bonded pair of hydrocarbon or heterocyclic rings coordinated to the metal via a nitrogen atom on ring A and via an sp² hybridized carbon atom on ring B,
R_{A} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 carbon atoms, a substituted or unsubstituted heterocyclic group having 5 to 30 ring atoms, an -OR^{c'} group, an -SR^{c'} group or an SiR^{d'}R^{e'}R^{f'} group; preferably hydrogen, deuterium or C₁-C₄-alkyl, which may be fully or partly deuterated, more preferably hydrogen, deuterium, methyl, CD₃, ethyl, C₂D₅, propyl, especially i-propyl, C₃D₇, especially (CD₃)₂CD or (CH₃)₂CD;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms, preferably a substituted or unsubstituted aromatic hydrocarbon group having 5 or 6 ring carbon atoms, a substituted or unsubstituted heterocyclic group having 5 or 6 ring atoms;
n is 0, 1 or 2, preferably 0 or 1,
R_{B} is hydrogen, deuterium, a substituted or unsubstituted alkyl group having 1 to 30 carbon atoms, a substituted or unsubstituted cycloalkyl group having 3 to 30 ring carbon atoms, a substituted or unsubstituted fluoroalkyl group having 1 to 30 carbon atoms, a substituted or unsubstituted aromatic hydrocarbon group having 6 to 30 ring carbon atoms, a substituted or unsubstituted heterocyclic group having 5 to 30 ring atoms, an -OR^{c'} group, an -SR^{c'} group or an SiR^{d'}R^{e'}R^{f'} group; preferably hydrogen, deuterium or C₁-C₄-alkyl, which may be fully or partly deuterated, more preferably hydrogen, deuterium, methyl, CD₃, ethyl, C₂D₅, propyl, especially i-propyl, C₃D₇, especially (CD₃)₂CD or (CH₃)₂CD, most preferably, R_{B} is hydrogen;
and one of R_{B} may be -SR^{a'}, -OR^{a'} or -NR^{a'}R^{b'},
one of R_{A} and one of R_{B} may be connected to each other and form a bridge, for example 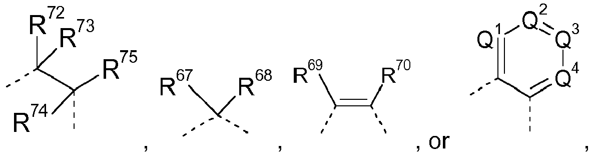 preferably 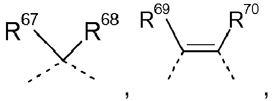 or 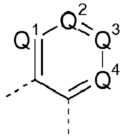 wherein
   R⁶⁷, R⁶⁸, R⁶⁹, R⁷⁰, R⁷², R⁷³, R⁷⁴ and R⁷⁵are each independently hydrogen, deuterium, C₁-C₄-alkyl, C₁-C₄-haloalkyl, substituted or unsubstituted phenyl, or substituted or unsubstituted heteroaryl having 5 or 6 ring atoms;
   Q¹, Q², Q³ and Q⁴ are each independently CR⁷¹ or N, wherein preferably 0 or 1 group Q¹, Q², Q³ or Q⁴ are N and the remaining groups Q¹, Q², Q³ and Q⁴ are CR⁷¹;
   R⁷¹ is hydrogen, deuterium, C₁-C₄-alkyl, C₁-C₄-fluoroalkyl, substituted or unsubstituted phenyl, or substituted or unsubstituted heteroaryl having 5 or 6 ring atoms;
   R^{a'}, R^{b'} are each independently a substituted or unsubstituted aromatic hydrocarbon group having 6 to 30 ring carbon atoms, a substituted or unsubstituted heterocyclic group having 5 to 30 ring atoms,
   m is 0, 1, 2 or 3, preferably 0, 1 or 2,
   in the case that m is ≥ 2, two adjacent residues R_{B} may form together a ring, preferably a five or six membered ring, which is unsubstituted or substituted and may be fused with one or more, preferably one, further unsubstituted or substituted carbocyclic or heterocyclic five or six membered ring,
   wherein the dotted lines are bonding sites.

Preferably, one of R_{B} is -SR^{a}, -OR^{a} or -NR^{a}R^{b} in the case that the metal complex is a Pt complex.

Suitable groups -SR^{a}, -OR^{a} and -NR^{a}R^{b} are in the case that the metal complex is a Pt complex the following groups: 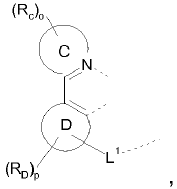 wherein
ring C is a heterocyclic group having 5 or 6 ring atoms, preferably a heteroaromatic group having 5 or 6 ring atoms,
ring D is an aromatic hydrocarbon group having 6 to 30 ring carbon atoms, preferably an aromatic hydrocarbon group having 6 to 10 ring carbon atoms or a heteroaromatic group having 5 or 6 ring atoms,
R_{C} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 carbon atoms, a substituted or unsubstituted heterocyclic group having 5 to 30 ring atoms, an -OR^{c'} group, an -SR^{c'} group or an SiR^{d'}R^{e'}R^{f'} group;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms, preferably a substituted or unsubstituted aromatic hydrocarbon group having 5 or 6 ring carbon atoms, a substituted or unsubstituted heterocyclic group having 5 or 6 ring atoms;
o is 0, 1 or 2, preferably 0 or 1,
in the case that o is = 2, two adjacent residues R_{C} may form together a ring, preferably a five or six membered ring, which is unsubstituted or substituted and may be fused with one or more, preferably one, further unsubstituted or substituted carbocyclic or heterocyclic five or six membered ring,
R_{D} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, a substituted or unsubstituted heterocyclic group having 5 to 30 ring atoms, an -OR^{c'} group, an -SR^{c'} group or an SiR^{d'}R^{e'}R^{f'} group;
one of R_{C} and one of R_{D} may be connected to each other and form a bridge, for example 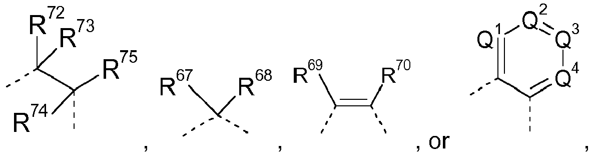 preferably 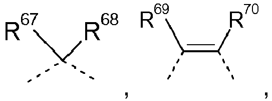 or 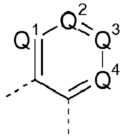 wherein
   R⁶⁷, R⁶⁸, R⁶⁹, R⁷⁰, R⁷², R⁷³, R⁷⁴ and R⁷⁵ are each independently hydrogen, deuterium, C₁-C₄-alkyl, C₁-C₄ fluoroalkyl, substituted or unsubstituted phenyl, or substituted or unsubstituted heteroaryl having 5 or 6 ring atoms;
   Q¹, Q², Q³ and Q⁴ are each independently CR⁷¹ or N, wherein preferably 0 or 1 group Q¹, Q², Q³ or Q⁴ are N and the remaining groups Q¹, Q², Q³ and Q⁴ are CR⁷¹;
   R⁷¹ is hydrogen, deuterium, C₁-C₄-alkyl, C₁-C₄fluoroalkyl, substituted or unsubstituted phenyl, or substituted or unsubstituted heteroaryl having 5 or 6 ring atoms;
   p is 0, 1 or 2, preferably 0 or 1,
   in the case that p is = 2, two adjacent residues R_{D} may form together a ring, preferably a five or six membered ring, which is unsubstituted or substituted and may be fused with one or more, preferably one, further unsubstituted or substituted carbocyclic or heterocyclic five or six membered ring,
   L₁ is -O-, -S- or -NR'"-, a substituted or unsubstituted alkylene group having 1 to 30 carbon atoms, a substituted or unsubstituted cycloalkylene group having 3 to 30 carbon atoms, wherein R"' is a substituted or unsubstituted aromatic hydrocarbon group having 6 to 30 ring carbon atoms, or a
   wherein the dotted lines are bonding sites.

Preferred groups 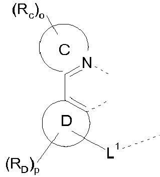 are mentioned below.

Preferred groups 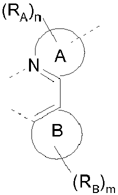 are the following groups: 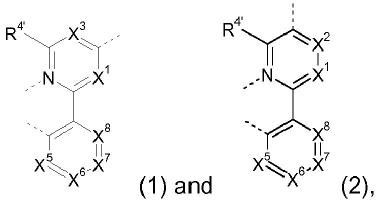 wherein
X¹ is CH or N, X² is CR^{2'} or N, X³ is CR^{3'} or N, X⁵ is CR^{5'} or N, X⁶ is CR^{6'} or N, X⁷ is CR^{7'} or N and X⁸ is CH or N, wherein 0, 1 or 2, preferably 0 or 1, more preferably 0 of X¹, X² and X³ are N,
wherein in the case that two of X¹, X² and X³ are N, X¹ and X³ are N, and 0, 1 or 2 of X⁵, X⁶, X⁷ and X⁸ are N, wherein in the case that two of X⁵, X⁶, X⁷ and X⁸ are N, X⁵ and X⁷, X⁶ and X⁸ or X⁵ and X⁸ are N, more preferably 0 of X⁵ to X⁸ are N;
X¹ and X⁸ may be connected to each other via a bridge, for example an alkane-diyl bridge, an alkene-diyl bridge, an arylene-bridge or a heteroarylene bridge,
wherein X⁵ and X⁶, X⁶ and X⁷ or X⁷ and X⁸ may together form a ring structure R^{2'} and R^{3'} are each independently defined as R_{A},
R^{4'} is H or C₁-C₄-alkyl, preferably H,
and
R^{5'}, R^{6'} and R^{7'} are each independently defined as R^{B}, preferably, R^{5'} is H,
wherein one of R^{2'} and R^{3'} is a bonding site,
wherein the dotted lines are bonding sites.

Preferred metal complexes of formula (I) comprise therefore at least one ligand of formulae (IA-1), (IA-2), (IB-1), (IB-2), (IC-1) or (IC-2) 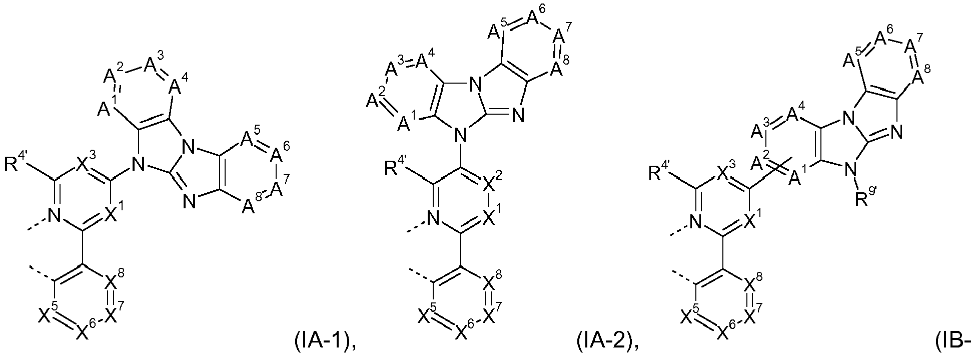 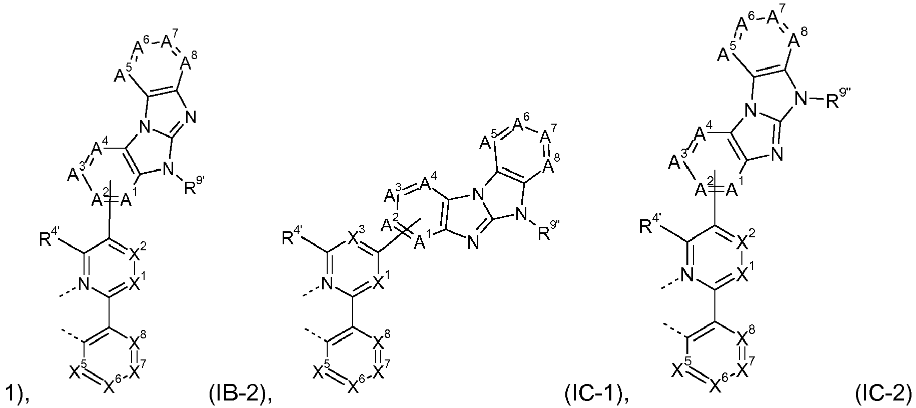 wherein the residues, symbols and indices have been defined above.

More preferred metal complexes of formula (I) comprise at least one ligand of formulae (IA-1) or (IA-2).

More preferred groups 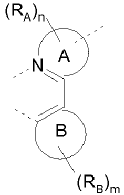 are the following groups: 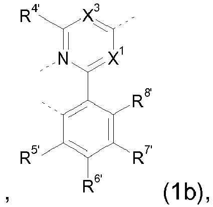 preferably 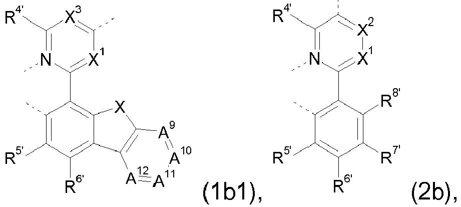 preferably 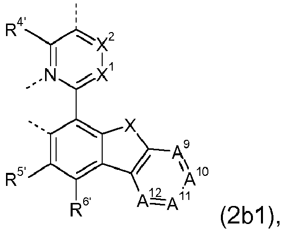 wherein A⁹ is CR⁹ or N, A¹⁰ is CR¹⁰ or N, A¹¹ is CR¹¹ or N, A¹² is CR¹² or N, wherein 0, 1 or 2, preferably 0 or 1, more preferably, 1 of A⁹, A¹⁰, A¹¹, A¹² are N, most preferably, A⁹ is N, wherein R^{6'} and R^{7'} or R^{7'} and R^{8'} in formulae (1b) and (2b) together form a ring of the following formula: 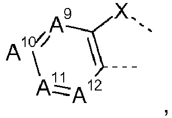 or R^{5'} and R^{6'} or R^{6'} and R^{7'} or R^{7'} and R^{8'} in formulae (1b and (2b) together form a ring of the following formula: 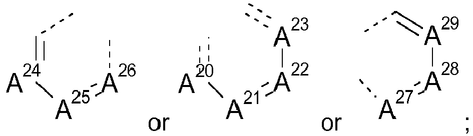 A²⁰ is CR²⁰ or N, A²¹ is CR²¹ or N, A²² is CR²² or N, A²³ is CR²³ or N, A²⁴ is CR²⁴ or N, A²⁵ is CR²⁵ or N, A²⁶ is CR²⁶ or N, A²⁷ is CR²⁷ or N, A²⁸ is CR²⁸ or N and A²⁹ is CR²⁹ or N, wherein 0 or 1, preferably 0 of A^{20'}, A²¹, A²² and A²³, respectively of A²⁴, A²⁵ and A²⁶, respectively of A²⁷, A²⁸ and A²⁹ are N,
R⁹, R¹⁰, R¹¹, R¹², R²⁰, R^{20'}, R²¹, R²², R²³, R²⁴, R²⁵, R²⁶, R²⁷, R²⁸ and R²⁹ are each independently hydrogen, deuterium, a substituted or unsubstituted alkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted five or six membered heteroaromatic ring, preferably hydrogen, deuterium, a substituted or unsubstituted alkyl group having 1 to 30 carbon atoms, a substituted or unsubstituted cycloalkyl group having 3 to 30 ring carbon atoms, and
X is O or S,
wherein the dotted lines are bonding sites.

More preferred metal complexes of formula (I) comprise therefore at least one ligand of formulae (IA-1a), (IA-1b), preferably (IA-1b1), (IB-1a), (IB-1b), preferably (1B-1b1), (IC-1a), (IC-1b), preferably (IC-1b1), (IA-2a), (IA-2b), preferably (IA-2b1), (IB-2a), (IB-2b), preferably (1B-2b1), or (IC-2a), (IC-2b), preferably (IC-2b1) 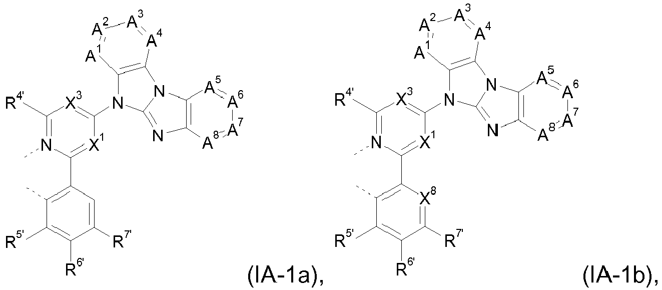 preferably 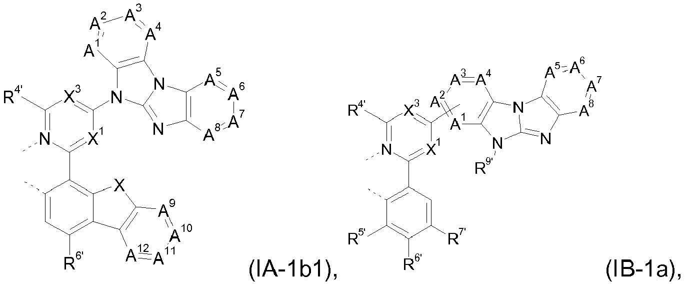 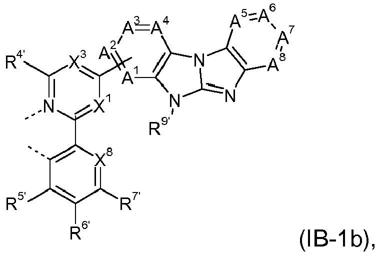 preferably 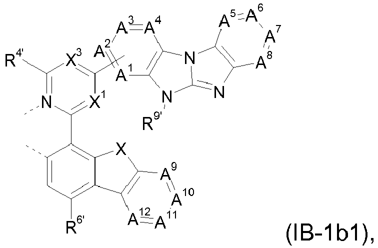 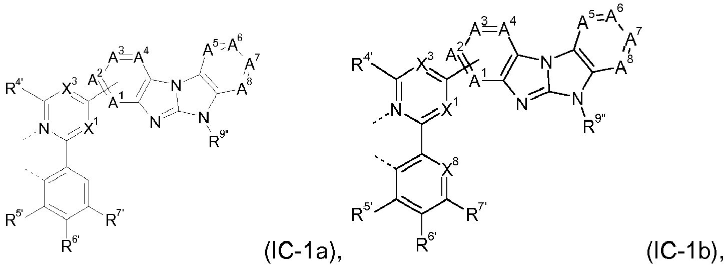 preferably 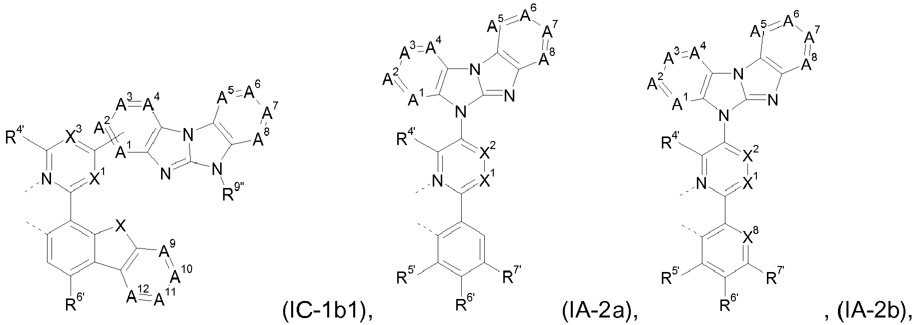 preferably 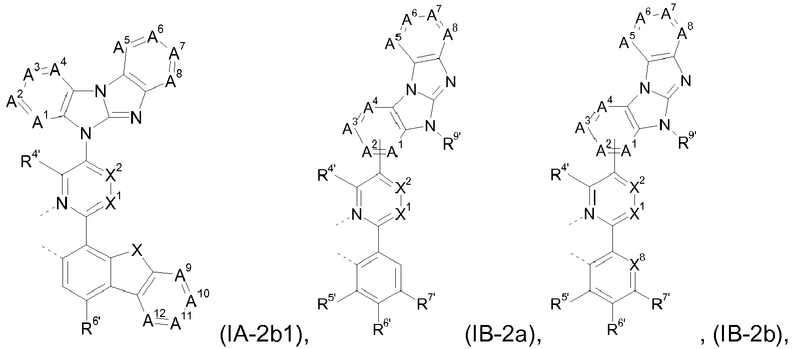 preferably 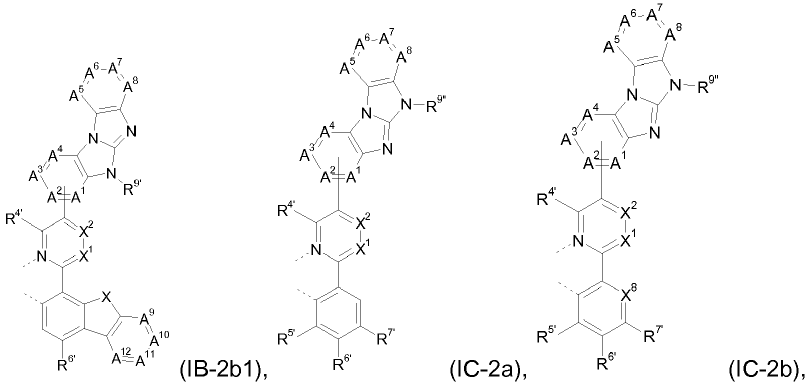 preferably 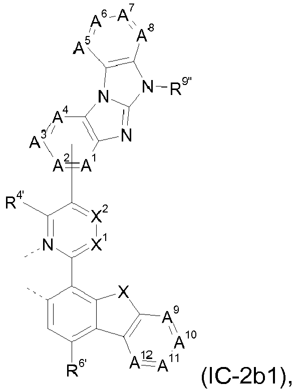 wherein X⁸ is CR^{8'}, wherein R^{8'} is H or forms a ring as defined above together with R^{7'};
R^{5'} is H or forms a ring as defined below together with R^{6'}; and the further residues, symbols and indices have been defined above.

Most preferred metal complexes of formula (I) comprise at least one ligand of formulae (IA-1a), (IA-1b), (IB-1a), (IB-1b), (IC-1a), (IC-1b), (IA-2a), (IA-2b), (IB-2a), (IB-2b), (IC-2a), (IC-2b).

Preferred ligands of formula (IA-1b) are the ligands (IA-1b1), (IA-1b3) and (IA-1b4).

Preferred ligands of formula (IB-1b) are the ligands (IB-1b1), (1B-1b3) and (1B-1b4).

Preferred ligands of formula (IC-1b) are the ligands (IC-1b1), (IC-1b3) and (IC-1b4).

Preferred ligands of formula (IA-2b) are the ligands (IA-2b1), (IA-2b3) and (IA-2b4).

Preferred ligands of formula (IB-2b) are the ligands (IB-2b1), (1B-2b3) and (1B-2b4).

Preferred ligands of formula (IC-2b) are the ligands (IC-2b1) (IC-2b3) and (IC-2b4).

Further most preferred metal complexes of formula (I) comprise at least one ligand of formulae (IA-1a), (IA-1b), (IA-2a) or (IA-2b), more preferably at least one ligand of formulae (IA-1b1) or (IA-2b1).

In one embodiment, in the case that the metal in the metal complex according to the present invention is Pt, the group 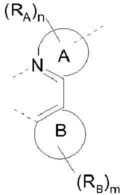 has one of the following formulae: 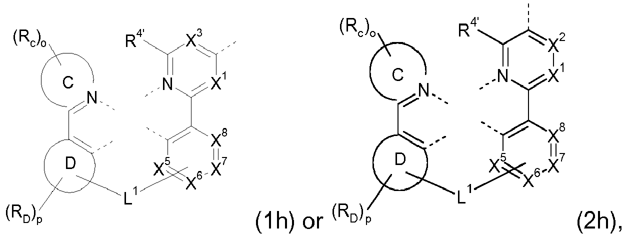 wherein
ring C is a heterocyclic group having 5 or 6 ring atoms, preferably a heteroaromatic group having 5 or 6 ring atoms, more preferably a heteroaromatic group having 6 ring atoms, most preferably pyridyl,
ring D is an aromatic hydrocarbon group having 6 to 30 ring carbon atoms, preferably an aromatic hydrocarbon group having 6 to 10 ring carbon atoms or a heteroaromatic group having 5 or 6 ring atoms, more preferably an aromatic hydrocarbon group having 6 to 10 ring carbon atoms, most preferably phenyl,
R_{C} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 carbon atoms, a substituted or unsubstituted heterocyclic group having 5 to 30 ring atoms, an -OR^{c'} group, an -SR^{c'} group or an SiR^{d'}R^{e'}R^{f'} group; preferably hydrogen, deuterium, methyl, CD₃, ethyl, C₂D₅, propyl, especially i-propyl, C₃D₇, especially (CD₃)₂CD or (CH₃)₂CD;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
o is 0, 1 or 2, preferably 0 or 1,
in the case that o is = 2, two adjacent residues R_{C} may form together a ring, preferably a five or six membered ring, which is unsubstituted or substituted and may be fused with one or more, preferably one, further unsubstituted or substituted carbocyclic or heterocyclic five or six membered ring,
R_{D} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, a substituted or unsubstituted heterocyclic group having 5 to 30 ring atoms, an -OR^{c'} group, an -SR^{c'} group or an SiR^{d'}R^{e'}R^{f'} group; preferably hydrogen, deuterium, methyl, CD₃, ethyl, C₂D₅, propyl, especially i-propyl, C₃D₇, especially (CD₃)₂CD or (CH₃)₂CD;
one of R_{C} and one of R_{D} may be connected to each other and form a bridge, for example 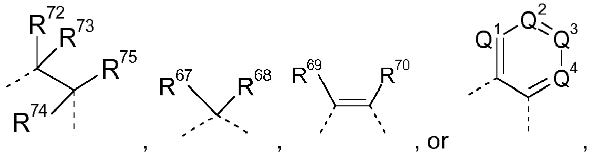 preferably 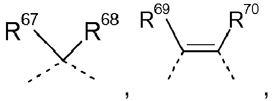 or 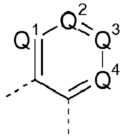 wherein
   R⁶⁷, R⁶⁸, R⁶⁹, R⁷⁰, R⁷², R⁷³, R⁷⁴ and R⁷⁵ are each independently hydrogen, deuterium, C₁-C₄-alkyl, C₁-C₄ fluoroalkyl, substituted or unsubstituted phenyl, or substituted or unsubstituted heteroaryl having 5 or 6 ring atoms;
   Q¹, Q², Q³ and Q⁴ are each independently CR⁷¹ or N, wherein preferably 0 or 1 group Q¹, Q², Q³ or Q⁴ are N and the remaining groups Q¹, Q², Q³ and Q⁴ are CR⁷¹;
   R⁷¹ is hydrogen, deuterium, C₁-C₄-alkyl, C₁-C₄ fluoroalkyl, substituted or unsubstituted phenyl, or substituted or unsubstituted heteroaryl having 5 or 6 ring atoms;
   p is 0, 1 or 2, preferably 0 or 1,
   in the case that p is = 2, two adjacent residues R_{D} may form together a ring, preferably a five or six membered ring, which is unsubstituted or substituted and may be fused with one or more, preferably one, further unsubstituted or substituted carbocyclic or heterocyclic five or six membered ring,
   L₁ is -O-, -S- or -NR'"-, a substituted or unsubstituted alkylene group having 1 to 30 carbon atoms, a substituted or unsubstituted cycloalkylene group having 3 to 30 carbon atoms, wherein R"' is a substituted or unsubstituted aromatic hydrocarbon group having 6 to 30 ring carbon atoms, or a
   wherein the dotted lines are bonding sites.

Preferred groups 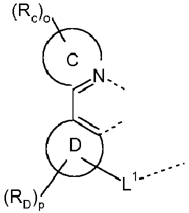 have the following meaning: 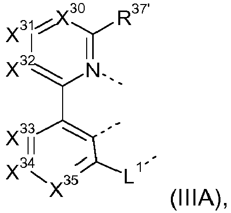 wherein
X³⁰ is CR^{30'} or N, X³¹ is CR^{31'} or N, X³² is CH or N, wherein 0 or 1, preferably 0, of X³⁰, X³¹ and X³² are N, X³³ is CH or N, X³⁴ is CR^{34'} or N, X³⁵ is CR^{35'} or N, wherein 0 or 1, preferably 0, of X³³, X³⁴ and X³⁵ are N,
R^{30'}, R^{31'}, R^{32'}, R^{33'}, R^{34'} and R^{35'} are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted five or six membered heteroaromatic ring, an -OR^{c'} group, an -SR^{c'} group or an SiR^{d'}R^{e'}R^{f'} group; provided that X³¹ and X³² and/or X³³ and X³⁴ may be connected to each other via a bridge to form a ring structure, preferably hydrogen, deuterium, methyl, CD₃, ethyl, C₂D₅, propyl, especially i-propyl, C₃D₇, especially (CD₃)₂CD or (CH₃)₂CD, provided that X³¹ and X³² and/or X³³ and X³⁴ may be connected to each other via a bridge to form a ring structure; or
R^{30'} and R^{31'} or R^{34'} and R^{35'} may together form a ring structure,
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
R^{37'} is hydrogen, deuterium or a substituted or unsubstituted alkyl group having 1 to 4 carbon atoms, preferably hydrogen, deuterium, methyl, CD₃, ethyl, C₂D₅, propyl, especially i-propyl, C₃D₇, especially (CD₃)₂CD or (CH₃)₂CD, more preferably hydrogen,
X³² and X³³ may be connected to each other via a bridge, for example an alkane-diyl bridge, an alkene-diyl bridge, an arylene-bridge or a heteroarylene bridge,
R^{37'} and R^{30'} may be connected to each other and form together with the carbon atoms to which R^{37'} and R^{30'} are connected a 6 membered aromatic ring which may be substituted or unsubstituted,
wherein the dotted lines are bonding sites.

Preferably, the group of formula (IIIA) is selected from the group (IIIA-1a) and (IIIA-1b) 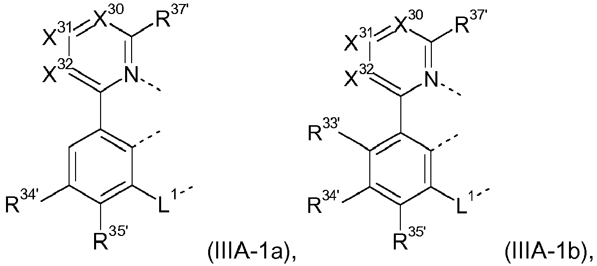 preferably 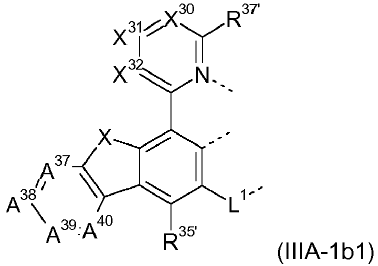 wherein
A³⁷ is CR³⁷ or N, A³⁸ is CR³⁸ or N, A³⁹ is CR³⁹ or N and A⁴⁰ is CR⁴⁰ or N, wherein 0 or 1, preferably 1, of A³⁷, A³⁸, A³⁹ and A⁴⁰ is N,
wherein R^{33'} and R^{34'} or R^{34'} and R^{35'} in formulae (IIIA-1b) together form a ring of the following formula: 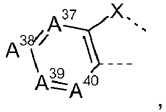
R³⁷, R³⁸, R³⁹ and R⁴⁰ are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms or a substituted or unsubstituted five or six membered heteroaromatic ring, an-OR^{c'} group, an -SR^{c'} group or an SiR^{d'}R^{e'}R^{f'} group; provided that two adjacent substituents selected from R³⁷, R³⁸, R³⁹ and R⁴⁰ may be bonded to each other to form a ring structure, preferably hydrogen, deuterium, methyl, CD₃, ethyl, C₂D₅, propyl, especially i-propyl, C₃D₇, especially (CD₃)₂CD or (CH₃)₂CD, provided that two adjacent substituents selected from R³⁷, R³⁸, R³⁹ and R⁴⁰ may be bonded to each other to form a ring structure,
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
wherein the dotted lines are bonding sites.

In a preferred embodiment, X¹ and X⁸ in the metal complexes of formula (I) comprising at least one ligand of formulae (IA-1), (IA-2), (IB-1), (IB-2), (IC-1) or (IC-2), are each independently N or CH, preferably X¹ is N or CH and X⁸ is CH, most preferably X¹ and X⁸ are CH.

In a further preferred embodiment, in formulae (IA-1), (IB-1) and (IC-1), X³ is CH or C-methyl, R^{4'} is hydrogen and X¹, X⁵, X⁶, X⁷ and X⁸ are CH.

In a further preferred embodiment, in formulae (IA-2), (IB-2) and (IC-2), X² is CH or C-methyl, R^{4'} is hydrogen and X¹, X⁵, X⁶, X⁷ and X⁸ are CH.

**The groups** 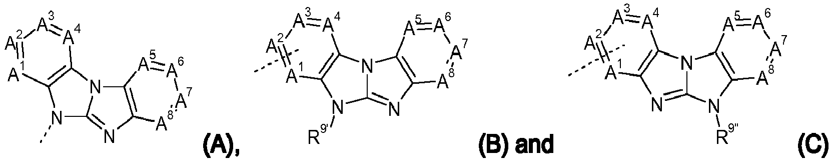 In the groups 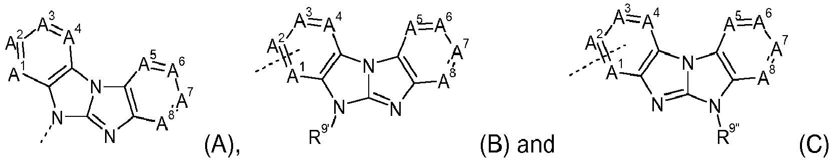
A¹ is CR¹ or N, A² is CR² or N, A³ is CR³ or N, A⁴ is CR⁵ or N, A⁵ is CR⁵ or N, A⁶ is CR⁶ or N, A⁷ is CR⁷ or N and A⁸ is CR⁸ or N, whereby preferably 0, 1 or 2, more preferably 0 or 1, most preferably 0 of A¹ to A⁸ are N,
wherein - in formula (B) and (C) one of A¹, A², A³ and A⁴ is CR¹, CR², CR³ respectively CR⁴, wherein R¹, R², R³ respectively R⁴ is a bonding site to the ring A,
R¹, R², R³, R⁴, R⁵, R⁶, R⁷ and R⁸ are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted heterocyclic group, having 5 to 30 ring atoms, an -OR^{c'} group, an -SR^{c'} group or an SiR^{d'}R^{e'}R^{f'} group; provided that, two substituents selected from R¹, R², R³, R⁴ respectively from R⁵, R⁶, R⁷ and R⁸ may be bonded to each other to form a ring structure, preferably, R¹, R², R³, R⁴, R⁵, R⁶, R⁷ and R⁸ are each independently hydrogen, deuterium or a substituted or unsubstituted alkyl group having 1 to 30 carbon atoms, more preferably, R¹, R², R³, R⁴, R⁵, R⁶, R⁷ and R⁸ are each independently hydrogen, deuterium or a C₁-C₄-alkyl group, most preferably hydrogen, deuterium, methyl, CD₃, ethyl, C₂D₅, propyl, especially i-propyl, C₃D₇, especially (CD₃)₂CD or (CH₃)₂CD;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
R^{9'}, R^{9"} are each independently a substituted or unsubstituted aromatic hydrocarbon group having 6 to 30 ring carbon atoms, or a substituted or unsubstituted heterocyclic group having 5 to 30 ring atoms, preferably, R^{9'}, R^{9"} are phenyl; and
wherein the dotted lines are bonding sites.

The preferred group in the metal complexes according to the present invention is group (A).

Preferably, in the groups (A), (B) and (C) in the ligands of formulae (IA), (IB) and (IC), A¹ is CR¹, A² is CR², A³ is CR³, A⁴ is CR⁴, A⁵ is CR⁵, A⁶ is CR⁶, A⁷ is CR⁷ and A⁸ is CR⁸.

More preferably, one or two of A¹, A², A³, A⁴, A⁵, A⁶, A⁷ and A⁸ are CR^{X}, wherein R^{X} is R¹, R², R³, R⁴, R⁵, R⁶, R⁷ respectively R⁸, and the remaining groups A¹, A², A³, A⁴, A⁵, A⁶, A⁷ and A⁸ are CH, preferably one of A¹, A², A³, A⁴, A⁵, A⁶, A⁷ and A⁸ is CR^{X}, and the remaining groups A¹, A², A³, A⁴, A⁵, A⁶, A⁷ and A⁸ are CH, more preferably A¹, A², A³, A⁴, A⁵, A⁶, A⁷ and A⁸ are CH.

Most preferably, the ligand of formula (IA) comprises only one additional substituent, i.e., most preferably, one of A¹, A², A³, A⁴, A⁵, A⁶, A⁷ and A⁸ is CR^{X}, and the remaining A¹, A², A³, A⁴, A⁵, A⁶, A⁷ and A⁸ are CH and n and m are 0, or A¹, A², A³, A⁴, A⁵, A⁶, A⁷ and A⁸ are CH and one of n and m is 1 and the other one is 0. The residues R_{A} and R_{B} and CR^{X} are defined above.

In a further most preferred embodiment, in the ligands of formulae (IB) and (IC) R⁹ respectively R^{9'} is phenyl, and the ligands of formulae (IB) and (IC) comprise only one additional substituent, i.e., most preferably, one of A¹, A², A³, A⁴, A⁵, A⁶, A⁷ and A⁸ is CR^{X}, and the remaining A¹, A², A³, A⁴, A⁵, A⁶, A⁷ and A⁸ are CH and n and m are 0, or A¹, A², A³, A⁴, A⁵, A⁶, A⁷ and A⁸ are CH and one of n and m is 1 and the other one is 0. The residues R_{A} and R_{B} and CR^{X} are defined above.

### The metal complexes of formulae (IIA), (IIB) and (IIC):

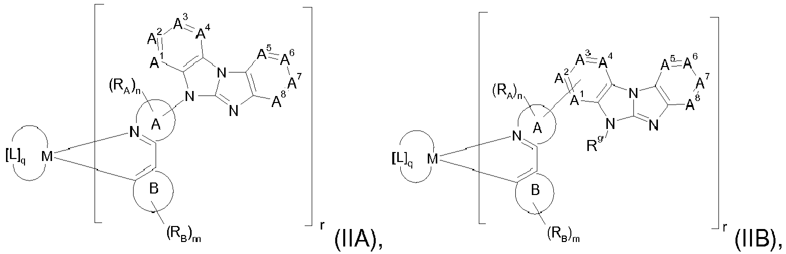

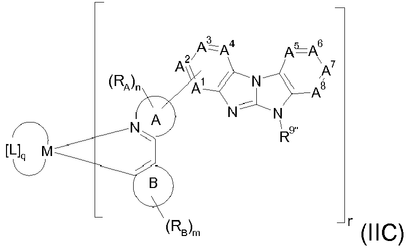

Preferred metal complexes comprising at least one ligand of formulae (IA), (IB) or (IC) are the metal complexes of formulae (IIA), (IIB) and (IIC), preferably of formula (IIA),
wherein
M is Pt or Ir, preferably Ir;
if M is Ir, r is 1, 2 or 3, preferably 1, q is 0,1 or 2 and the sum of r + q = 3;
in the case that q = 2, the ligands L may be the same of different, preferably the same; and in the case that r is 2 or 3, the r ligands may be the same or different, preferably the same;
if M is Pt, r is 1 or 2, q is 0 or 1; and the sum of r + q = 2;
in the case that r is 2, the r-ligands may be the same or different, preferably the same; and L is a monoanionic bidentate ligand.

The ligands of formulae (IA), (IB) or (IC) 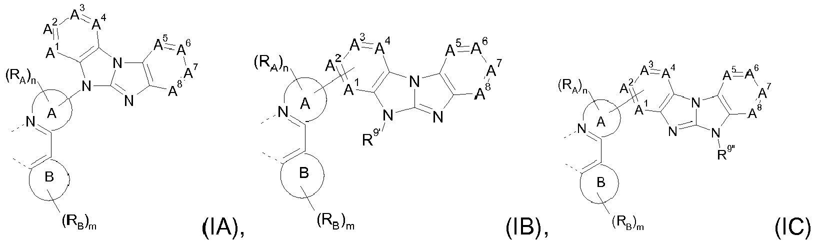 in the metal complexes of formulae (IIA), (IIB) and (IIC) are described above.

More preferred metal complexes of formulae (IIA), (IIB) and (IIC) are the following complexes: 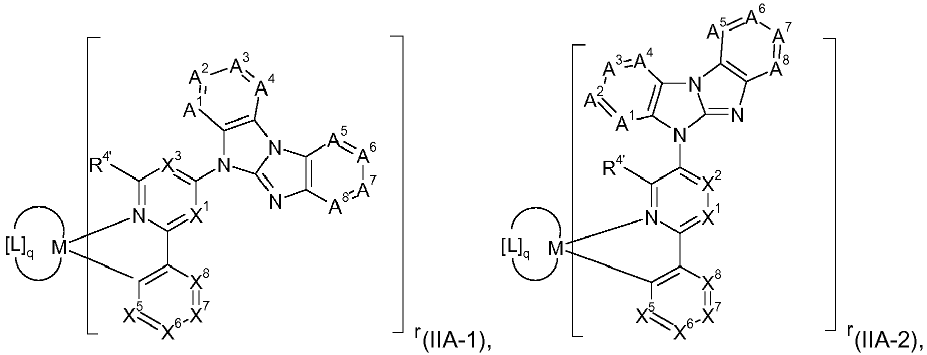 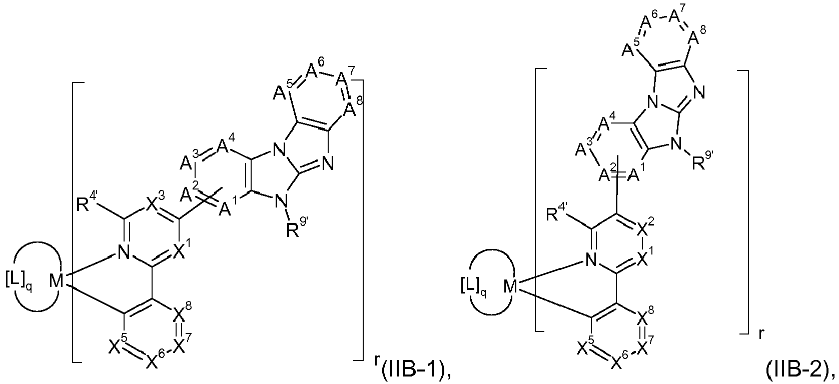 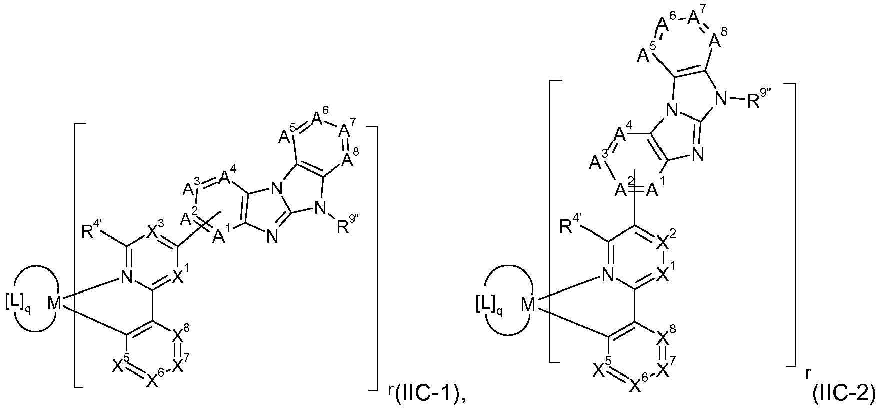 wherein
X¹ is CH or N, X² is CR^{2'} or N, X³ is CR^{3'} or N, X⁵ is CR^{5'} or N, X⁶ is CR^{6'} or N, X⁷ is CR^{7'} or N and X⁸ is CH or N, wherein 0, 1 or 2, preferably 0 or 1, more preferably 0 of X¹, X² and X³ are N, wherein in the case that two of X¹, X² and X³ are N, X¹ and X³ are N, and 0, 1 or 2 of X⁵, X⁶, X⁷ and X⁸ are N, wherein in the case that two of X⁵, X⁶, X⁷ and X⁸ are N, X⁵ and X⁷, X⁶ and X⁸ or X⁵ and X⁸ are N, more preferably 0 of X⁵ to X⁸ are N;
X¹ and X⁸ may be connected to each other via a bridge, for example an alkane-diyl bridge, an alkene-diyl bridge, an arylene-bridge or a heteroarylene bridge,
wherein X⁵ and X⁶, X⁶ and X⁷ or X⁷ and X⁸ may together form a ring structure R^{2'} and R^{3'} are each independently defined as R_{A},
R^{4'} is H or C₁-C₄-alkyl, preferably H,
and
R^{5'}, R^{6'} and R^{7'} are each independently defined as R^{B}, preferably, R^{5'} is H,
wherein one of R^{2'} and R^{3'} is a bonding site,
M is Pt or Ir, preferably Ir;
if M is Ir, r is 1, 2 or 3, preferably 1, q is 0,1 or 2 and the sum of r + q = 3;
in the case that q = 2, the ligands L may be the same of different, preferably the same; and in the case that r is 2 or 3, the r ligands may be the same or different, preferably the same;
if M is Pt, r is 1 or 2, q is 0 or 1; and the sum of r + q = 2;
in the case that r is 2, the r-ligands may be the same or different, preferably the same; and L is a monoanionic bidentate ligand.

Most preferred metal complexes of formulae (IIA), (IIB) and (IIC) are the following complexes: 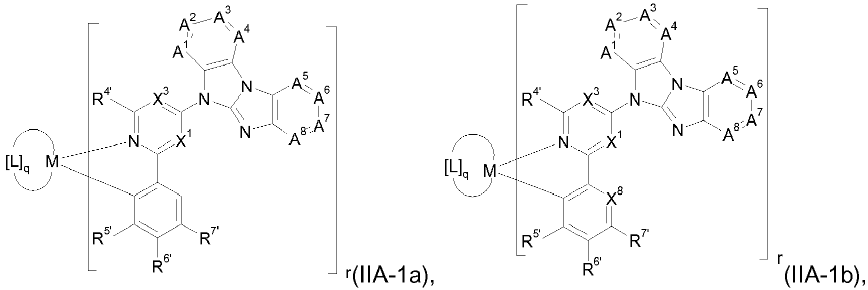 preferably 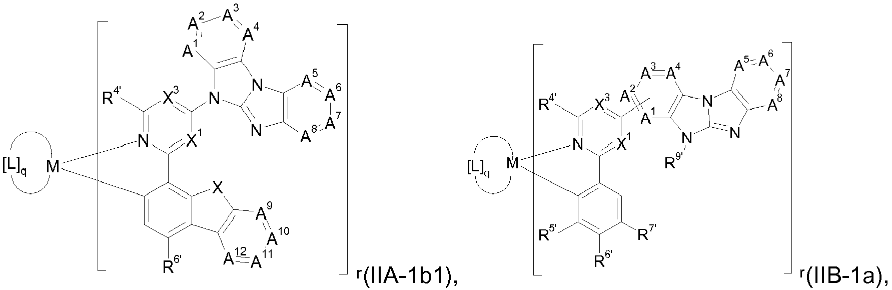 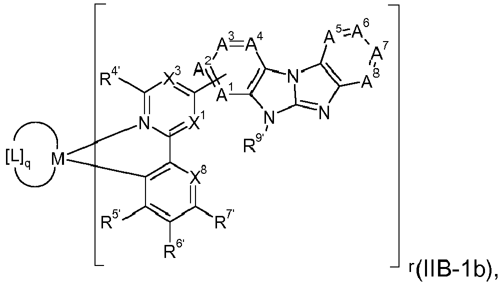 preferably 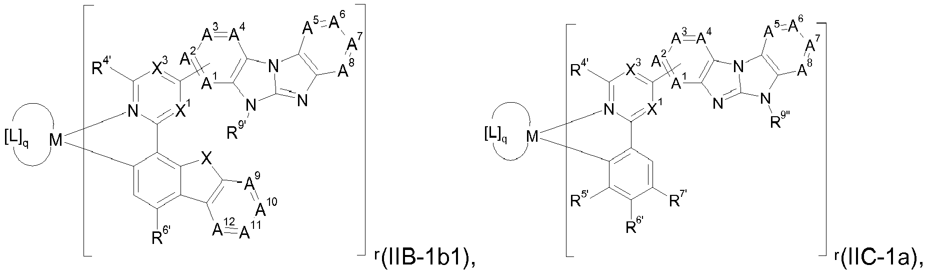 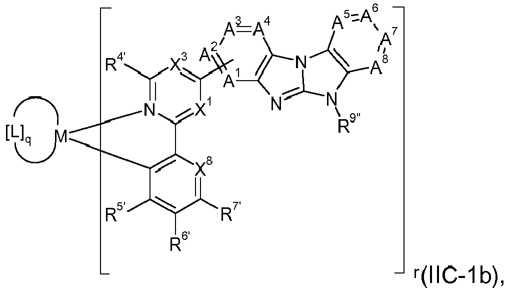 preferably 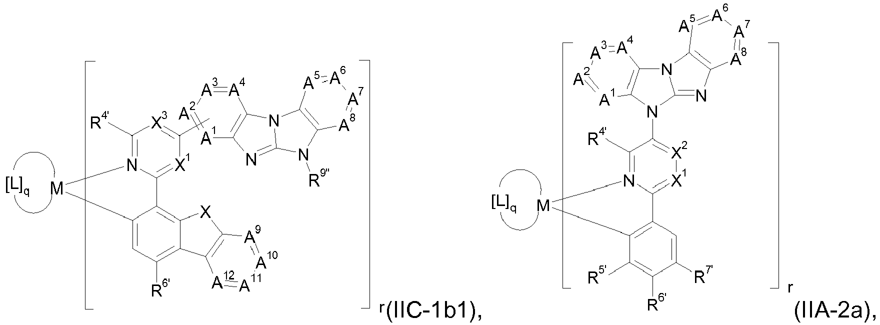 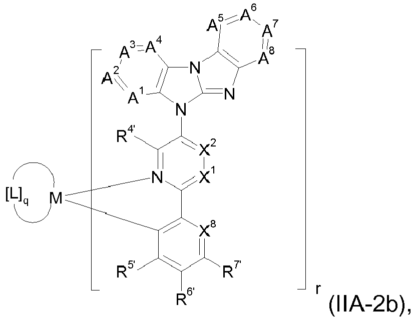 preferably 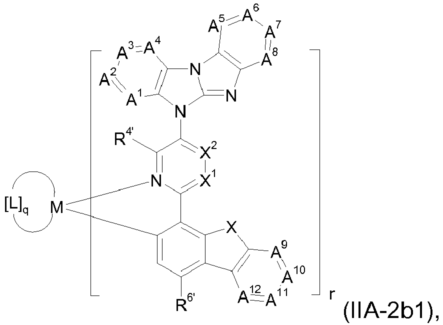 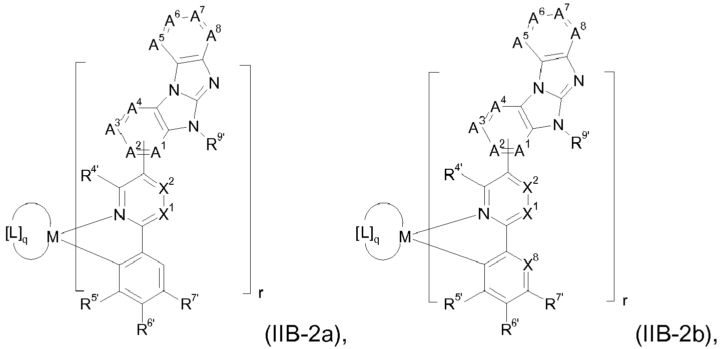 preferably 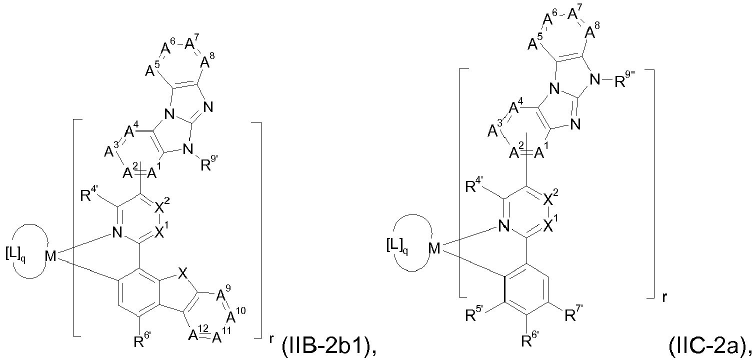 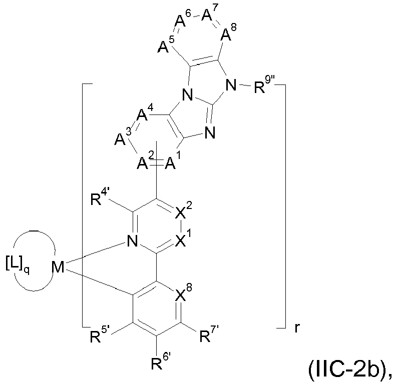 preferably 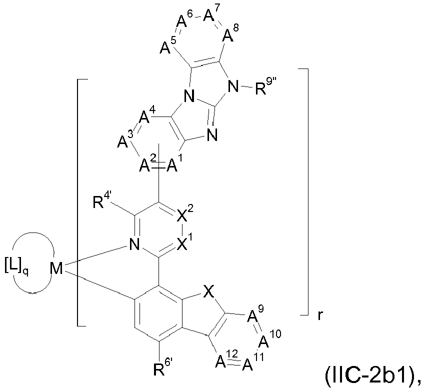
wherein A⁹ is CR⁹ or N, A¹⁰ is CR¹⁰ or N, A¹¹ is CR¹¹ or N, A¹² is CR¹² or N, wherein 0, 1 or 2, preferably 0 or 1, more preferably, 1 of A⁹, A¹⁰, A¹¹, A¹² are N, most preferably, A⁹ is N, wherein R^{6'} and R^{7'} or R^{7'} and R^{8'} in formulae (IIA-1b), (IIB-1b), (IIC-1b), (IIA-2b), (IIB-2b) and (IIC-2b) together form a ring of the following formula: 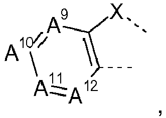 or R^{5'} and R^{6'} or R^{6'} and R^{7'} or R^{7'} and R^{8'} in formulae (IIA-1b), (IIB-1b), (IIC-1b), (IIA-2b), (IIB-2b) and (IIC-2b) together form a ring of the following formula: 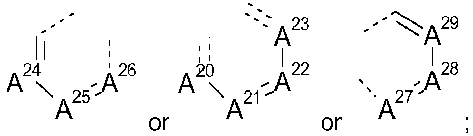
A²⁰ is CR²⁰ or N, A²¹ is CR²¹ or N, A²² is CR²² or N, A²³ is CR²³ or N, A²⁴ is CR²⁴ or N, A²⁵ is CR²⁵ or N, A²⁶ is CR²⁶ or N, A²⁷ is CR²⁷ or N, A²⁸ is CR²⁸ or N and A²⁹ is CR²⁹ or N,
wherein 0 or 1, preferably 0 of A^{20'}, A²¹, A²² and A²³, respectively of A²⁴, A²⁵ and A²⁶, respectively of A²⁷, A²⁸ and A²⁹ are N,
R⁹, R¹⁰, R¹¹, R¹², R²⁰, R²¹, R²², R²³, R²⁴, R²⁵, R²⁶, R²⁷, R²⁸ and R²⁹ are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted five or six membered heteroaromatic ring, an -OR^{c'} group, an -SR^{c'} group or an SiR^{d'}R^{e'}R^{f'} group; preferably hydrogen, deuterium, a substituted or unsubstituted alkyl group having 1 to 30 carbon atoms, a substituted or unsubstituted cycloalkyl group having 3 to 30 ring carbon atoms, more preferably hydrogen, deuterium or a C₁-C₄-alkyl group, most preferably hydrogen, deuterium, methyl, CD₃, ethyl, C₂D₅, propyl, especially i-propyl, C₃D₇, especially (CD₃)₂CD or (CH₃)₂CD, most preferably hydrogen,
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
X⁸ is CR^{8'}, wherein R^{8'} is H or forms a ring as defined below together with R^{7'}; preferably R^{8'} is H.
R^{5'} is H or forms a ring as defined below together with R^{6'};
X is O or S,
M is Pt or Ir, preferably Ir;
if M is Ir, r is 1, 2 or 3, preferably 1, q is 0,1 or 2, preferably 2, and the sum of r + q = 3;
in the case that q = 2, the ligands L may be the same of different, preferably the same; and in the case that r is 2 or 3, the r ligands may be the same or different, preferably the same;
if M is Pt, r is 1 or 2, q is 0 or 1; and the sum of r + q = 2;
in the case that r is 2, the r-ligands may be the same or different, preferably the same; and L is a monoanionic bidentate ligand;
wherein the dotted lines are bonding sites.

Even further preferred metal complexes of formulae (IIA), (IIB) and (IIC) are the metal complexes IIA-1a, IIA-1b, IIB-1a, IIB-1b, IIC-1a, IIC-1b, IIA-2a, IIA-2b, IIB-2a, IIB-2b, IIC-2a and IIC-2b. Preferred metal complexes IIA-1b are the metal complexes IIA-1b1, preferred metal complexes IIB-1b are the metal complexes IIB-1b1, preferred metal complexes IIC-1b are the metal complexes IIC-1b1, preferred metal complexes IIA-2b are the metal complexes IIA-2b1, preferred metal complexes IIB-2b are the metal complexes IIB-2b1 and preferred metal complexes IIC-2b are the metal complexes IIC-2b1. Further most preferred are the metal complexes of formulae IIA-1a, IIA-1b, IIA-2a and IIA-2b, whereby preferred metal complexes IIA-1b are the metal complexes IIA-1b1 and preferred metal complexes IIA-2b are the metal complexes IIA-2b1.

Most preferred are the following complexes: 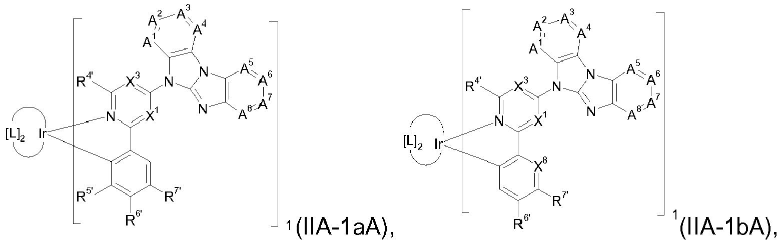 preferably 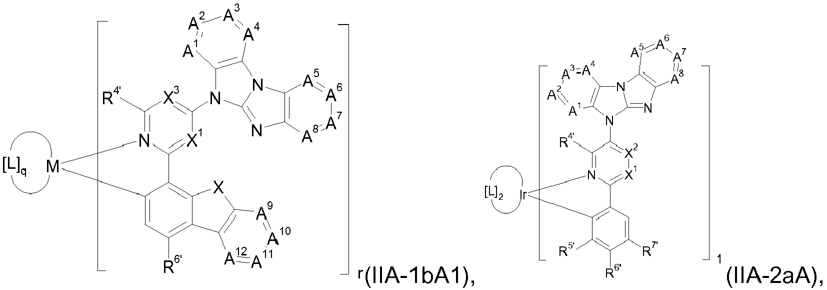 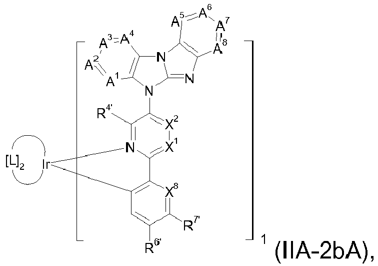 preferably 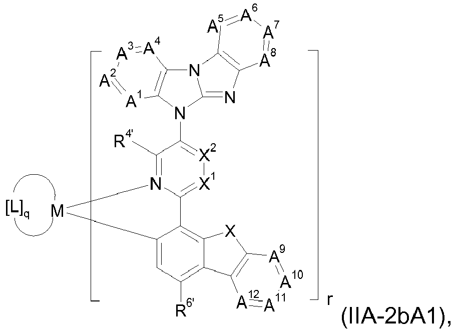 wherein the residues, symbols and indices are defined above.

Especially preferred are the complexes IIA-2bA and IIA-2bA1.

In the case that M in the metal complexes according to the present invention is Pt, suitable Pt complexes having one of the formulae (IIA-1h), (IIA-2h), (IIB-1h), (IIB-2h), (IIC-1h) or (IIC-2h), preferably IIA-1h, IIA-2h: 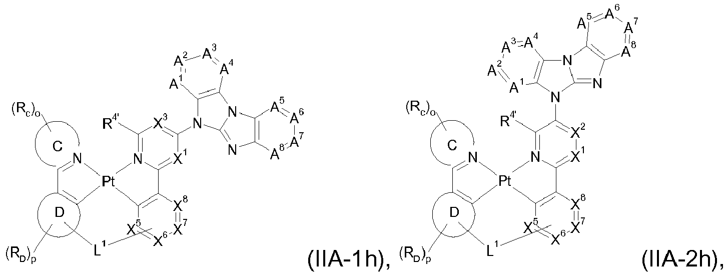 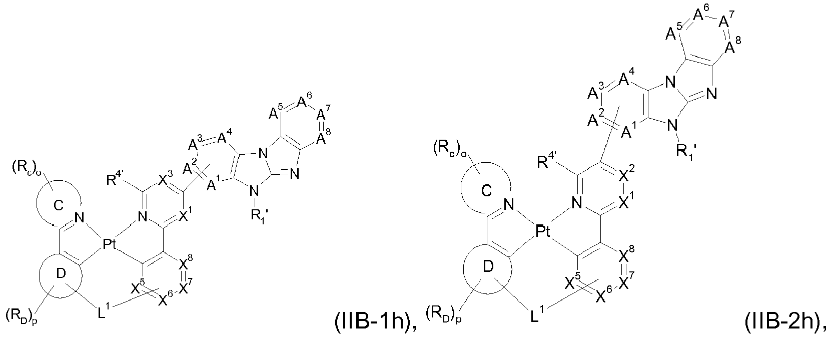 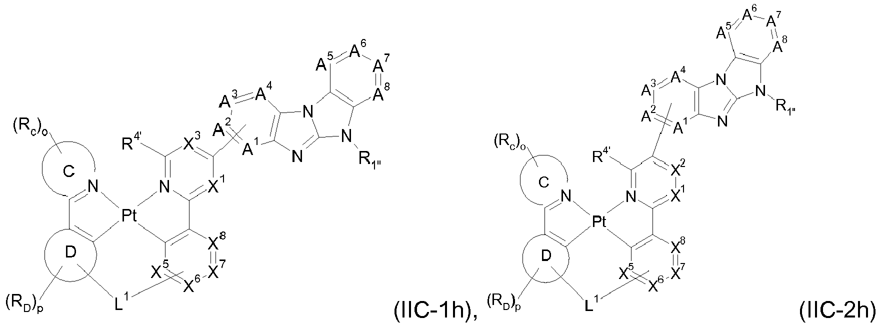 wherein the residues, symbols and indices in formulae (IIA-1h), (IIA-2h), (IIB-1h), (IIB-2h), (IIC-1h) and (IIC-2h) are defined above.

Preferred metal complexes of formulae (IIA-1h), (IIA-2h), (IIB-1h), (IIB-2h), (IIC-1h) and (IIC-2h) having one of the following formulae (IIA-1h-a), (IIA-2h-a), (IIB-1h-a), (IIB-2h-a), (IIC-1h-a) or (IIC-2h-a), preferably formula (IIA-1h-a) or formula (IIA-2h-a): 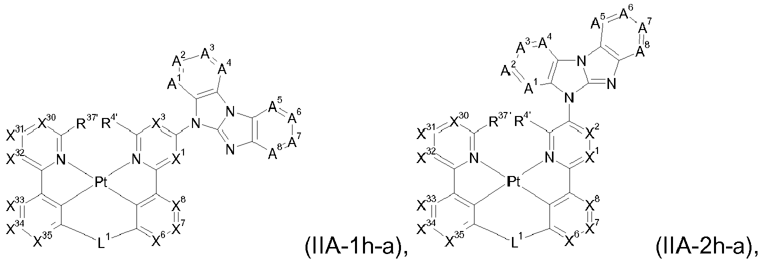 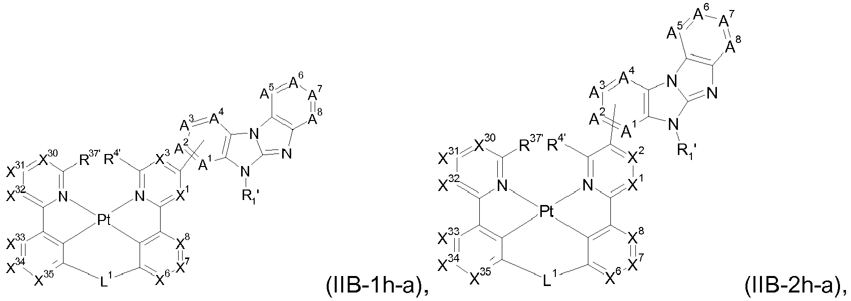 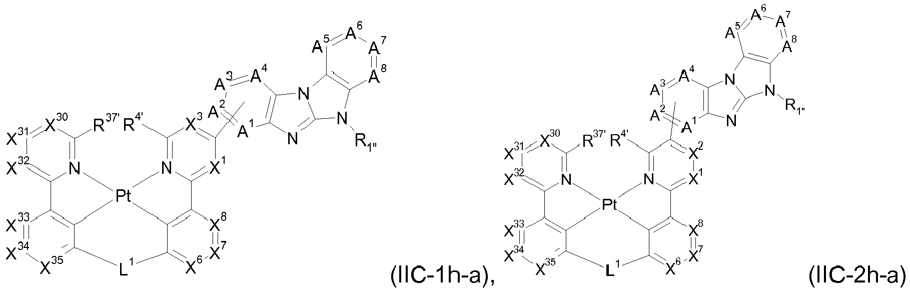 wherein the residues, symbols and indices in formulae (IIA-1h-a), (IIA-2h-a), (IIB-1h-a), (IIB-2ha), (IIC-1h-a) or (IIC-2h-a) are defined above.

In the metal complexes of formulae (IIA), (IIB) and (IIC) r is most preferably 1. In the case that M is Ir, q is then 2, whereby the ligands L can be the same or different. Preferably, the ligands L are the same. In the case that M is Pt, q is then 1.

L in the metal complexes of formulae (IIA), (IIB) and (IIC) is a monoanionic bidentate ligand. Preferred ligands L are mentioned in the following: 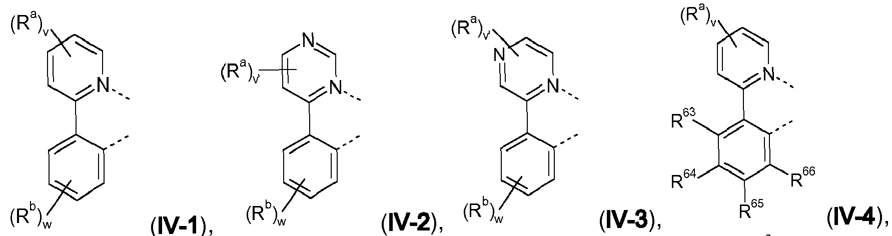 preferably 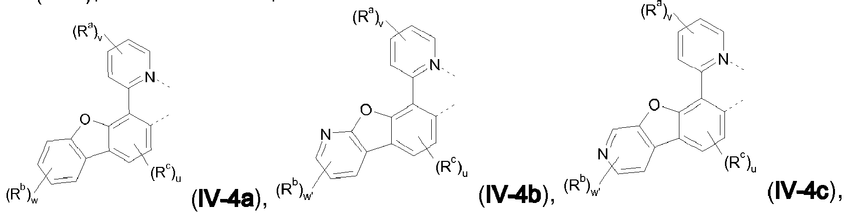 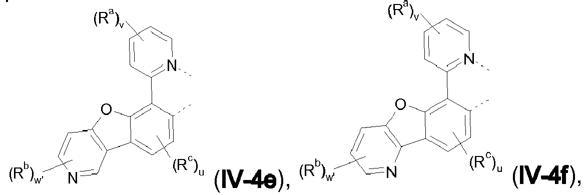 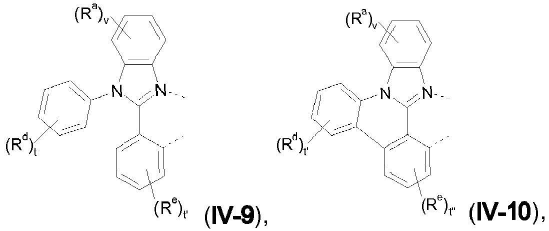 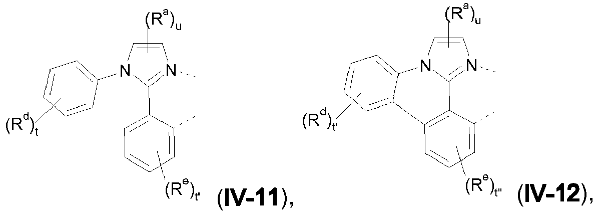 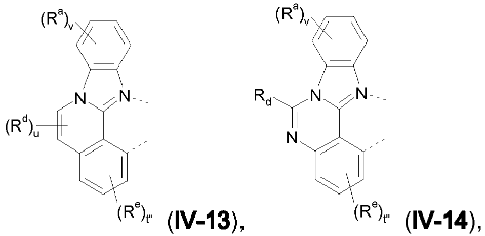 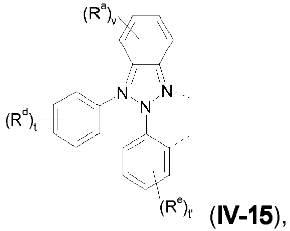 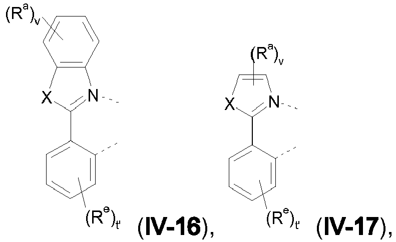 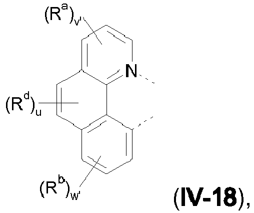 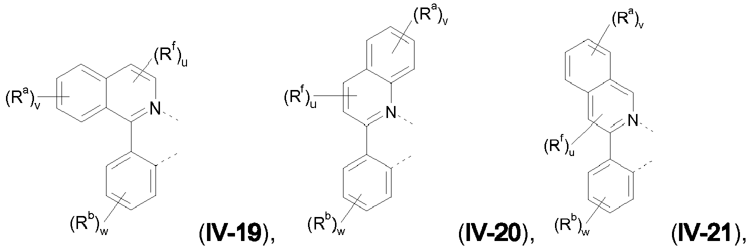 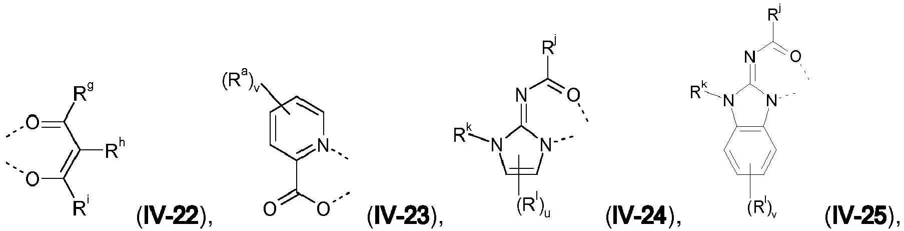 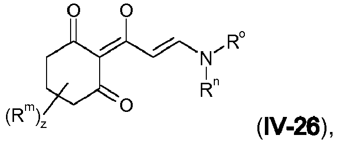 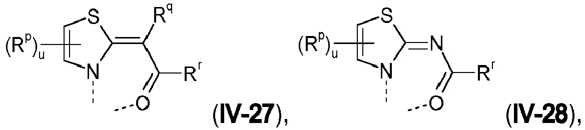 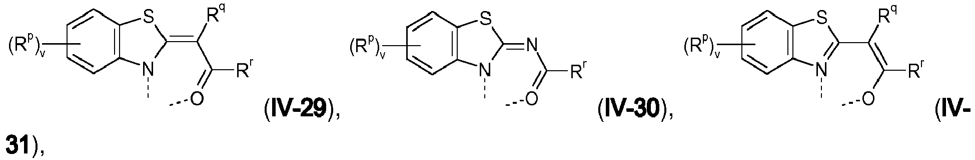 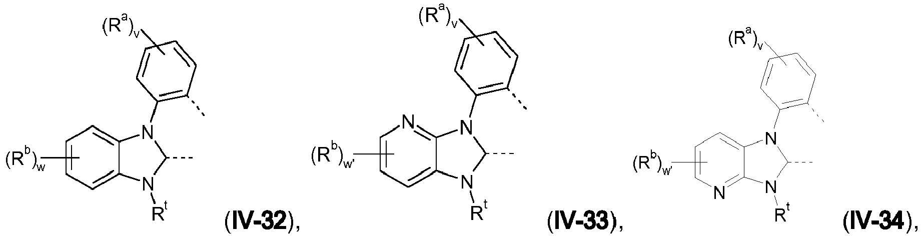 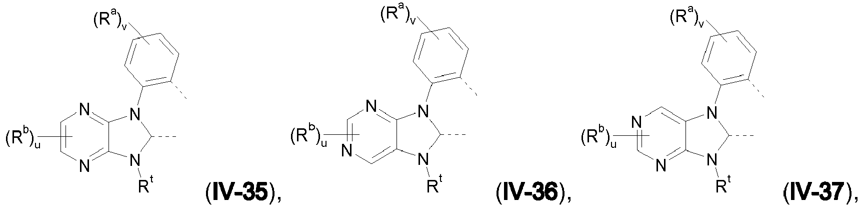 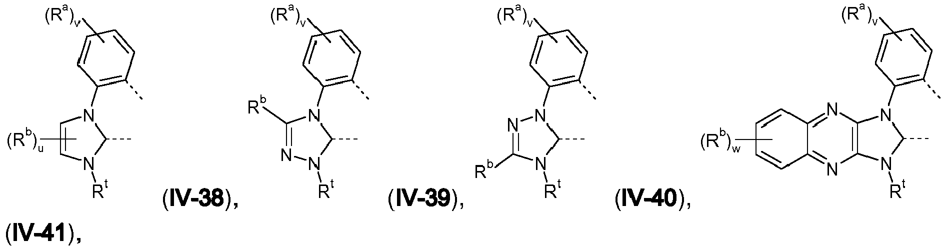 wherein
X is O or S;
R^{a}, R^{b}, R^{c}, R^{d}, R^{e}, R^{f}, R^{g}, R^{h}, Rⁱ, R^{j}, R^{l}, R^{m}, R^{p}, R^{q}, R^{r} and R^{s} are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted five or six membered heteroaromatic ring, an -OR^{c'} group, an -SR^{c'} group or an SiR^{d'}R^{e'}R^{f'} group; provided that, two or more adjacent substituents R^{a} or R^{b} may be bonded to each other to form a ring structure, preferably R^{b}, R^{c}, R^{d}, R^{e}, R^{f}, R^{g}, R^{h}, Rⁱ, R^{j}, R^{l}, R^{m}, R^{p}, R^{q}, R^{r} and R^{s} are each independently hydrogen, deuterium or a C₁-C₄-alkyl group, most preferably hydrogen, deuterium, methyl, CD₃, ethyl, C₂D₅, propyl, especially i-propyl, C₃D₇, especially (CD₃)₂CD or (CH₃)₂CD, R^{a} is preferably a substituted or unsubstituted aromatic hydrocarbon group having 6 to 30 ring carbon atoms, preferably a substituted aromatic hydrocarbon group having 6 ring carbon atoms, which is more preferably substituted by one or more, preferably one or two, alkyl groups having 1 to 30, preferably 1 to 4 carbon atoms, provided that, two or more adjacent substituents R^{a} or R^{b} may be bonded to each other to form a ring structure;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
R^{t}, R^{k}, Rⁿ and R^{o} are each independently a substituted or unsubstituted aromatic hydrocarbon group having 6 to 30 ring carbon atoms, or a substituted or unsubstituted five or six membered heteroaromatic ring;
R⁶³, R⁶⁴, R⁶⁵ and R⁶⁶ in formula IV-4 are each independently defined as R_{c}, wherein R⁶³ and R⁶⁴ or R⁶⁴ and R⁶⁵ or R⁶⁵ and R⁶⁶ together form a ring of the following formula: 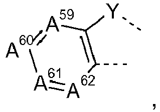 wherein
   Y is O or S, preferably O,
   A⁵⁹ is CR⁵⁹ or N, A⁶⁰ is CR⁶⁰ or N, A⁶¹ is CR⁶¹ or N and A⁶² is CR⁶² or N, wherein 0, 1 or 2, preferably 0 or 1, more preferably, 1 of A5⁹, A⁶⁰, A⁶¹, A⁶² are N, most preferably, A⁵⁹ is N,
   R⁵⁹, R⁶⁰, R⁶¹ and R⁶² are each independently defined as R_{b},
   v, w and t' are each independently 0, 1, 2, 3 or 4, preferably 0, 1 or 2;
   v', w' and t" are each independently 0, 1, 2 or 3, preferably 0, 1 or 2;
   u is 0, 1 or 2, preferably 0 or 1;
   t is 0, 1, 2, 3, 4 or 5, preferably 0, 1, 2 or 3; more preferably 0, 1 or 2; and z is 0, 1, 2, 3, 4, 5 or 6, preferably 0, 1, 2 or 3, more preferably 0, 1 or 2,
   wherein the dotted lines are bonding sites.

More preferred ligands L are the following ligands:
(IV-1); (IV-2); (IV-3); (IV-4), preferably (IV-4a), (IV-4b), (IV-4c), (IV-4e), (IV-4f); (IV-18); (IV-19); (IV-20) and (IV-21); most preferably (IV-1), (IV-4a), (IV-4b), (IV-4c), (IV-4e) and (IV-4f).

Most preferred ligands L are the ligands (IV-1); (IV-2); (IV-3); (IV-4), preferably (IV-4a), (IV-4b), (IV-4c), (IV-4e), (IV-4f); (IV-18); (IV-19); (IV-20) and (IV-21), preferably (IV-1), (IV-4a), (IV-4b), (IV-4c), (IV-4e) and (IV-4f), more preferably (IV-1) and (IV-4b), wherein v is 0, 1 or 2, R^{a} is hydrogen, deuterium, methyl, CD₃, ethyl, C₂D₅, propyl, especially i-propyl, C₃D₇, especially (CD₃)₂CD or (CH₃)₂CD, a substituted or unsubstituted aromatic hydrocarbon group having 6 to 30 ring carbon atoms, preferably a substituted aromatic hydrocarbon group having 6 ring carbon atoms, which is more preferably substituted by one or more, preferably one or two, alkyl groups having 1 to 30, preferably 1 to 4 carbon atoms, and R^{b}, R^{c}, R^{d}, R^{f} are each independently hydrogen, deuterium, methyl, CD₃, ethyl, C₂D₅, propyl, especially i-propyl, C₃D₇, especially (CD₃)₂CD or (CH₃)₂CD, preferably hydrogen, and R⁶³, R⁶⁴, R⁶⁵ and R⁶⁶ are hydrogen. Further most preferred ligands L are the ligands (IV-1), wherein the residues R^{a} and R^{b} and v and w are defined before.

Further most preferred are therefore the following metal complexes: 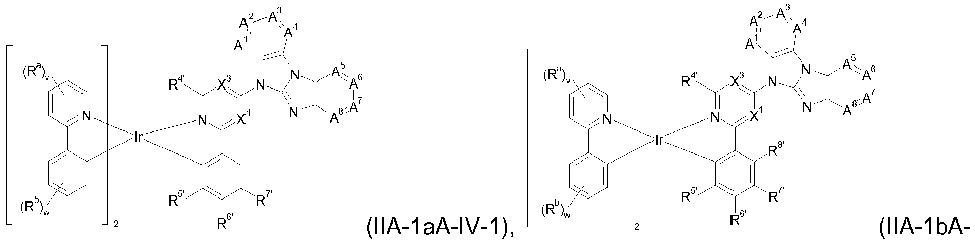 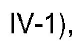 preferably 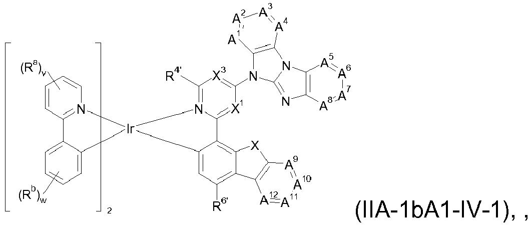 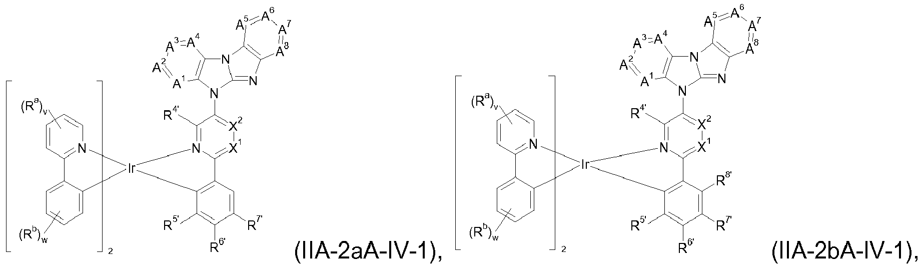 preferably 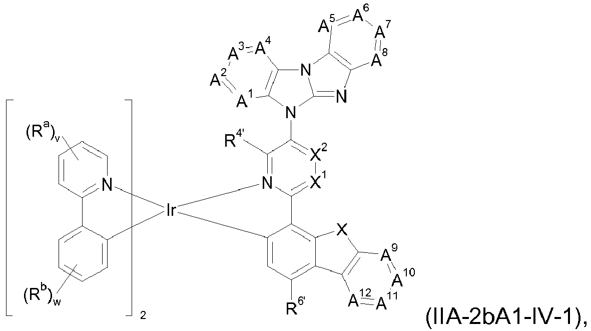 wherein the residues, symbols and indices are defined above,
preferably,
A⁹ is CR⁹ or N, A¹⁰ is CR¹⁰ or N, A¹¹ is CR¹¹ or N, A¹² is CR¹² or N, wherein 0, 1 or 2, preferably 0 or 1, more preferably, 1 of A⁹, A¹⁰, A¹¹, A¹² are N, most preferably, A⁹ is N,
wherein R^{6'} and R^{7'} or R^{7'} and R^{8'} in formulae (IIA-1bA-IV-1) and (IIA-2bA-IV-1) together form a ring of the following formula: 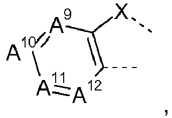 or R^{5'} and R^{6'} or R^{6'} and R^{7'} or R^{7'} and R^{8'} in formulae (IIA-1bA-IV-1) and (IIA-2bA-IV-1) together form a ring of the following formula: 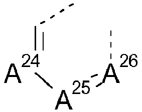 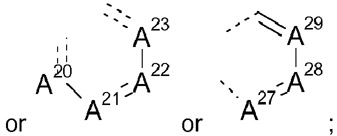
A²⁰ is CR²⁰ or N, A²¹ is CR²¹ or N, A²² is CR²² or N, A²³ is CR²³ or N, A²⁴ is CR²⁴ or N, A²⁵ is CR²⁵ or N, A²⁶ is CR²⁶ or N, A²⁷ is CR²⁷ or N, A²⁸ is CR²⁸ or N and A²⁹ is CR²⁹ or N,
wherein 0 or 1, preferably 0 of A^{20'}, A²¹, A²² and A²³, respectively of A²⁴, A²⁵ and A²⁶, respectively of A²⁷, A²⁸ and A²⁹ are N,
R^{g}, R¹⁰, R¹¹, R¹², R²⁰, R^{20'}, R²¹, R²², R²³, R²⁴, R²⁵, R²⁶, R²⁷, R²⁸ and R²⁹ are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted five or six membered heteroaromatic ring, an -OR^{c'} group, an -SR^{c'} group or an SiR^{d'}R^{e'}R^{f'} group; preferably hydrogen, deuterium, a substituted or unsubstituted alkyl group having 1 to 30 carbon atoms, a substituted or unsubstituted cycloalkyl group having 3 to 30 ring carbon atoms, more preferably hydrogen, deuterium or a C₁-C₄-alkyl group, most preferably hydrogen, deuterium, methyl, CD₃, ethyl, C₂D₅, propyl, especially i-propyl, C₃D₇, especially (CD₃)₂CD or (CH₃)₂CD, most preferably hydrogen,
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
X is O or S,
wherein the dotted lines are bonding sites, and
v is 0, 1 or 2,
R^{a} is hydrogen, deuterium, methyl, CD₃, ethyl, C₂D₅, propyl, especially i-propyl, C₃D₇, especially (CD₃)₂CD or (CH₃)₂CD, a substituted or unsubstituted aromatic hydrocarbon group having 6 to 30 ring carbon atoms, preferably a substituted aromatic hydrocarbon group having 6 ring carbon atoms, which is more preferably substituted by one or more, preferably one or two, alkyl groups having 1 to 30, preferably 1 to 4 carbon atoms,
and
R^{b} is hydrogen, deuterium, methyl, CD₃, ethyl, C₂D₅, propyl, especially i-propyl, C₃D₇, especially (CD₃)₂CD or (CH₃)₂CD, preferably hydrogen.

Exemplified metal complexes according to the present invention are mentioned in the following: 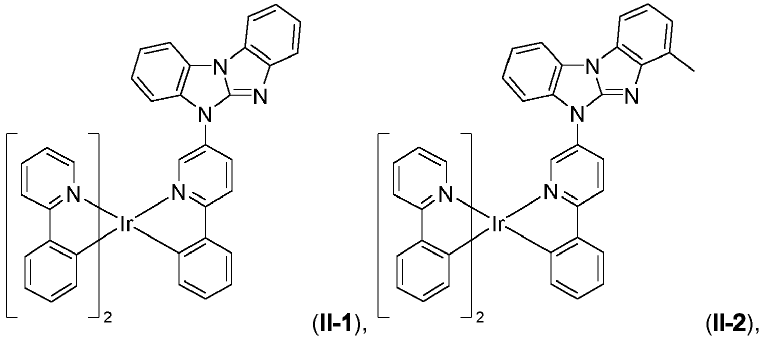 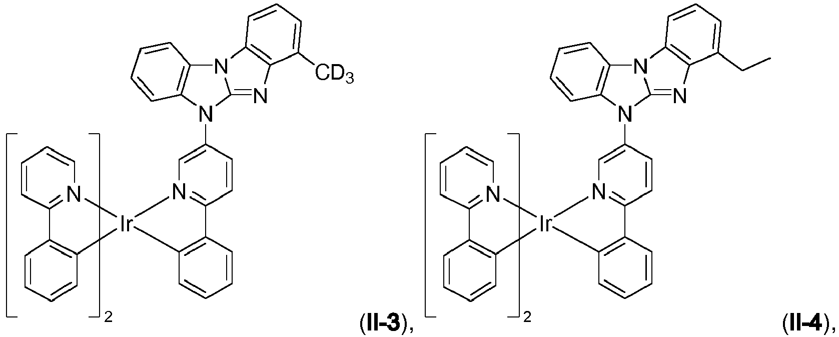 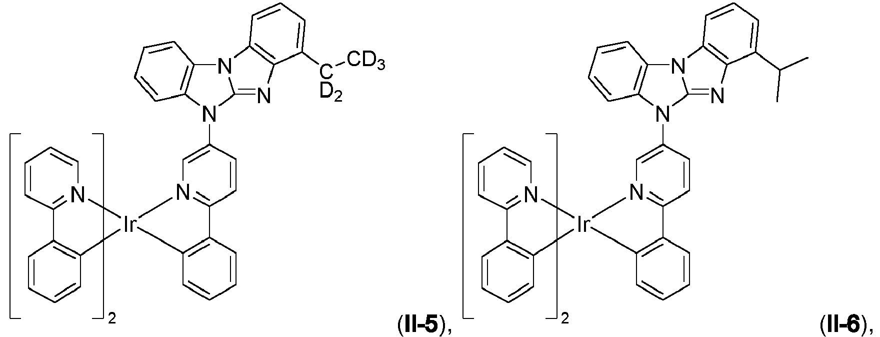 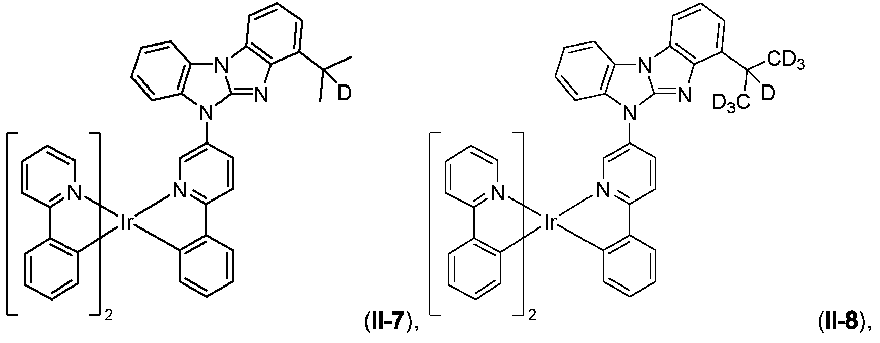 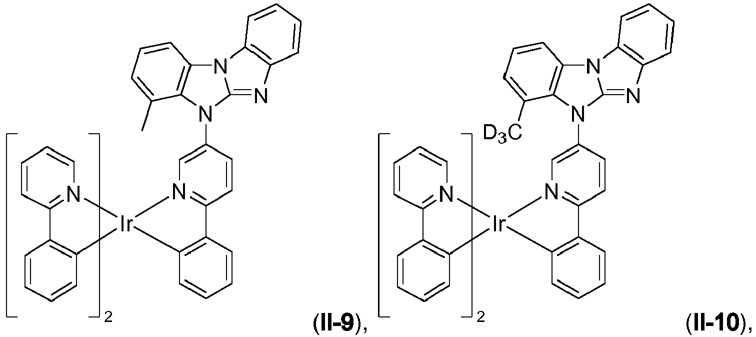 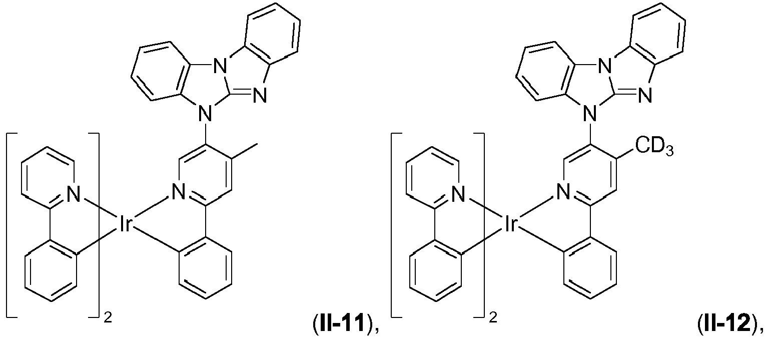 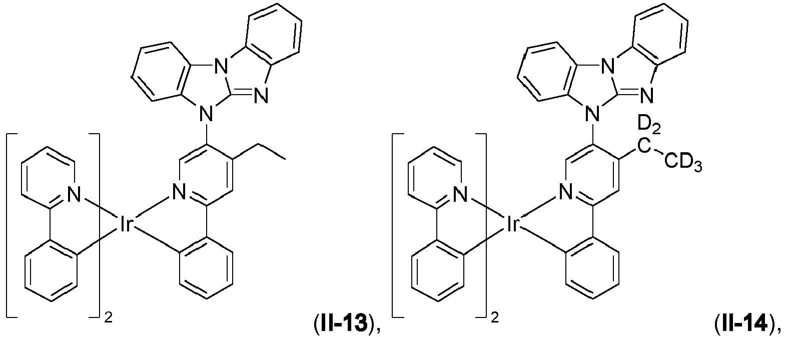 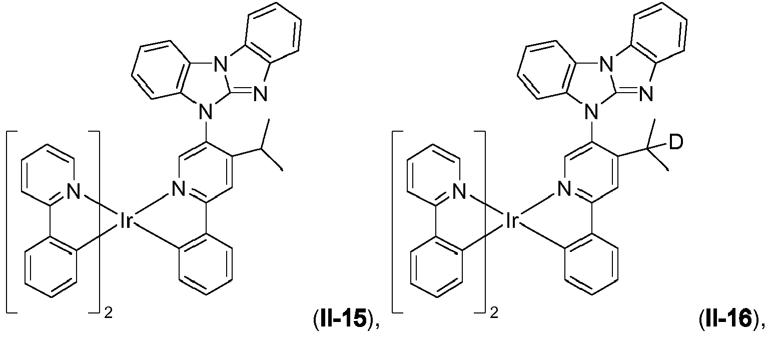 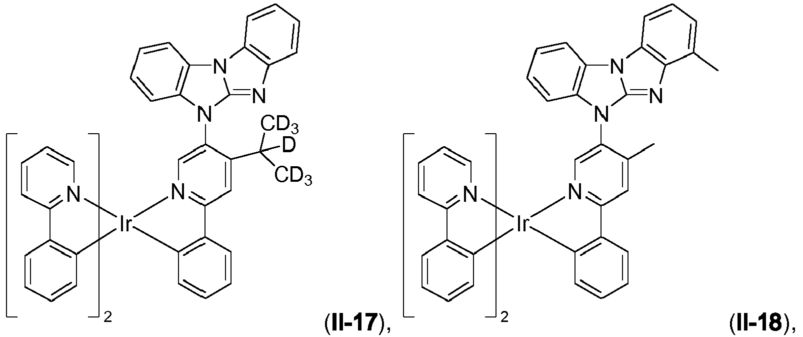 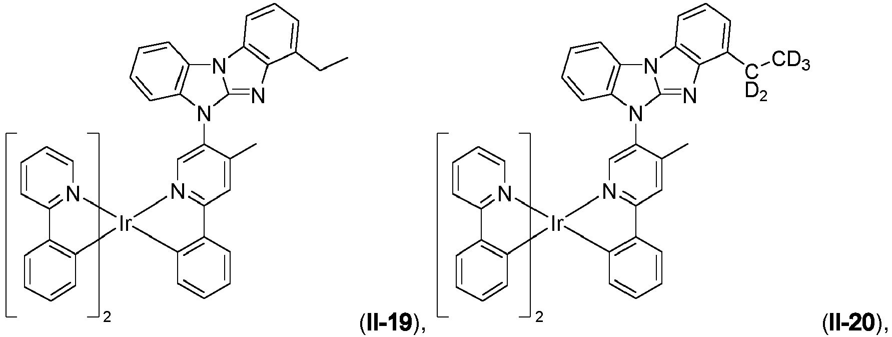 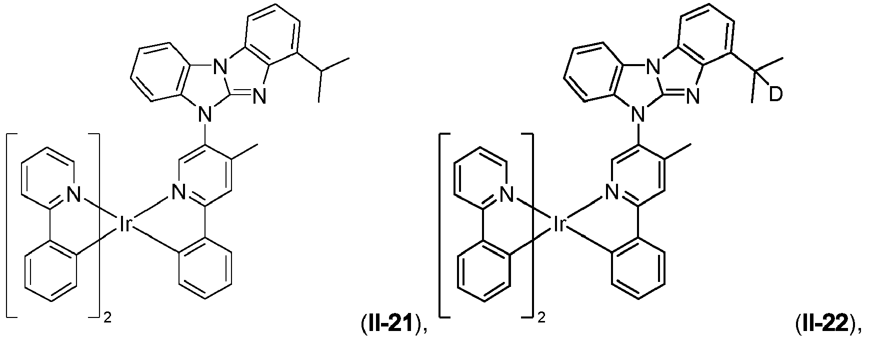 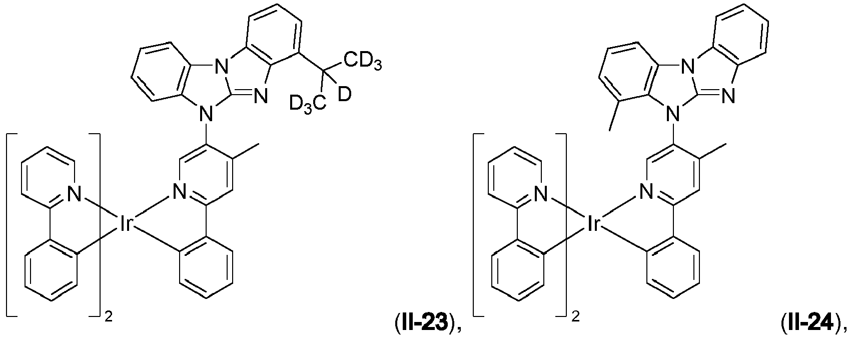 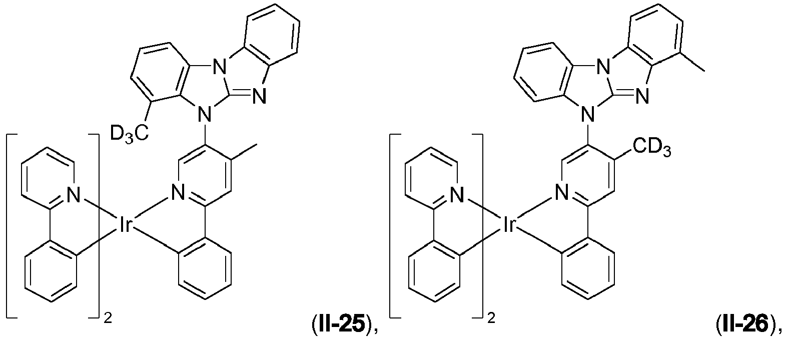 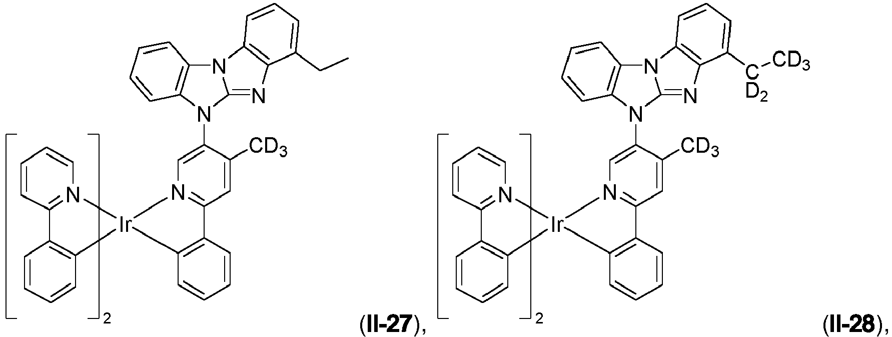 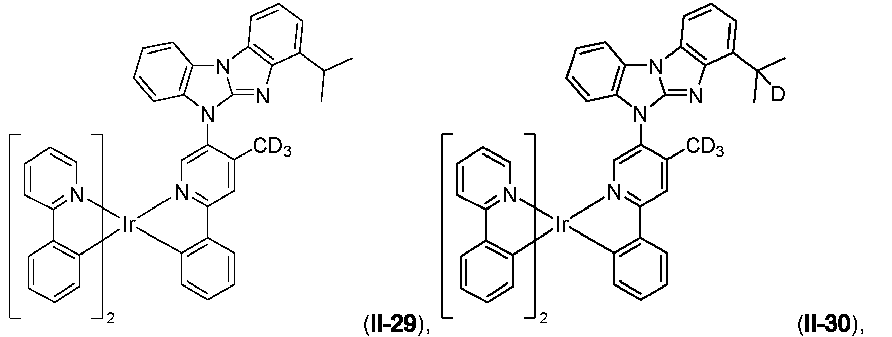 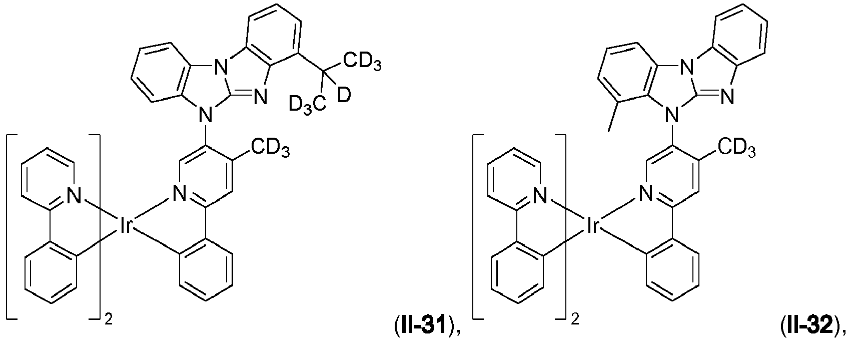 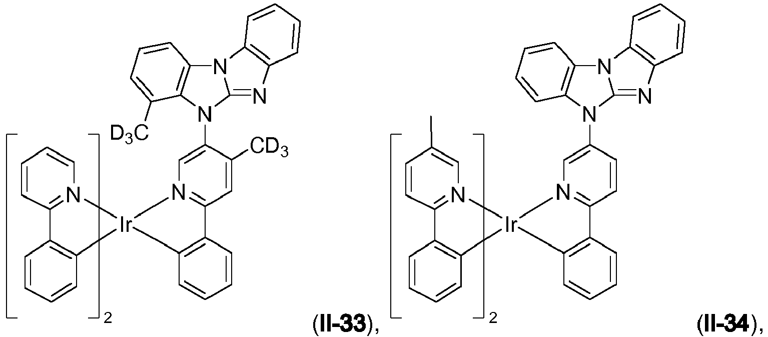 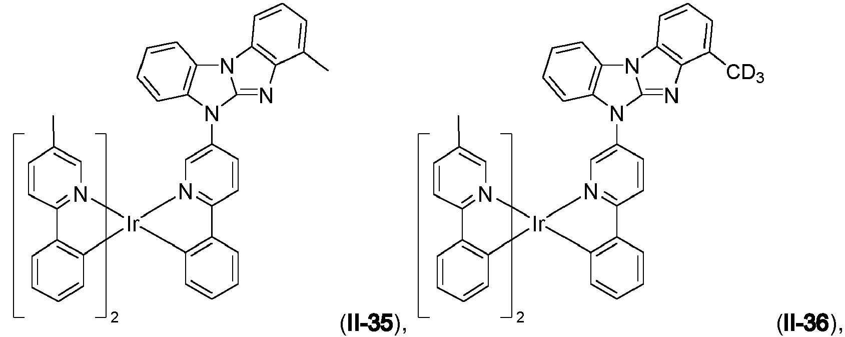 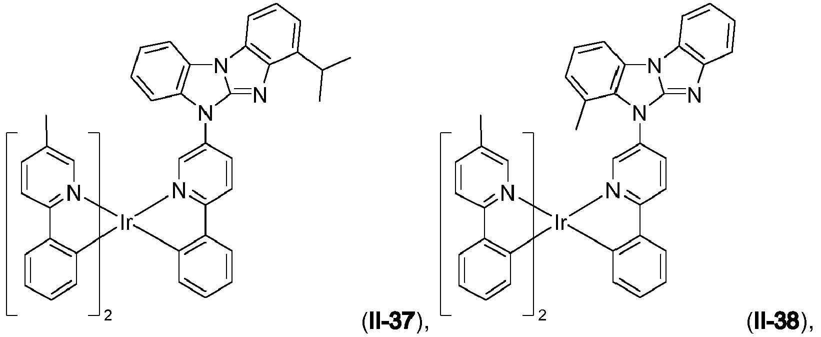 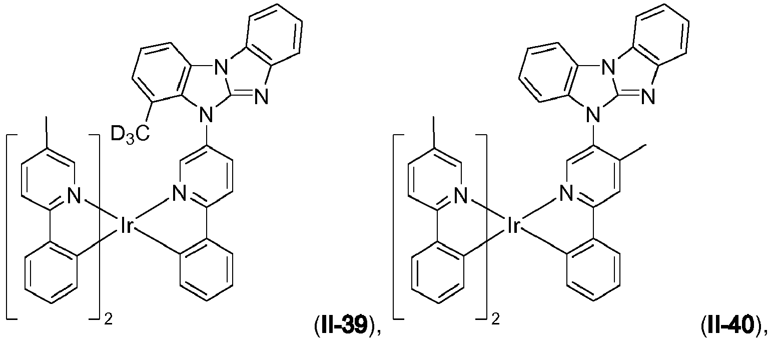 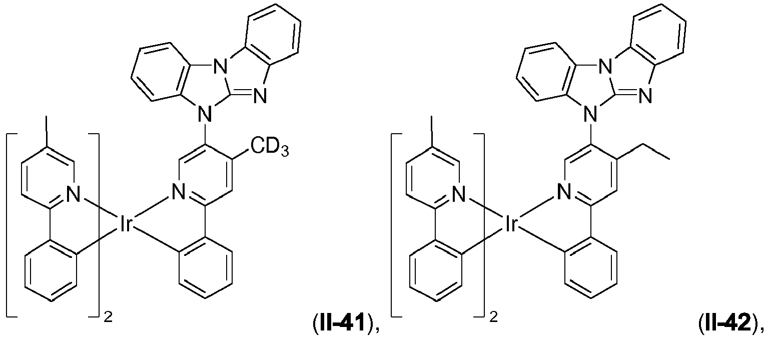 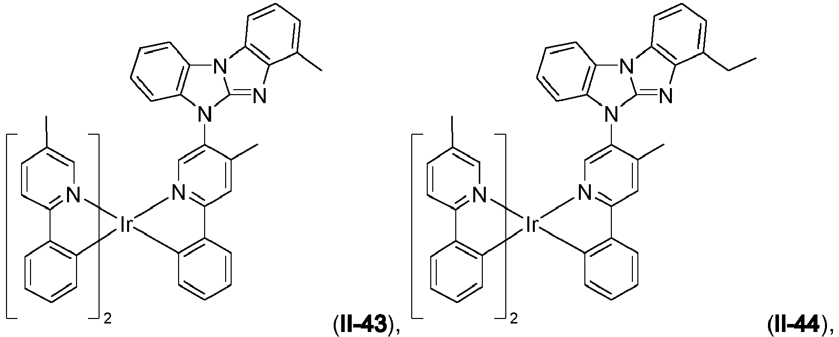 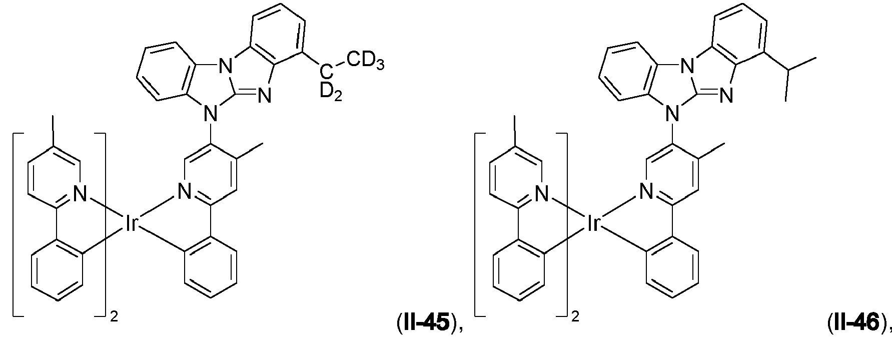 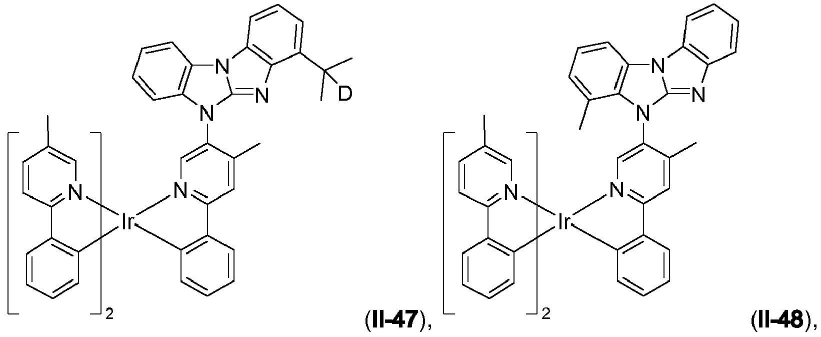 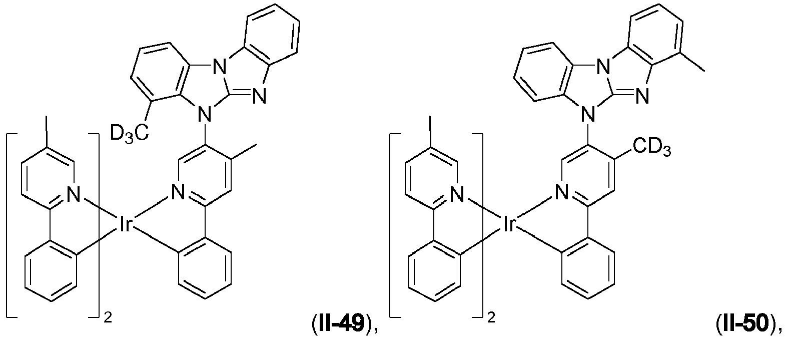 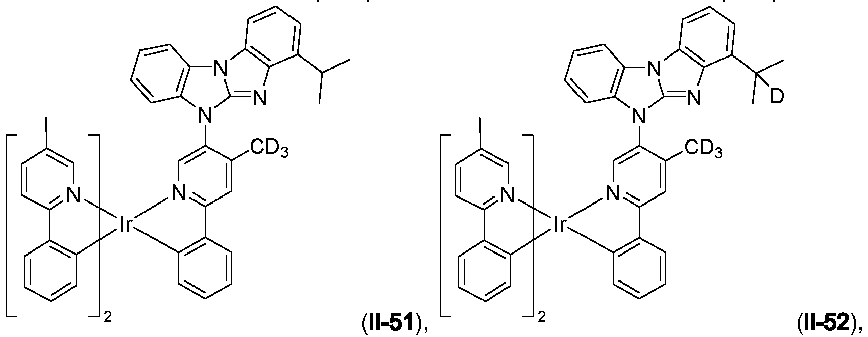 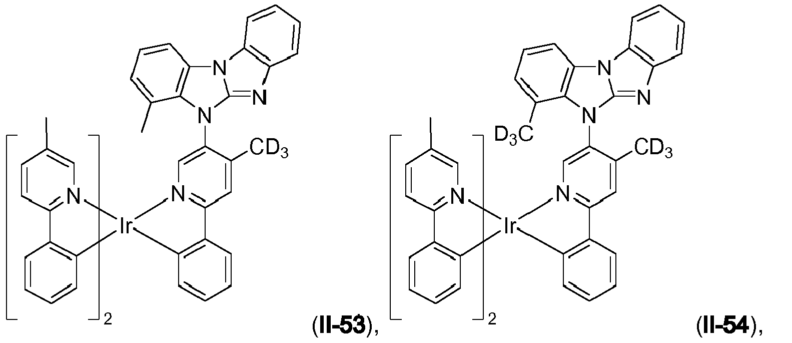 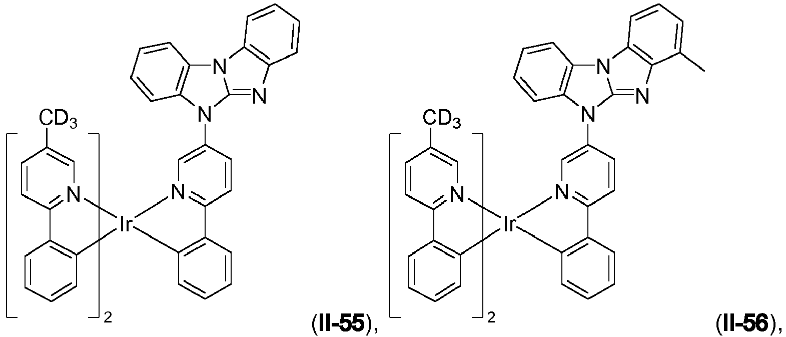 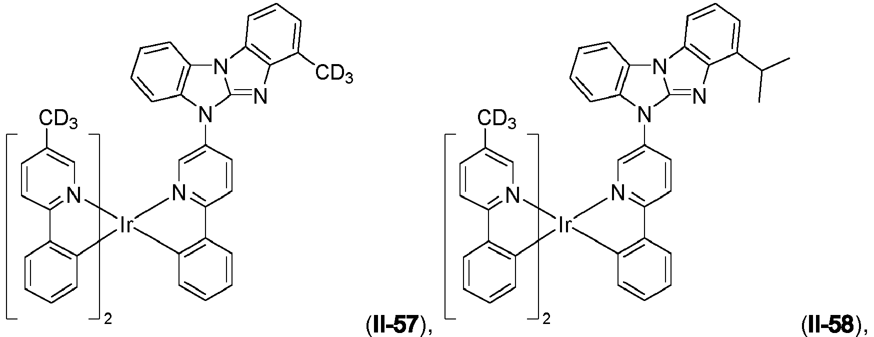 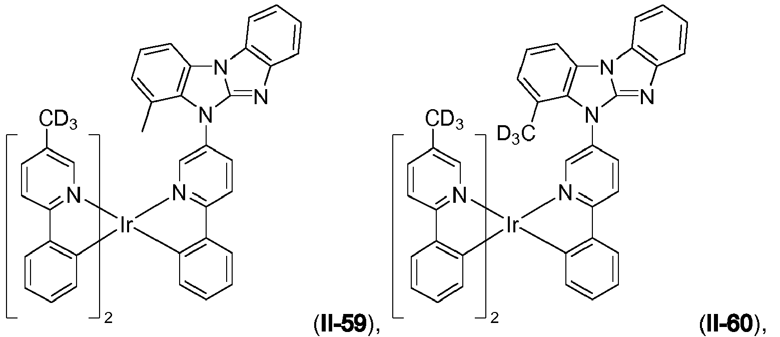 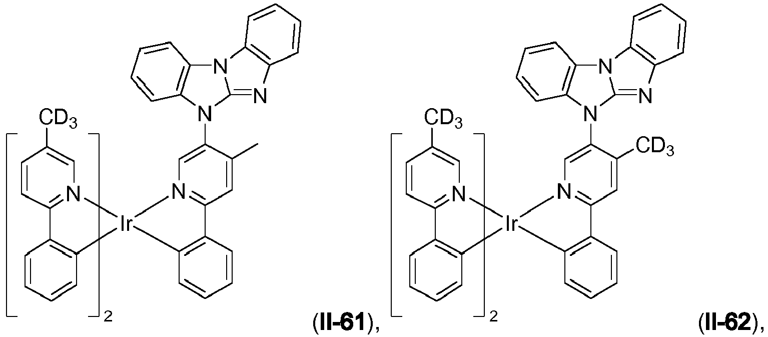 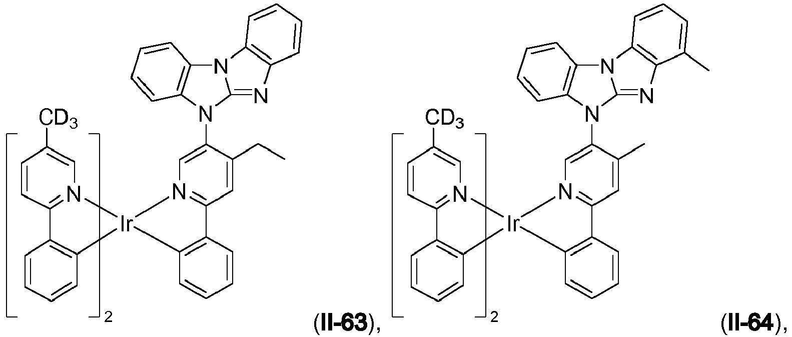 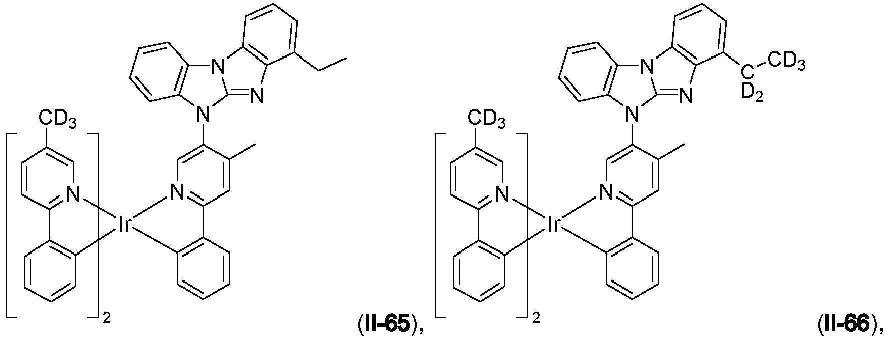 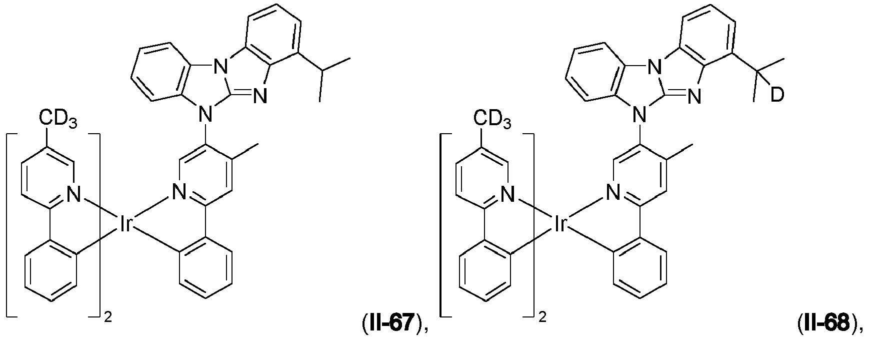 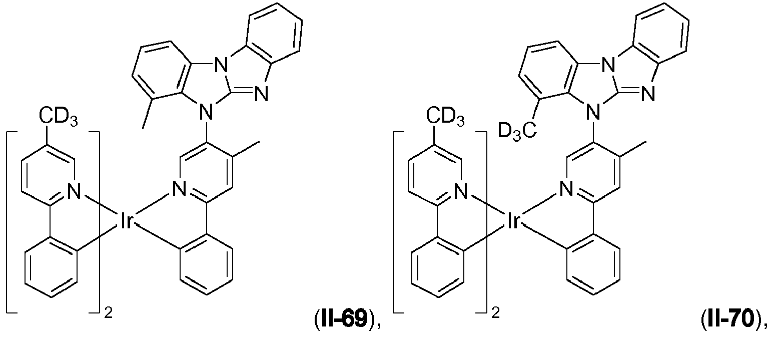 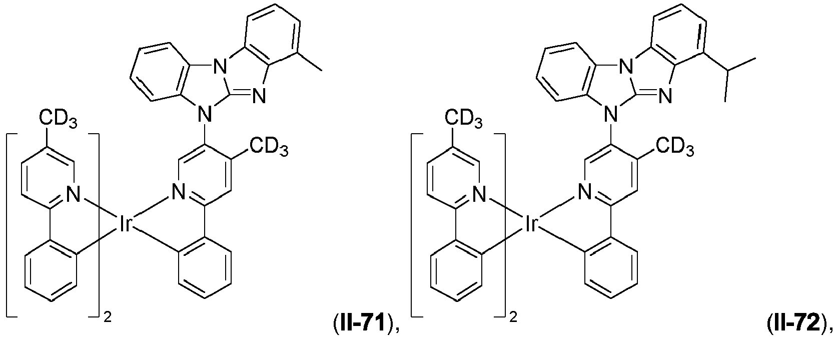 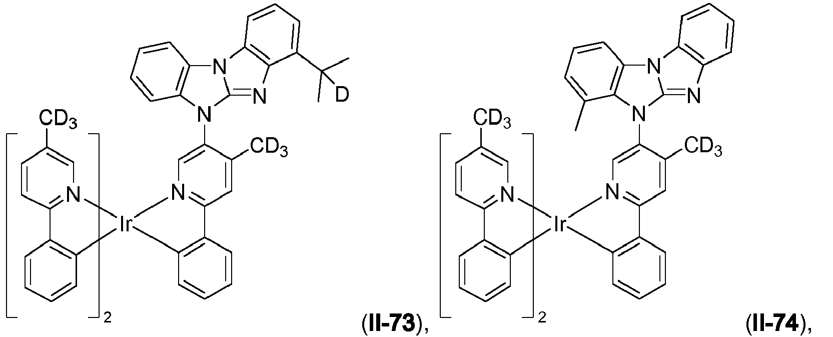 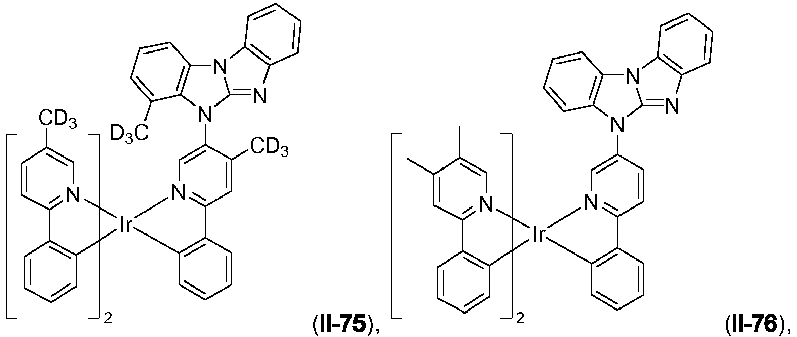 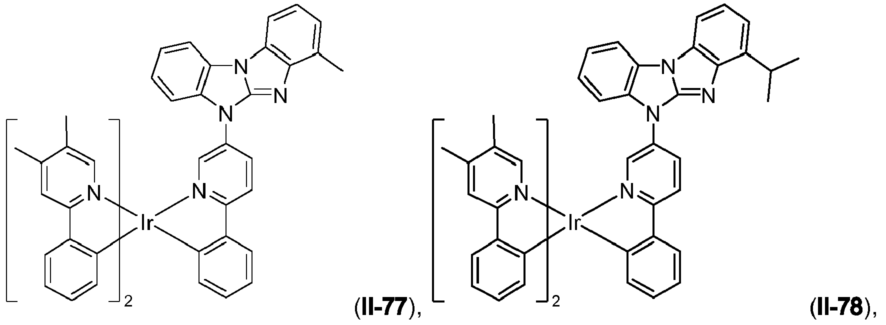 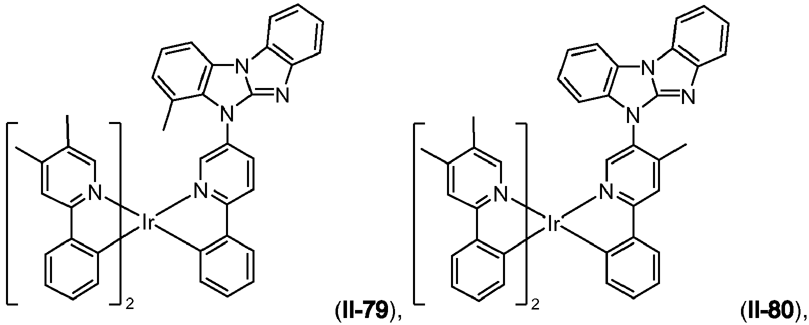 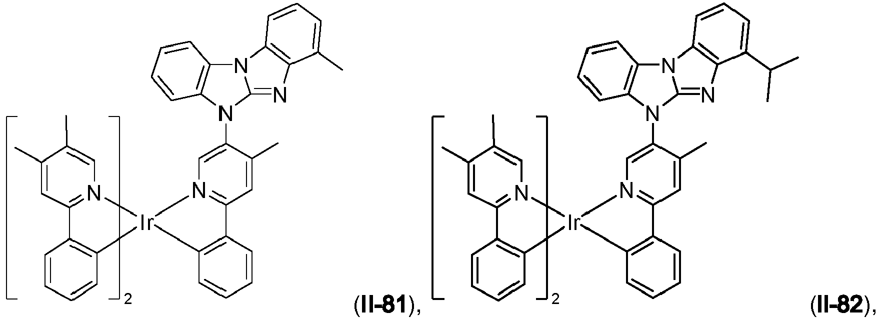 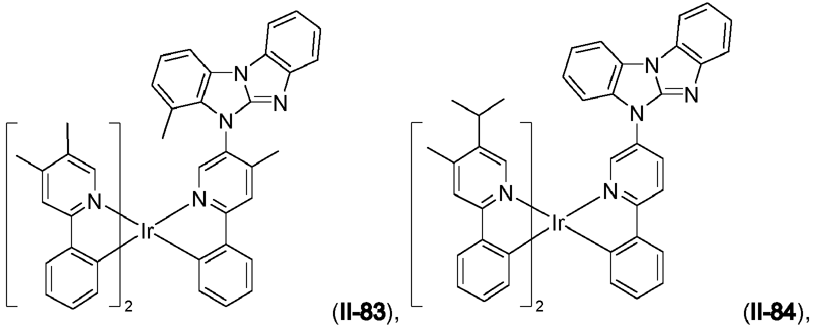 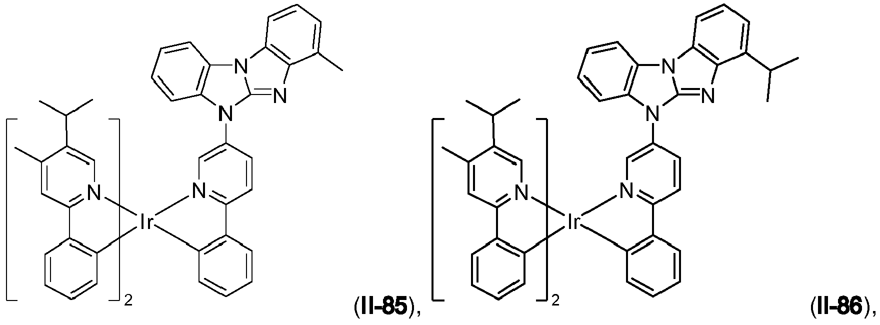 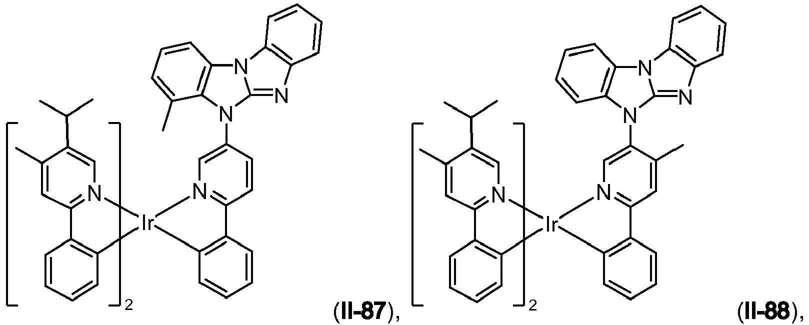 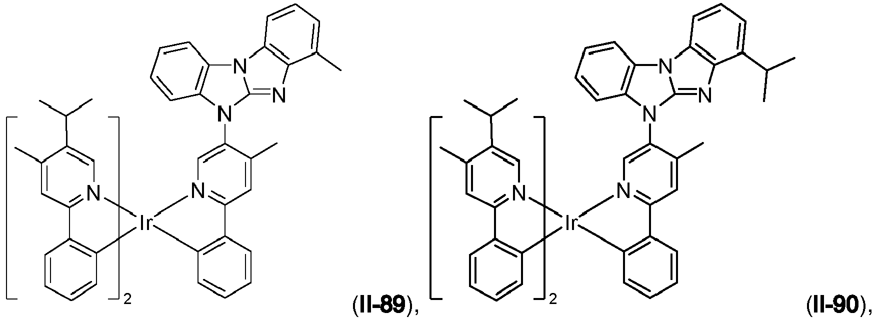 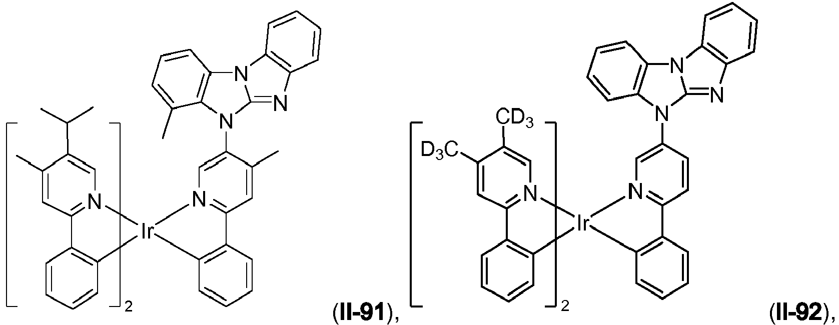 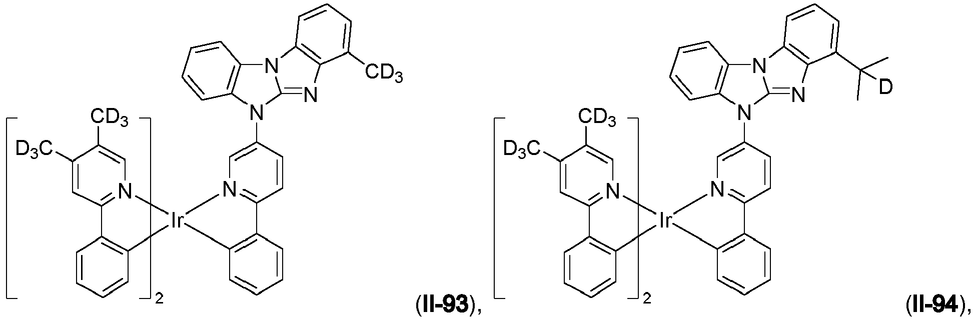 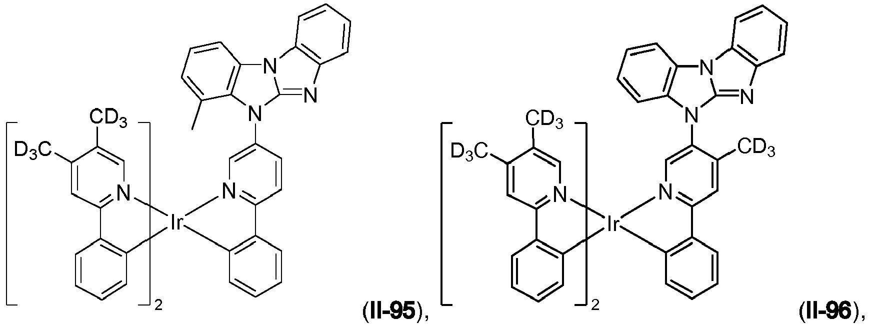 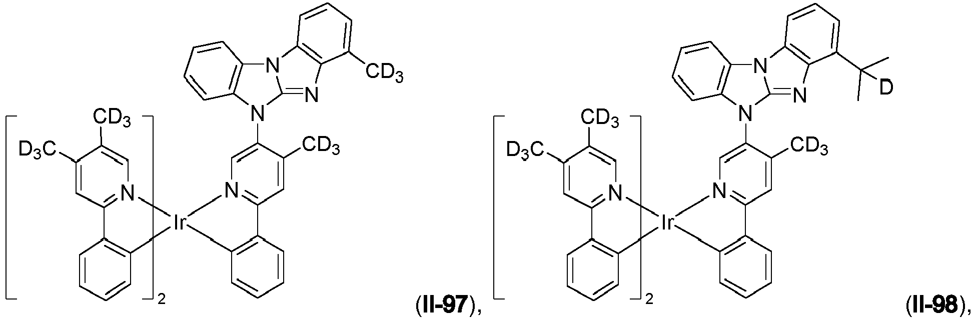 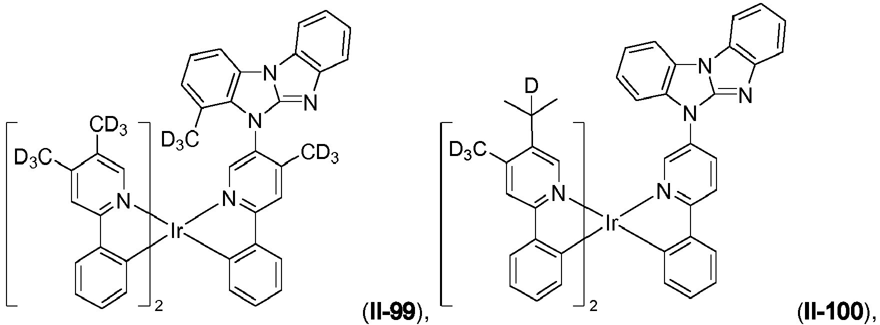 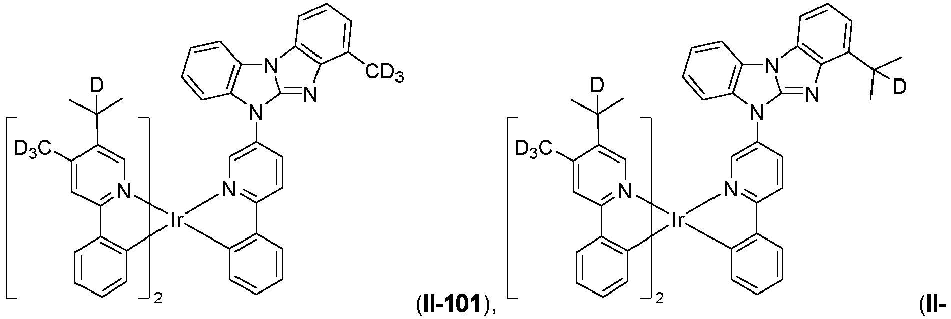 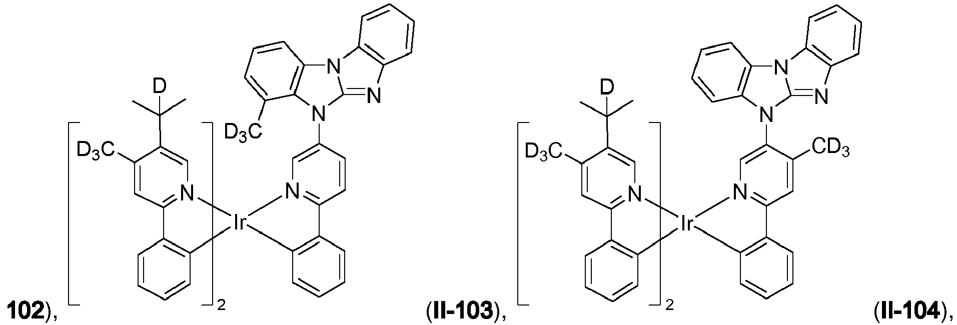 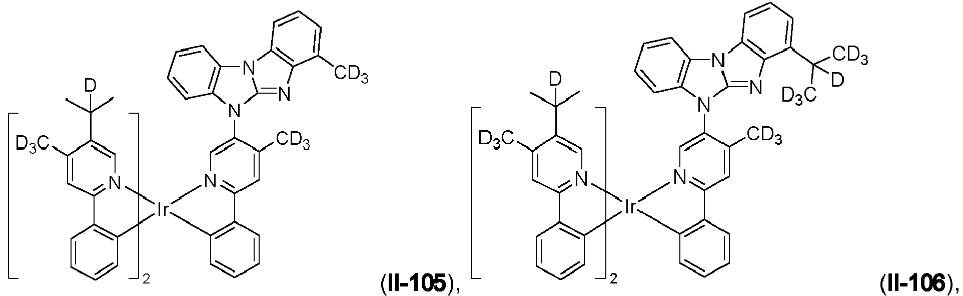 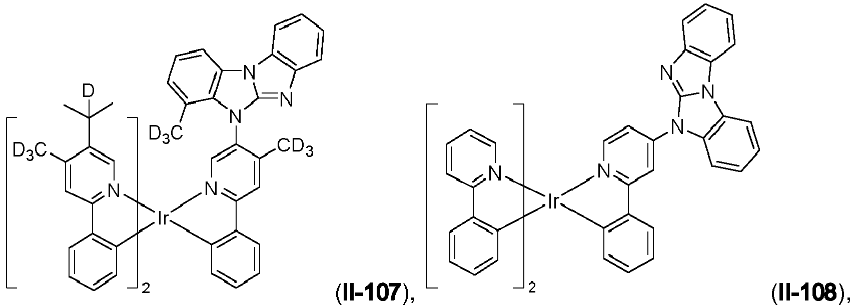 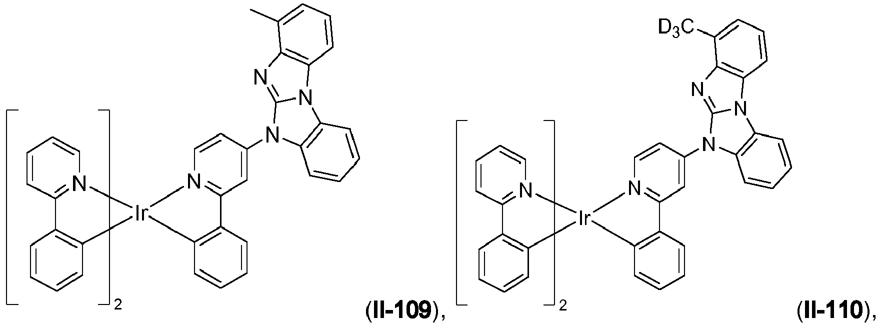 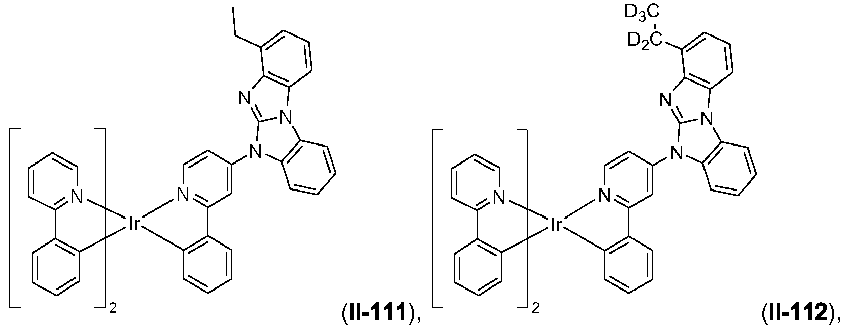 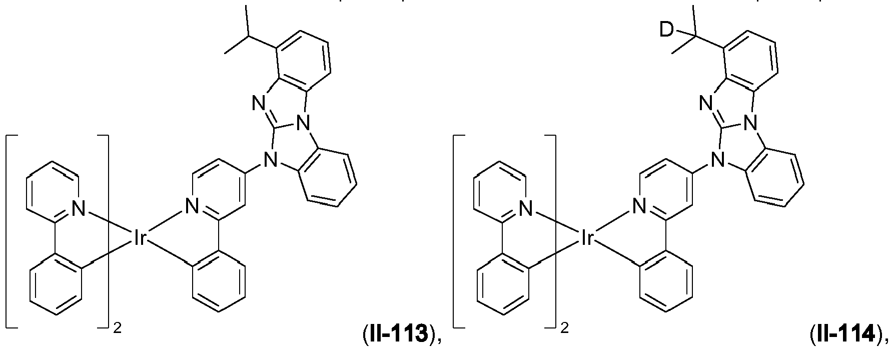 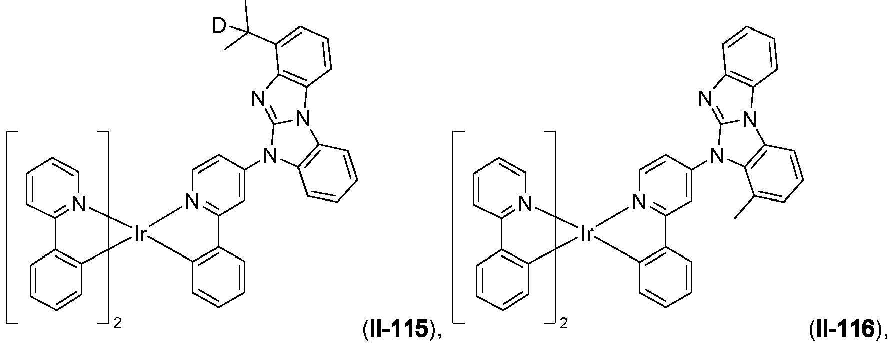 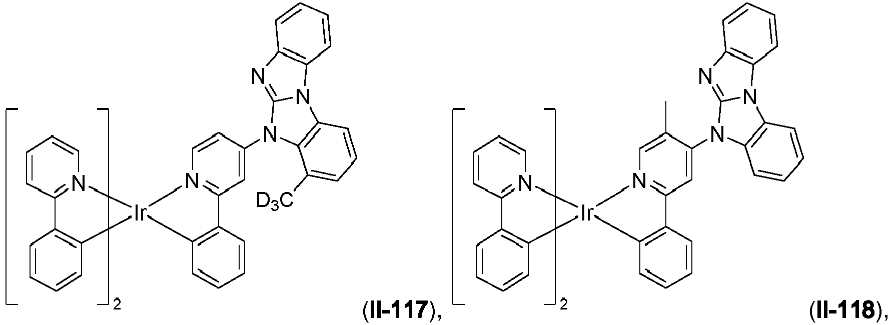 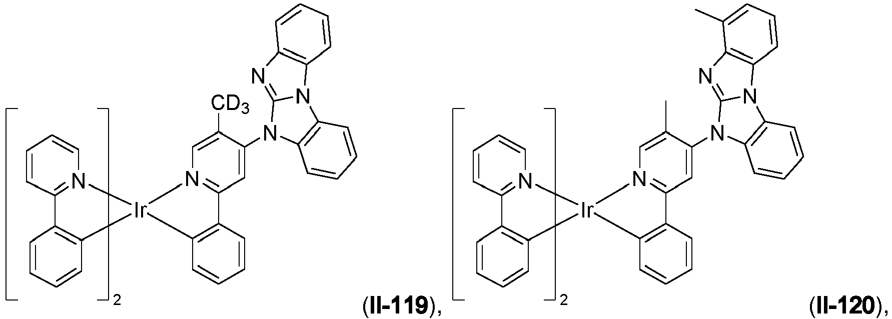 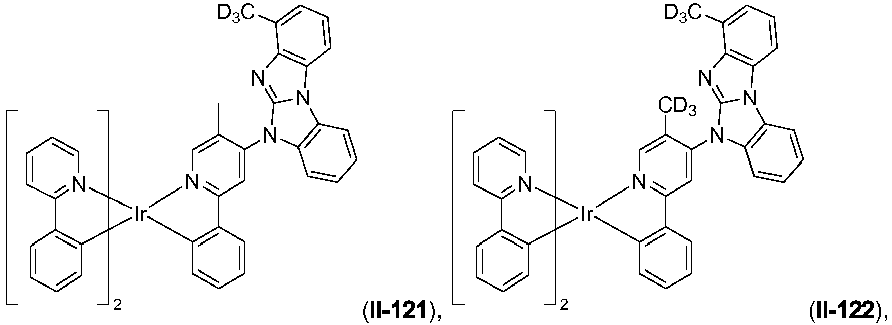 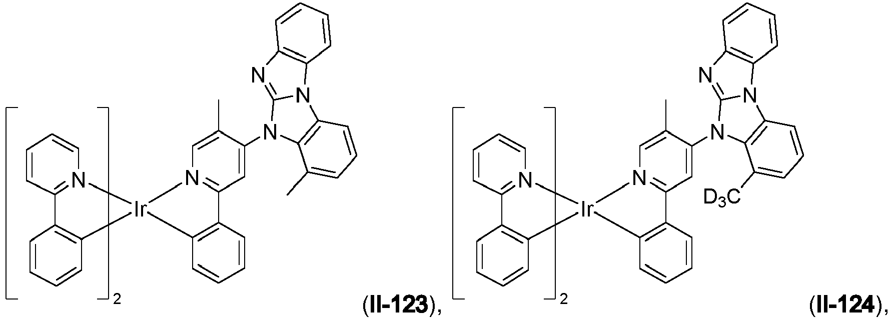 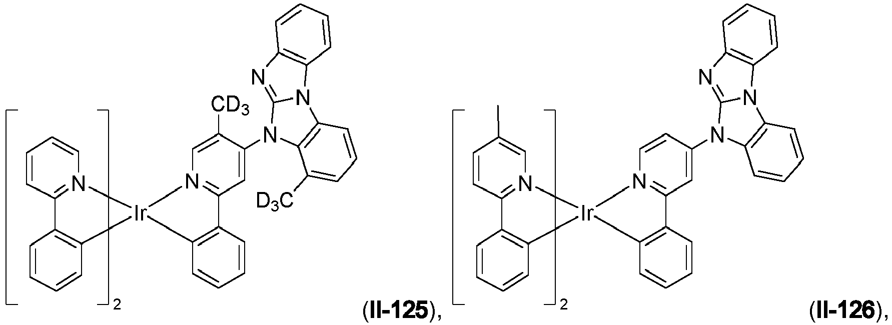 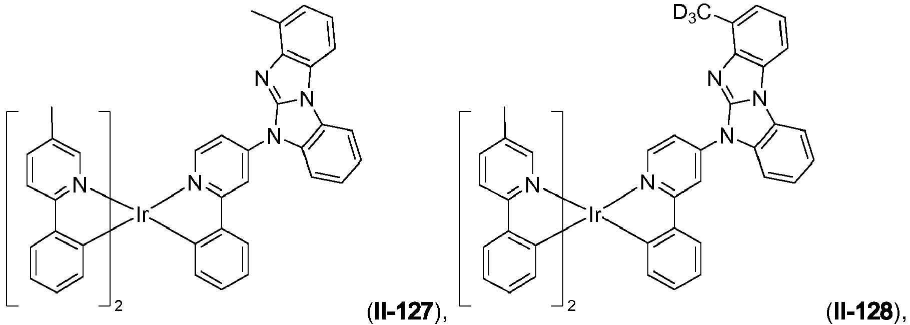 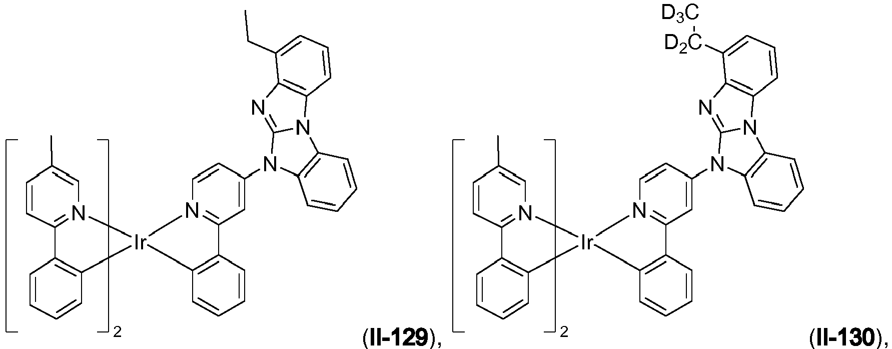 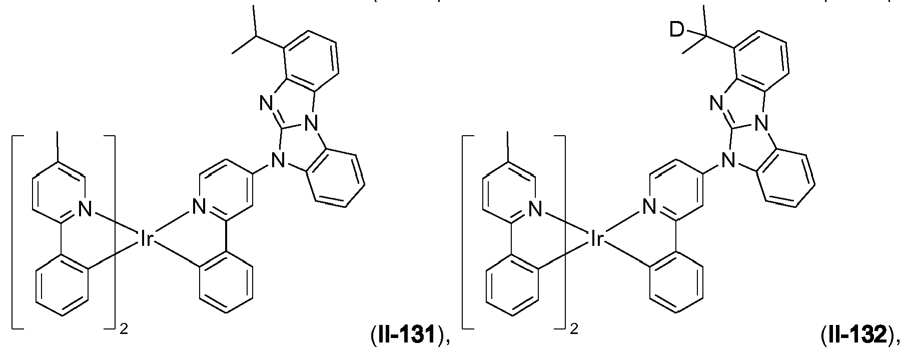 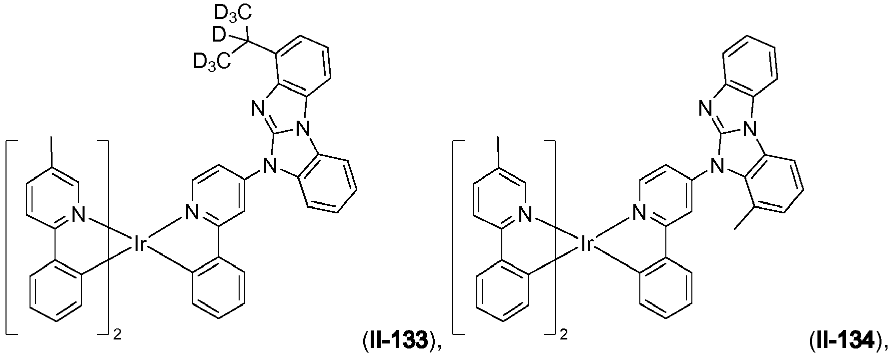 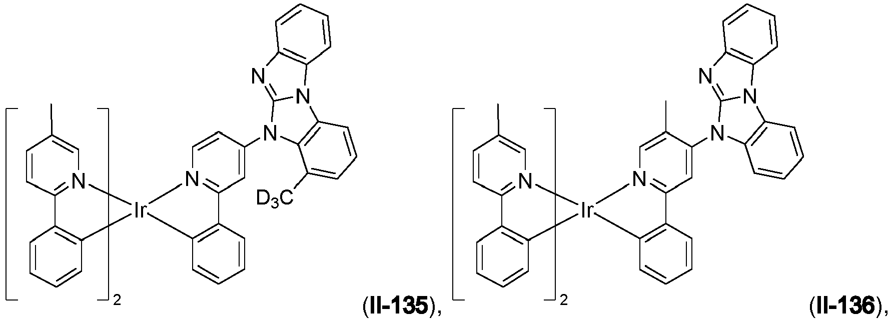 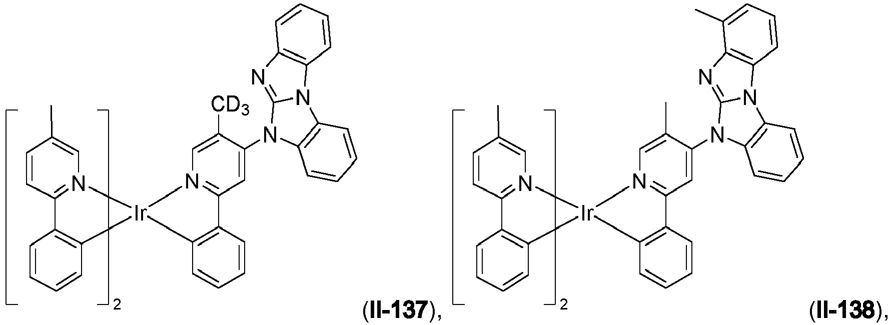 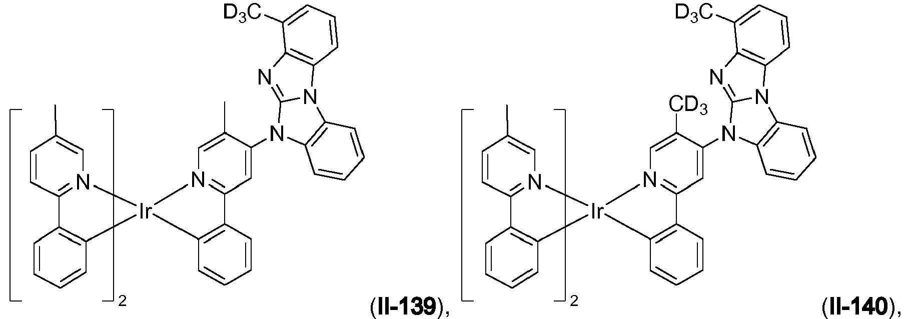 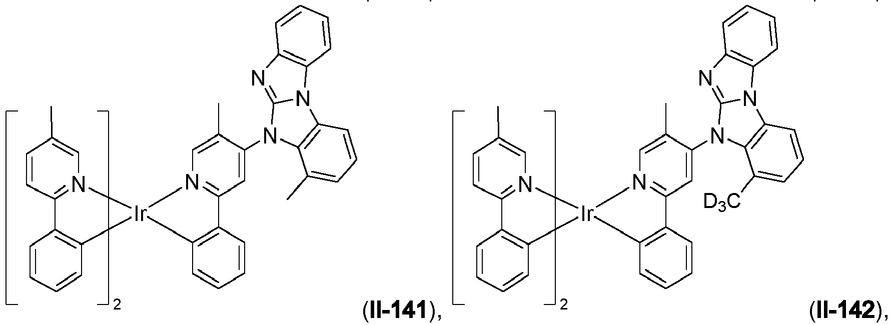 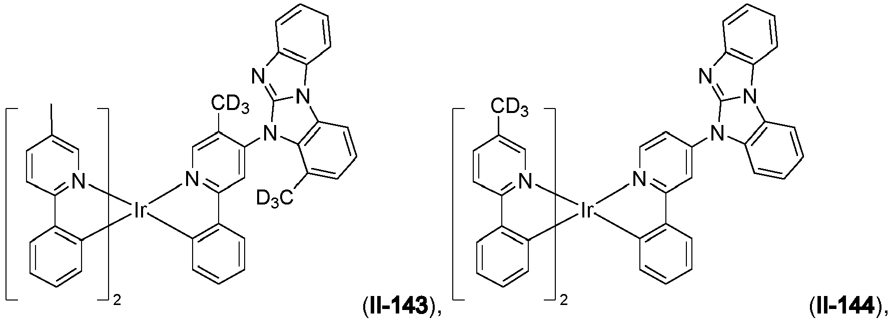 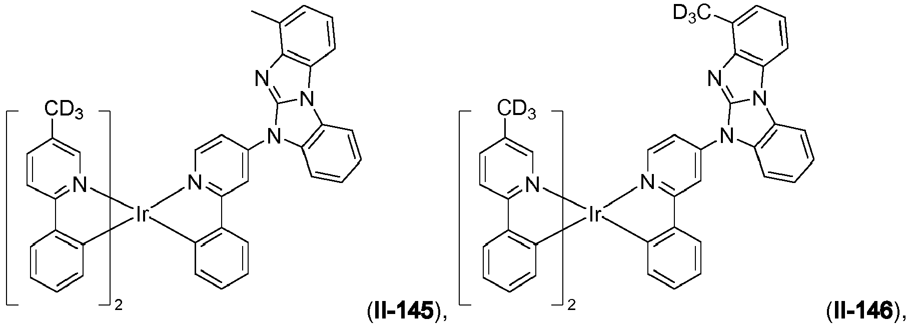 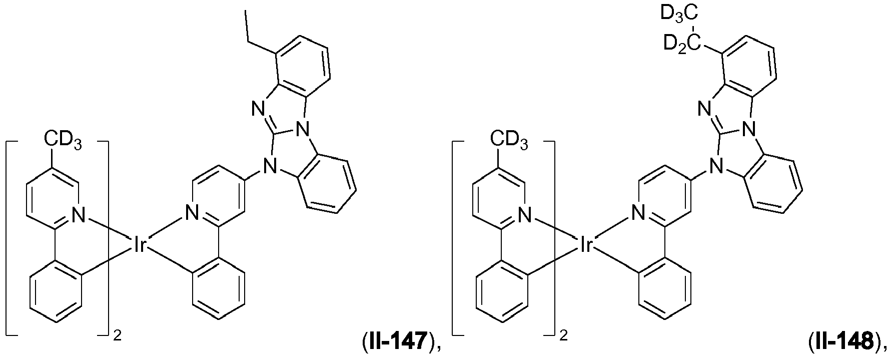 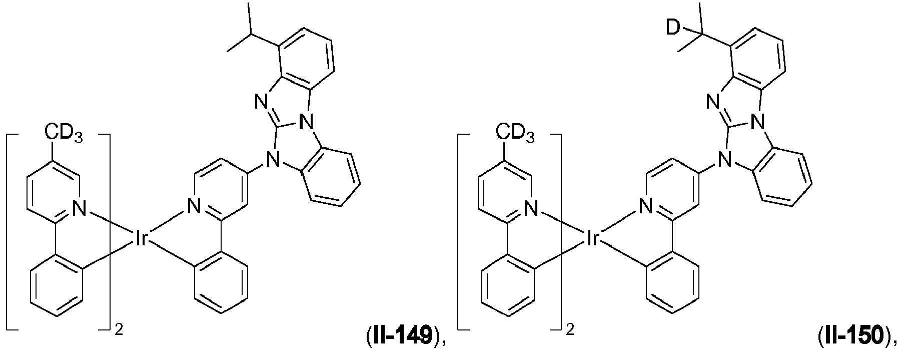 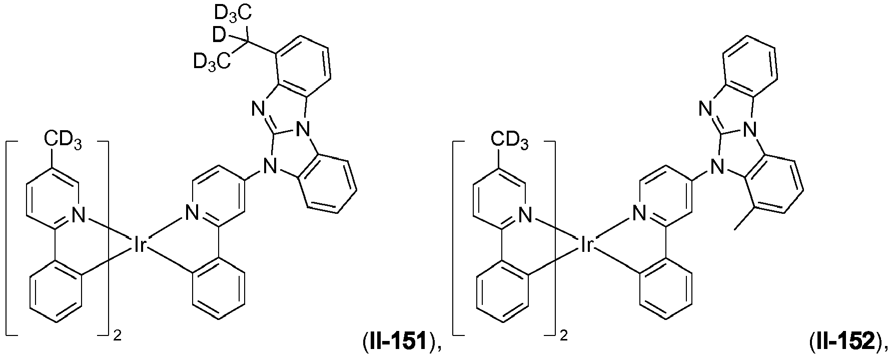 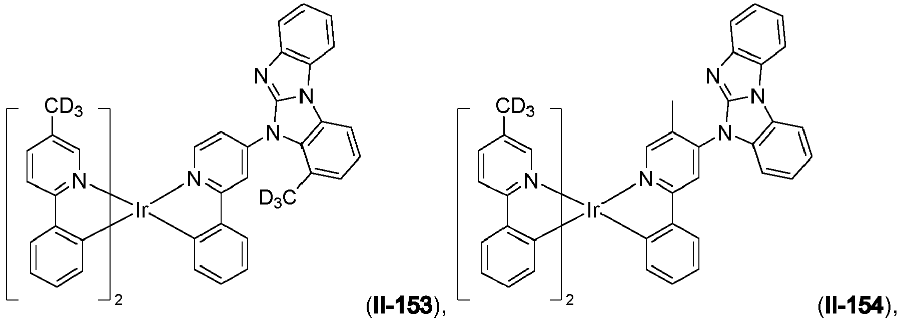 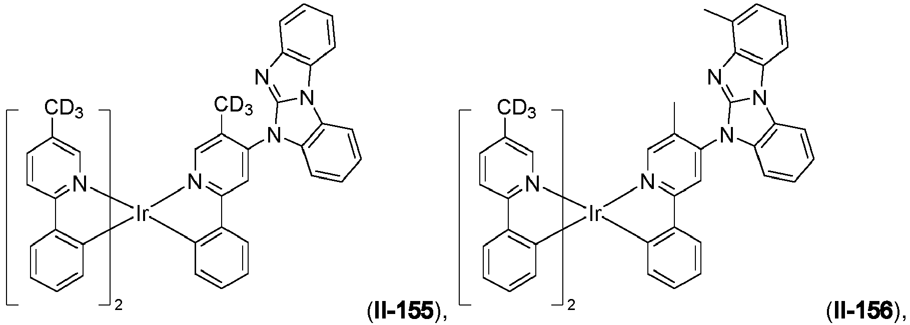 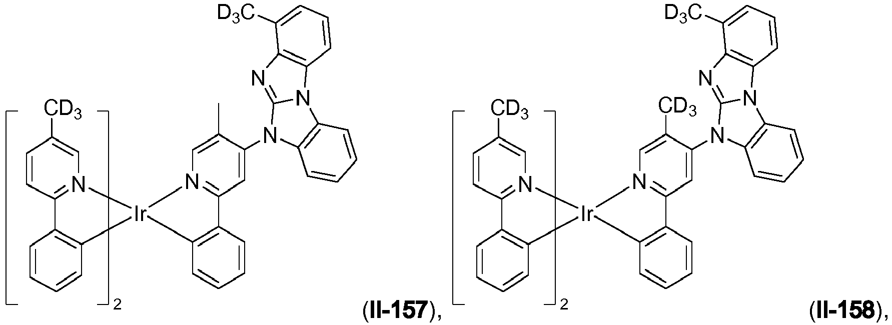 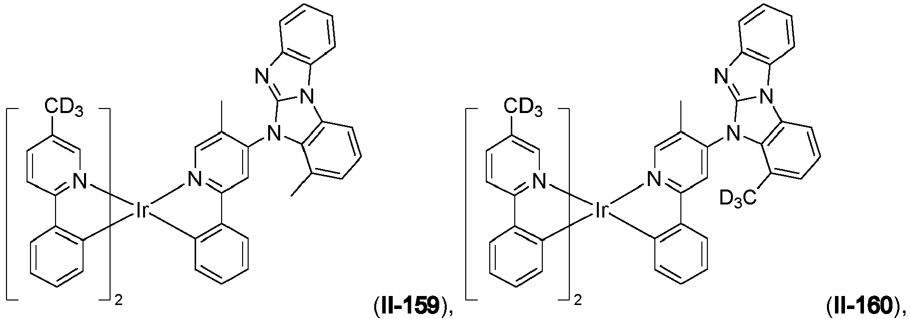 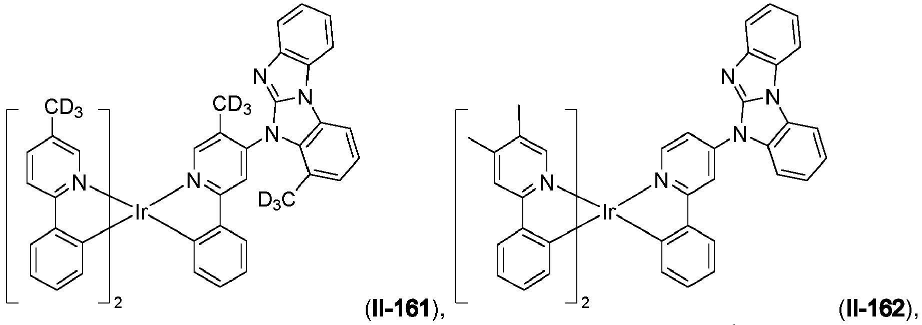 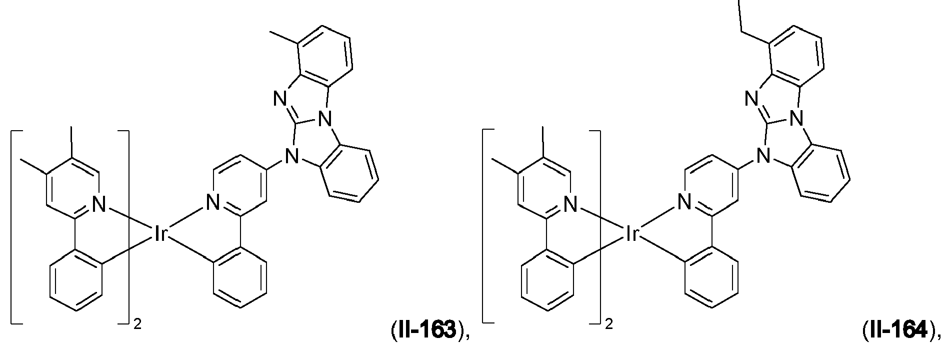 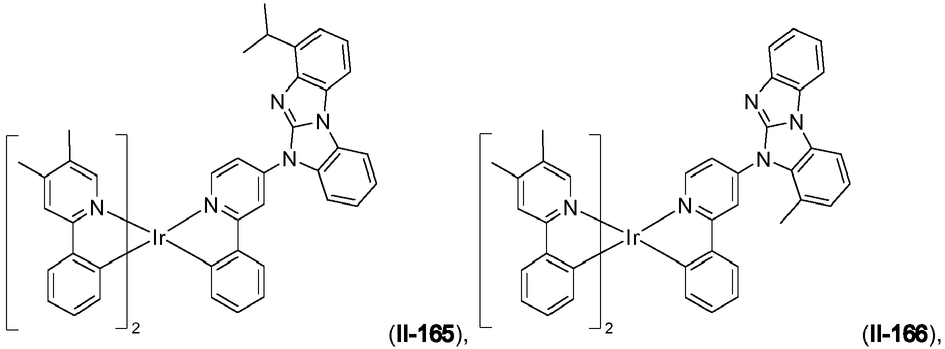 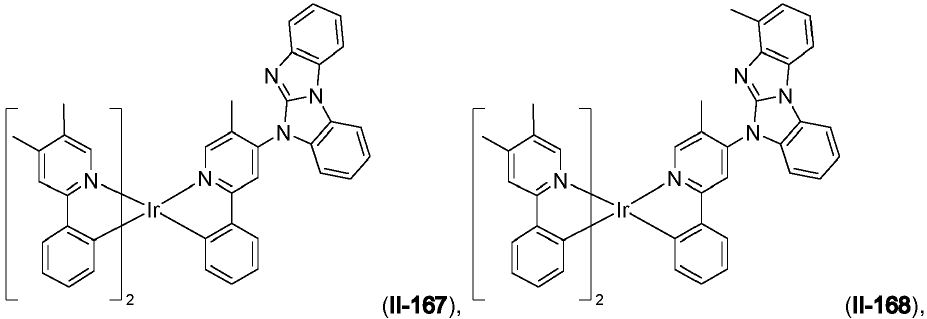 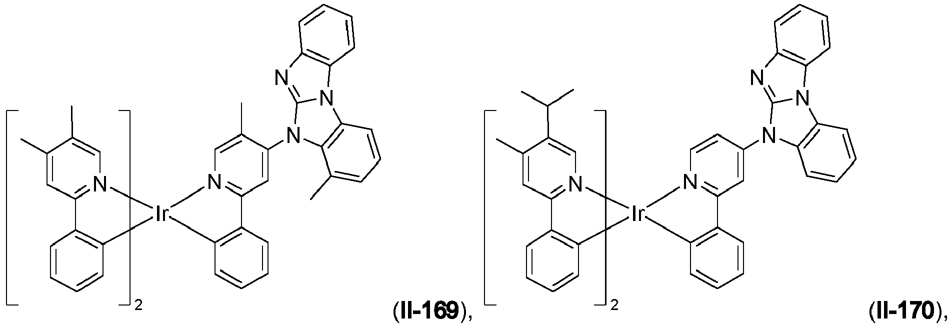 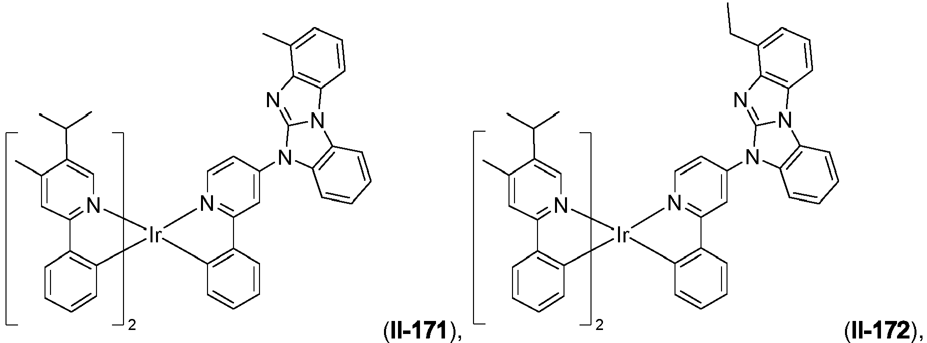 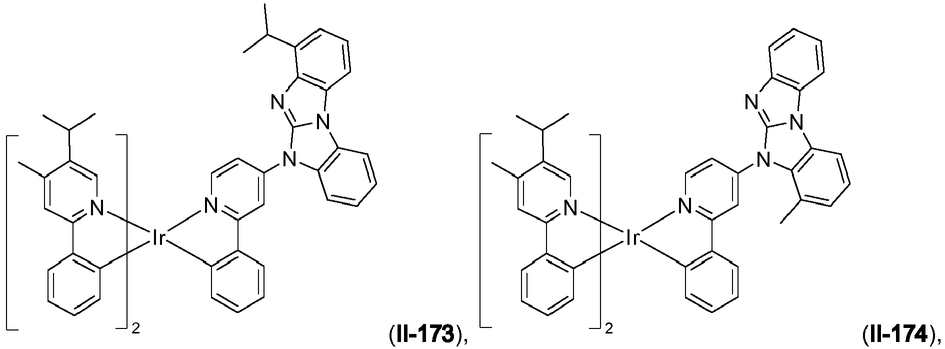 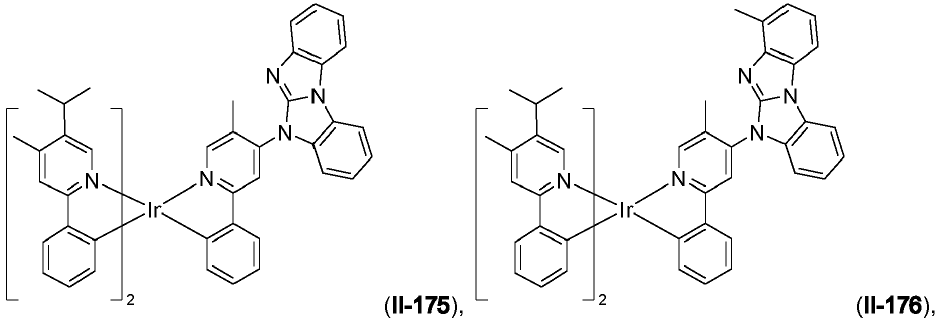 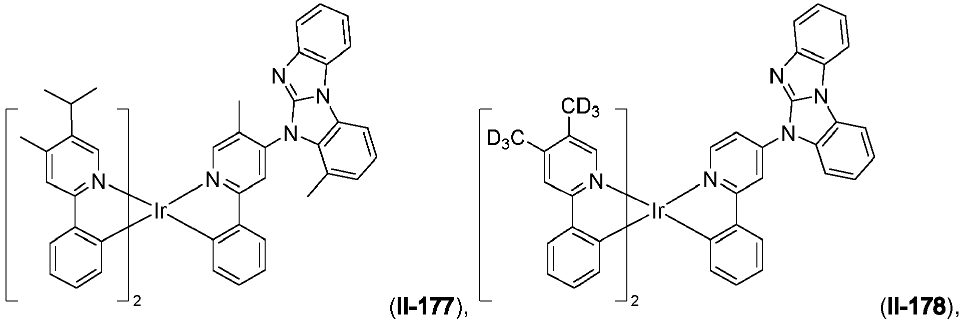 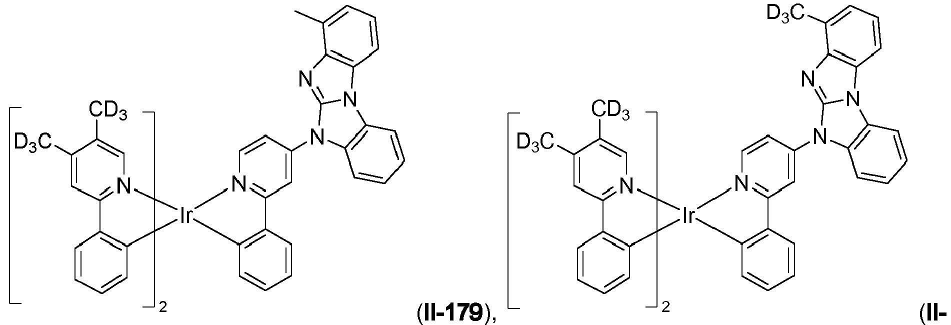 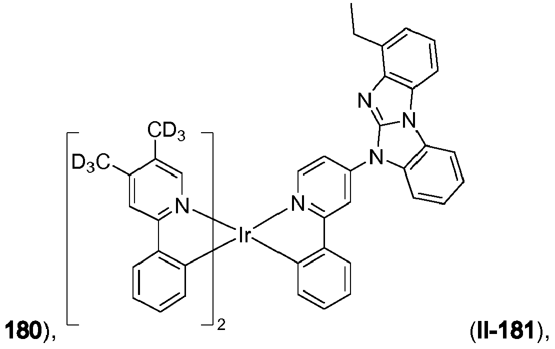 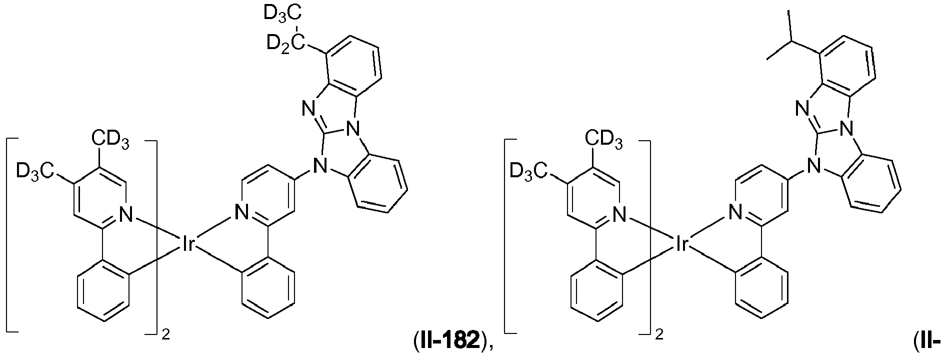 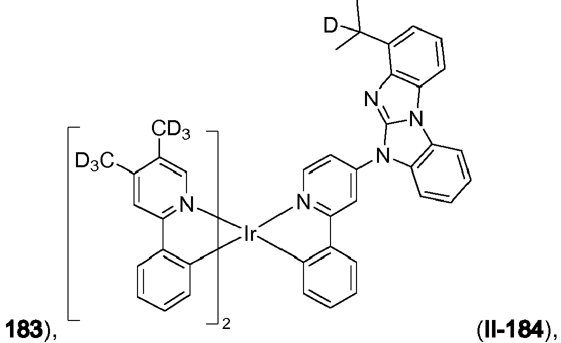 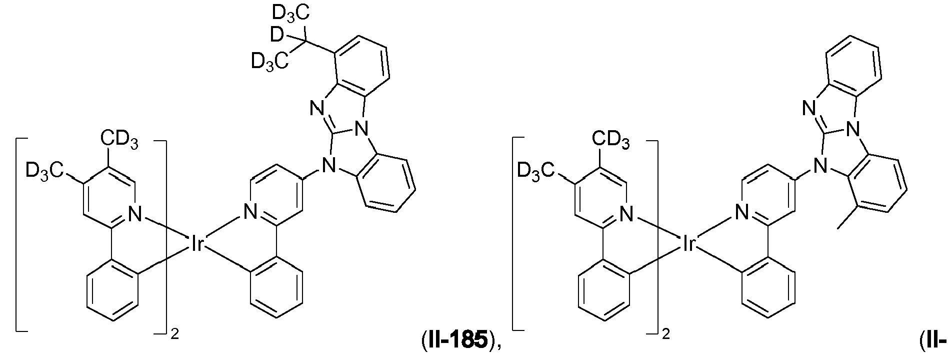 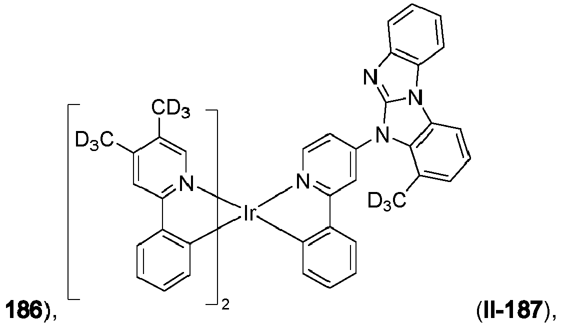 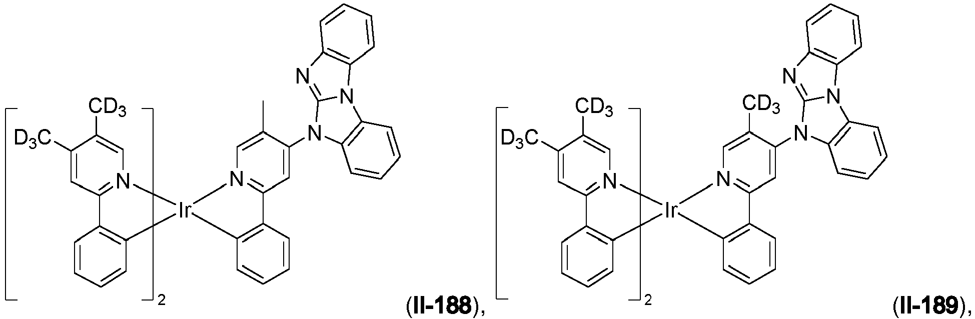 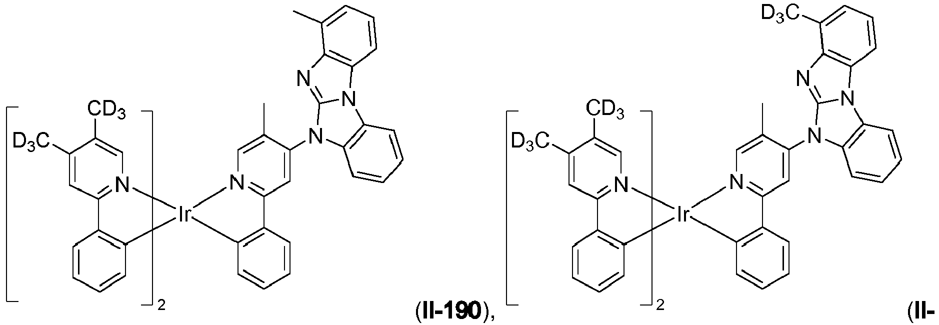 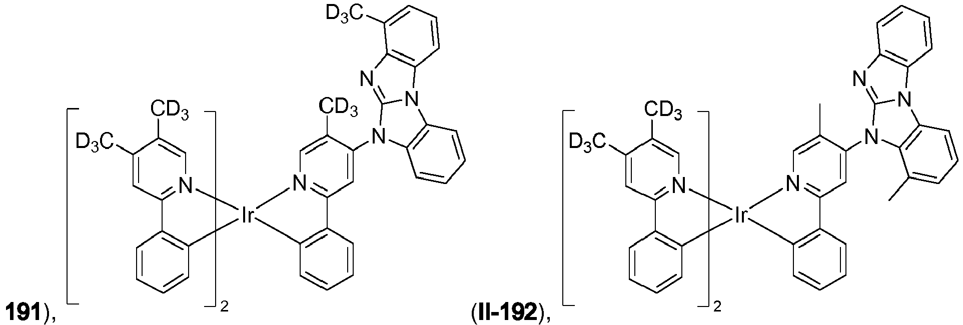 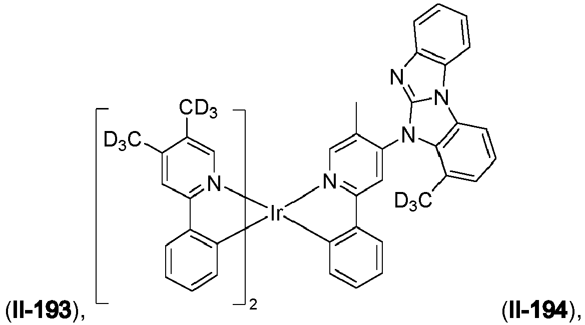 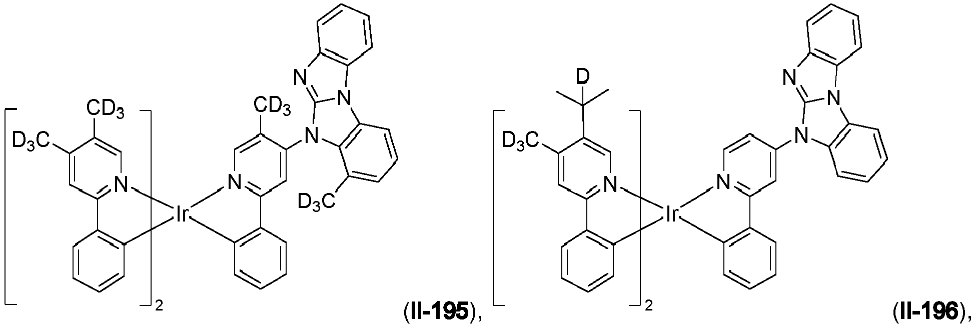 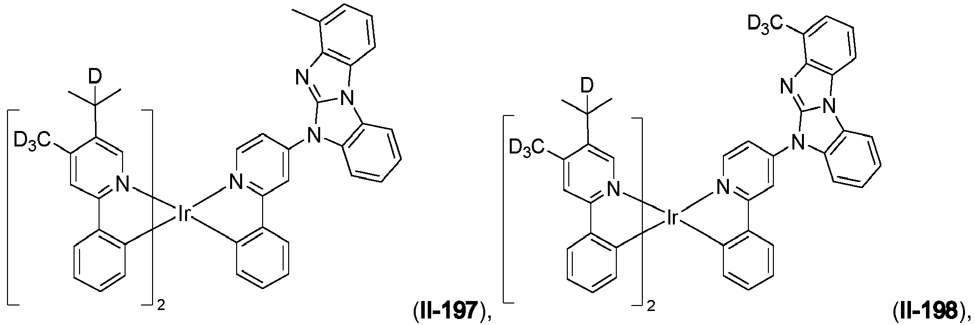 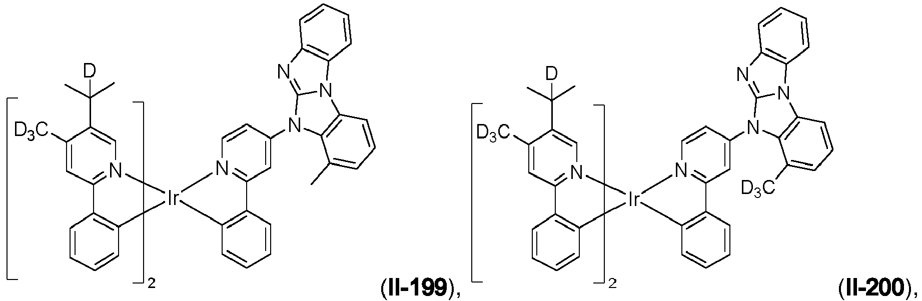 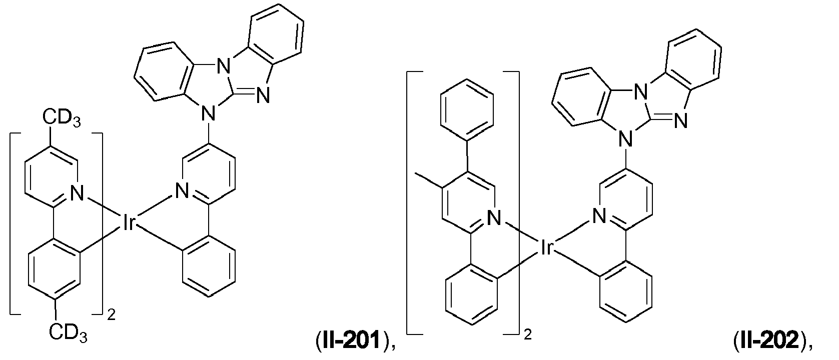 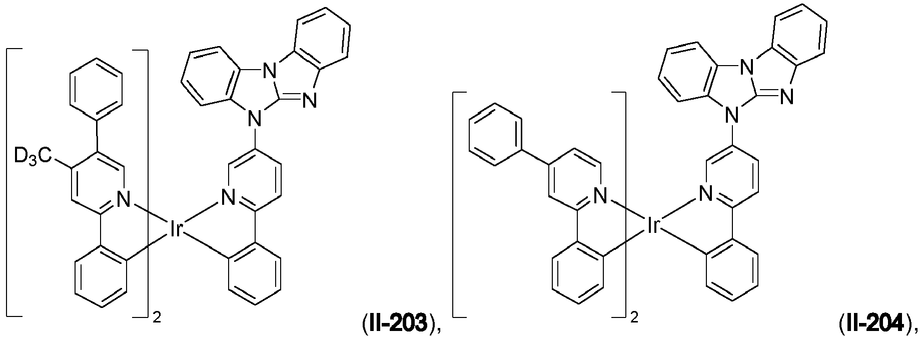 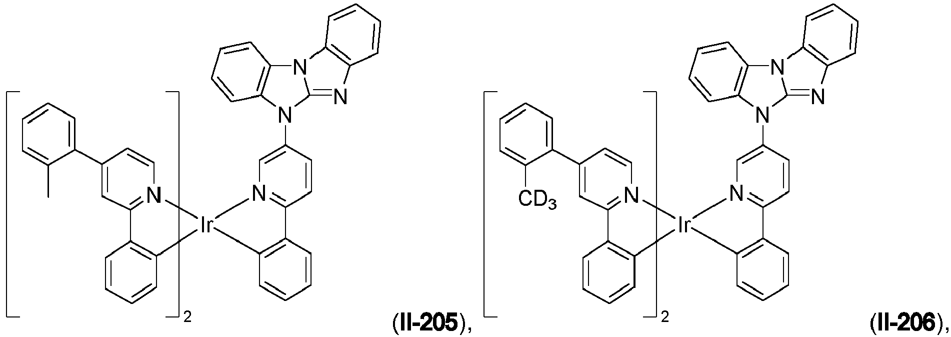 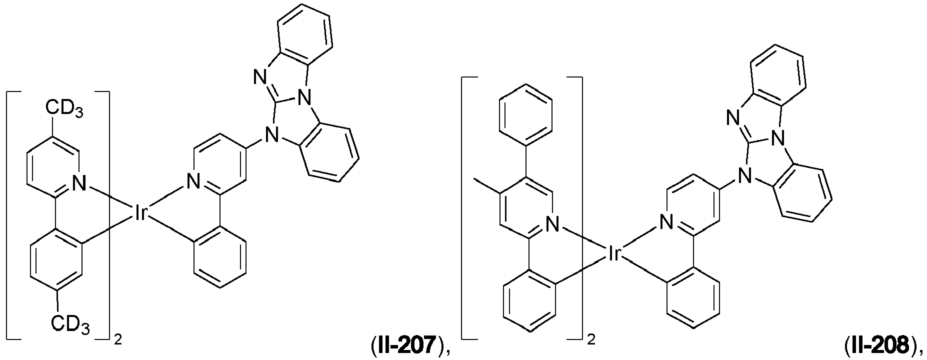 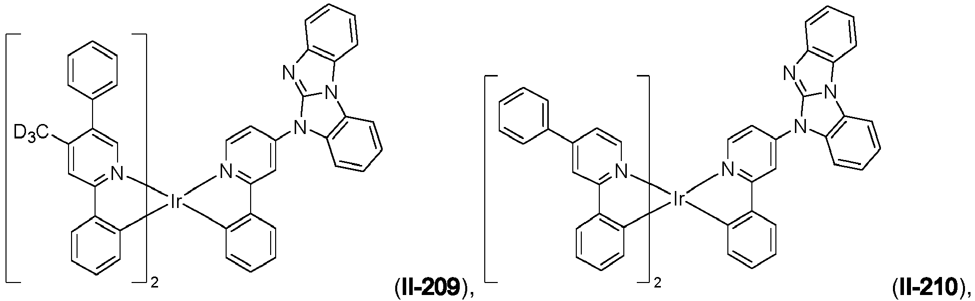 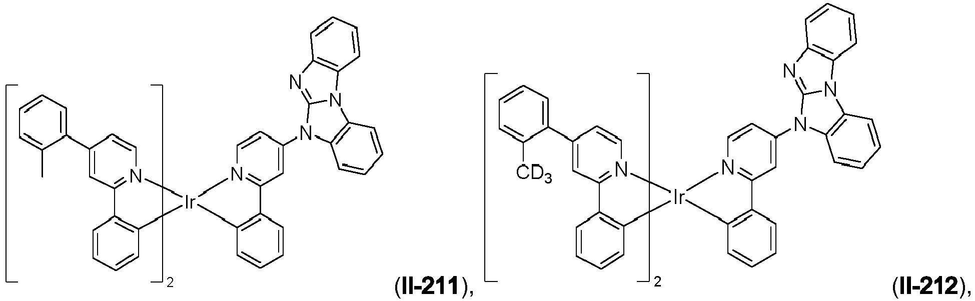 preferred metal complexes are the following complexes: (11-1), (11-11) to (II-17), (II-34), (II-40) to (II-42), (II-55), (II-61) to (II-63), (II-76), (II-80), (II-84), (II-88), (II-92), (II-96), (11-100), (II-104), (II-108), (II-118), (II-119), (II-126), (II-136), (II-137), (II-144), (II-154), (II-155), (II-162), (II-167), (II-170), (II-175), (II-178), (II-188), (II-189), (II-196), and (II-201) to (II-212);
more preferred metal complexes are the following complexes: (11-1), (11-11) to (II-17), (II-34), (II-40) to (II-42), (II-55), (II-61) to (II-63), (II-76), (II-80), (II-84), (II-88), (II-92), (II-96), (11-100), (II-104), (II-108), (II-126), (II-144), (II-162), (II-170), (II-178), (II-196), and (II-201) to (II-212) ;
even more preferred metal complexes are the following complexes: (11-1), (II-34), (II-55), (II-76), (II-84), (II-92), (11-100), (II-108), (II-126), (II-144), (II-162), (II-170), (II-178), (II-196), and (II-201) to (II-212);
even more preferred metal complexes are the following complexes: (11-1), (II-34), (II-55), (II-76), (II-84), (II-92), (11-100), (II-108), (II-126), (II-144), (II-162), (II-170), (II-178), (II-196), (II-201), and (II-207);

### Compounds of formulae (IA*), (IB*) and (IC*)

The present invention further relates to compounds of formulae (IA*), (IB*) and (IC*), preferably (IA*): 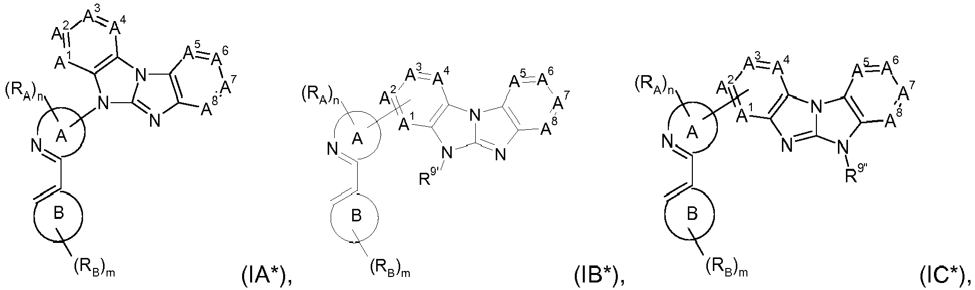 preferably of formula (IA*),
wherein
ring A is a heterocyclic group having 5 to 30 ring atoms, preferably a five or six membered heterocyclic ring, more preferably a five or six membered heteroaromatic ring,
ring B is an aromatic hydrocarbon group having 6 to 30 ring atoms, preferably an aromatic hydrocarbon group having 5 or 6 ring carbon atoms or a heterocyclic group having 5 to 30 ring atoms, preferably a heterocyclic group having 5 or 6 ring atoms, more preferably a heteroaromatic group having 6 ring atoms,
wherein A-B represents a bonded pair of hydrocarbon or heterocyclic rings coordinated to the metal via a nitrogen atom on ring A and via an sp² hybridized carbon atom on ring B,
R_{A} is hydrogen, deuterium, a substituted or unsubstituted alkyl group having 1 to 30 carbon atoms, a substituted or unsubstituted cycloalkyl group having 3 to 30 ring carbon atoms, a substituted or unsubstituted aromatic hydrocarbon group having 6 to 30 carbon atoms, a substituted or unsubstituted heterocyclic group having 5 to 30 ring atoms,
n is 0, 1 or 2, preferably 0 or 1,
R_{B} is hydrogen, deuterium, a substituted or unsubstituted alkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, a substituted or unsubstituted heterocyclic group having 5 to 30 ring atoms,
and one of R_{B} may be -SR^{a'}, -OR^{a'} or -NR^{a'}R^{b'},
one of R_{A} and one of R_{B} may be connected to each other and form a bridge, for example an alkane-diyl bridge, an alkene-diyl bridge, an arylene-bridge or a heteroarylene bridge,
R^{a'}, R^{b'} are each independently a substituted or unsubstituted aromatic hydrocarbon group having 6 to 30 ring carbon atoms, a substituted or unsubstituted heterocyclic group having 5 to 30 ring atoms,
m is 0, 1, 2 or 3, preferably 0, 1 or 2,
in the case that m is ≥ 2, two adjacent residues R_{B} may form together a ring, preferably a five or six membered ring, which is unsubstituted or substituted and may be fused with one or more, preferably one, further unsubstituted or substituted carbocyclic or heterocyclic five or six membered ring,
A¹ is CR¹ or N, A² is CR² or N, A³ is CR³ or N, A⁴ is CR⁵ or N, A⁵ is CR⁵ or N, A⁶ is CR⁶ or N, A⁷ is CR⁷ or N and A⁸ is CR⁸ or N, whereby preferably 0, 1 or 2, more preferably 0 or 1, most preferably 0 of A¹ to A⁸ are N,
wherein - in formula (IB) and (IC) one of A¹, A², A³ and A⁴ is CR¹, CR², CR³ respectively CR⁴, wherein R¹, R², R³ respectively R⁴ is a bonding site to the ring A,
R¹, R², R³, R⁴, R⁵, R⁶, R⁷ and R⁸ are each independently hydrogen, deuterium, a substituted or unsubstituted alkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted heterocyclic group, having 5 to 30 ring atoms, provided that, two substituents selected from R¹, R², R³, R⁴ respectively from R⁵, R⁶, R⁷ and R⁸ may be bonded to each other to form a ring structure,
R^{9'}, R^{9"} are each independently a substituted or unsubstituted aromatic hydrocarbon group having 6 to 30 ring carbon atoms, or a substituted or unsubstituted heterocyclic group having 5 to 30 ring atoms.

Preferred residues, symbols and indices mentioned in formulae (IA*), (IB*) and (IC*) are the same as mentioned in (IA), (IB) and (IC), mentioned above.

Said compounds are suitable for the preparation of the inventive metal complexes comprising at least one ligand of formulae (IA), (IB) and (IC).

### Preparation of the inventive metal complexes

The inventive metal complexes, wherein the metal is selected from Ir and Pt, comprising at least one ligand of formula (IA), (IB) or (IC) 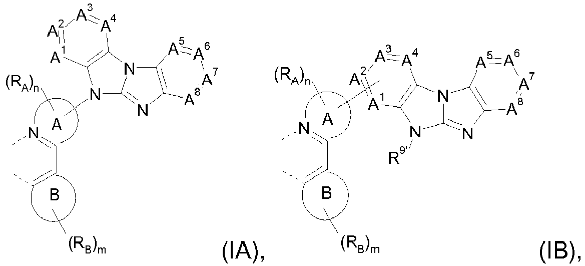 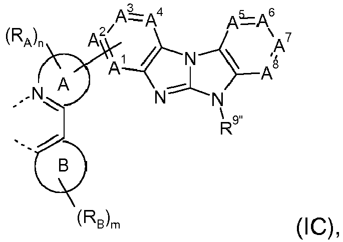 preferably of formula (IA),
are in general prepared by contacting suitable compounds comprising Ir or Pt with the appropriate ligands or ligand precursors. The residues, symbols and indices are defined before.

In the case that L in the inventive metal complexes of formulae (IIA), (IIB) or (IIC) 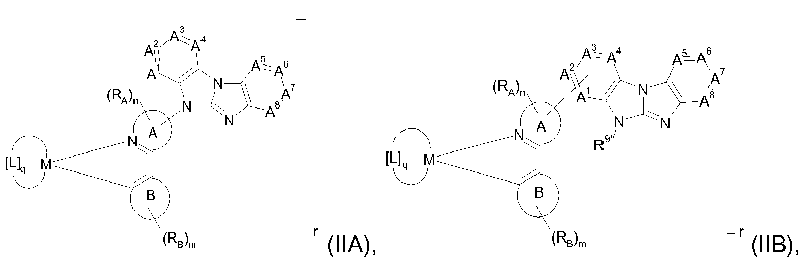 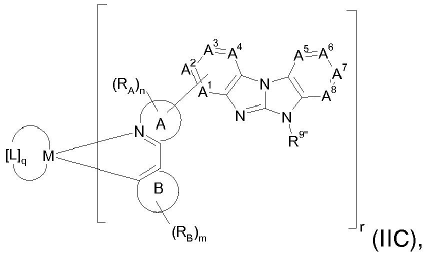 preferably (IIA),
is a ligand of formula (IV-1), M is Ir, q is 2 and r is 1, the inventive metal complexes are prepared as follows (shown for the metal complex of formula IIA): 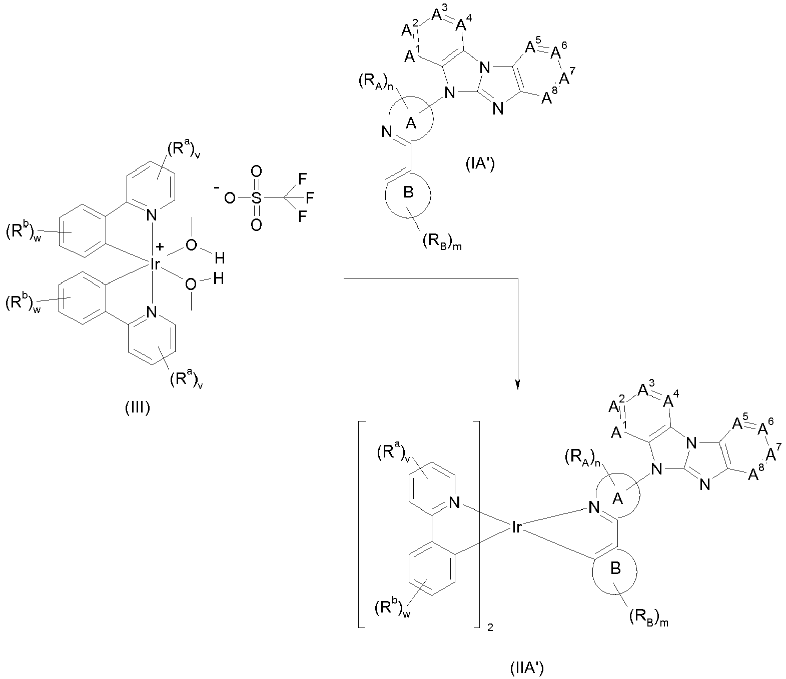 wherein the residues, symbols and indices are defined before.

It is known by a person skilled in the art that the other inventive metal complexes according to the present invention are prepared analogously.

The process shown above is usually carried out in a solvent. Suitable solvents are organic solvents like (polar) aprotic solvents, for example tertiary carboxylic acid amides like dimethyl formamide (DMF), dimethyl acetamide (DMA), N-methyl-2-pyrrolidone (NMP), dimethyl sulfoxide (DMSO), 1,3-dimethyl imidazolidone (DMI), or alcohols, for example ethoxyethanol, ethanol, methanol, 1-propanol, 2-propanol, tert-butanol, or mixtures thereof. The mixtures of solvents can also include chlorinated solvents like dichloromethane (DCM), 1,2-dichloroethane, chlorobenzene, or 1,2-dichlorobenzene. Preferably ethanol or mixtures of DMF and 2-ethoxyethanol are used, more preferably mixtures of DMF and 2-ethoxyethanol.

The complexes of formula (IIA') are prepared generally at a temperature of 40 to 200°C, preferably 50 to 180°C, more preferably 70 to 150°C.

The reaction time is generally 4 to 48 hours, preferably 8 to 30 hours, more preferably 16 to 24 hours.

After the reaction is finished, the desired product can be isolated and purified by customary processes known to those skilled in the art, for example filtration, precipitation, trituration, soxhlet extraction, recrystallization, column chromatography, etc.

The molar ratio of compound (III) to compound (IA') is generally 1 : 2 to 1 : 4, preferably 1 : 2.5 to 1 : 3.5.

The ligand precursor of formula (IA') is for example prepared by the following process:

### Route A

### Step (i)

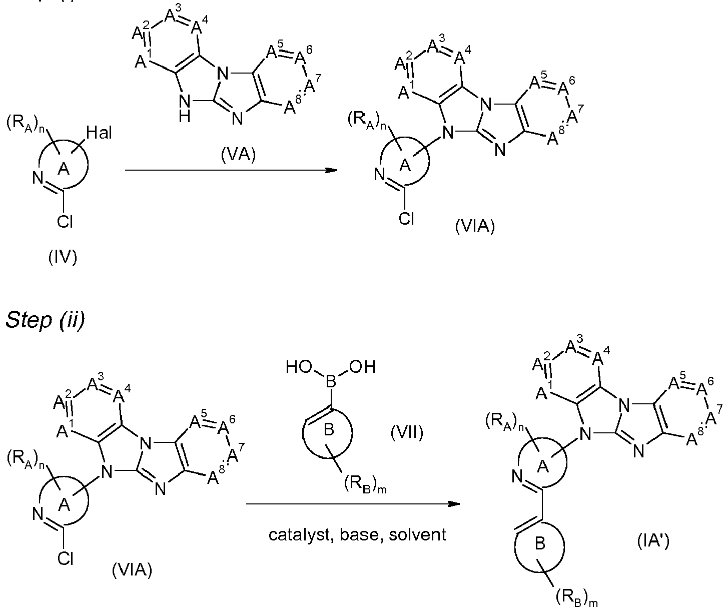

### Route B

### Step (i)

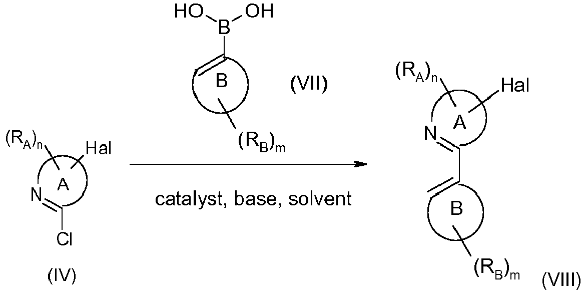

### Step (ii)

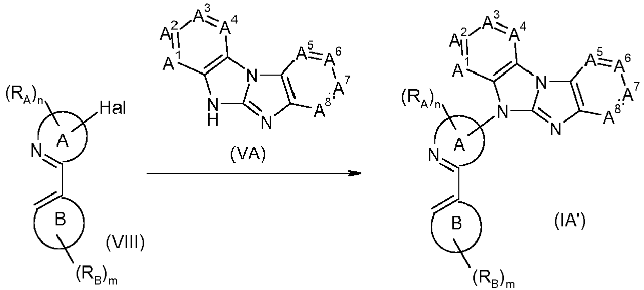

### Route C

### Step (i)

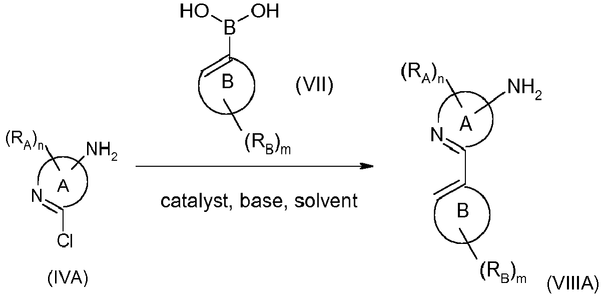

### Step (ii)

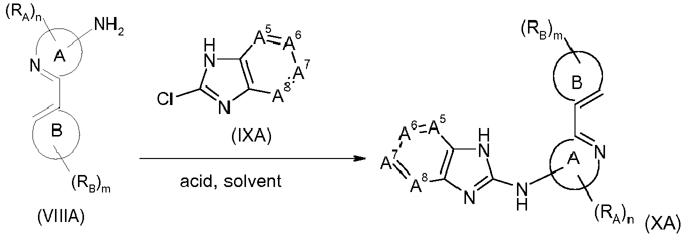

### Step (iii)

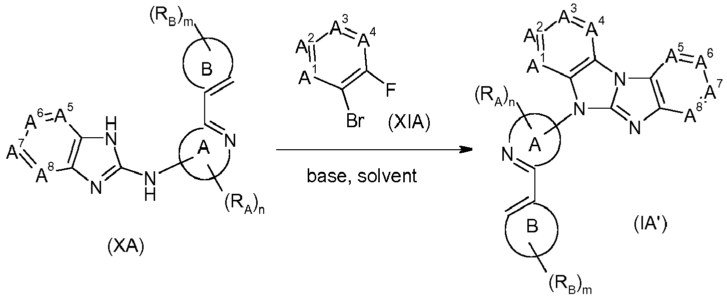

The residues, symbols and indices shown in routes A, B and C are defined before.

It is known by a person skilled in the art that the other inventive ligands according to the present invention are prepared analogously.

### Route A:

### Step (i)

The N-arylation reaction is generally carried out by reacting compound (VA) with compound (IV), wherein Hal is F, Cl, Br or I, preferably F, Br or I, more preferably F or I.

The nucleophilic aromatic substitution (N-arylation) of compound (VA) with compound (IV), wherein Hal is F, is generally performed in the presence of a base (reaction conditions are, for example, described in Angew. Chem. 2012, 124, 8136-8140, Angew. Chem. Int. Ed. 2008, 47, 8104-8107. Suitable bases are known to those skilled in the art and are preferably selected from the group consisting of alkali metal and alkaline earth metal hydroxides such as NaOH, KOH, Ca(OH)₂, alkali metal hydrides such as NaH, KH, alkali metal amides such as NaNH₂, alkali metal or alkaline earth metal carbonates such as K₂CO₃ or Cs₂CO₃, alkaline metal phosphates such as K₃PO₄, alkaline metal fluorides such as KF, CsF, and alkali metal alkoxides such as NaOMe, NaOEt. In addition, mixtures of the aforementioned bases are suitable. K₂CO₃, Cs₂CO₃, or K₃PO₄ are preferred.

The nucleophilic aromatic substitution (N-arylation) can be performed in solvent or in a melt. Preferably, the reaction is carried out in a solvent. Suitable solvents are, for example, (polar) aprotic solvents such as dimethyl sulfoxide (DMSO), dimethylformamide (DMF), N-methyl-2-pyrrolidone (NMP) or dimethylacetamide (DMA).

The reaction temperature is strongly dependent on the reactivity of the aryl fluoride. The reaction (N-arylation) is preferably carried out at a temperature of -10 to 220°C, more preferably 60 to 180°C, even more preferably at 100°C to 160°C.

Ullmann reaction (N-arylation) of compound (VA) with compound (IV), wherein Hal is Cl, Br, or I, preferably Br or I, more preferably I, is generally carried out in the presence of a base and a catalyst.

Reaction conditions for Ullmann reactions are, for example, described in J. Am. Chem. Soc. 2001, 123, 7727-7729, J. Am. Chem. Soc. 2002, 124, 11684-11688, Synlett 2004, No. 1, 128-130, J. Org. Chem. 2005, 70, 5164-5173, Angew Chem Int. Ed. Engl. 2009, 48, 6954-6971, J. Am. Chem. Soc. 2009, 131, 2251 Angew. Chem. Int. Ed. 2012, 51, 10364-10367.

Typically the Ullmann coupling of compound (VA) with compound (IV), wherein Hal is Br or I, especially I, is done in the presence of copper, or a copper salt, such as, for example, Cul, CuBr, Cu₂O, or CuO, and a ligand, such as, for example, L-proline, trans-cyclohexane-1,2-diamine (DACH), 1,10-phenanthroline, or 8-hydroxyquinoline in a solvent, such as, for example, dimethylsulfoxide (DMSO), dimethylformamide (DMF), dimethylacetamide (DMA), N-methylpyrrolidone (NMP) and dioxane, or a solvent mixture. The reaction temperature is dependent on the reactivity of the starting materials, but is generally in the range of 25 to 200°C. If copper salts are used without a ligand the reaction temperatures are higher.

### Step (ii)

Preferably, the Suzuki reaction of compound (VIA) with compound (VII) is carried out in the presence of
a) a catalyst/ligand system comprising a palladium catalyst and an organic phosphine or phosphonium compound,
b) a base,
c) a solvent or a mixture of solvents.
See for example in Chem. Rev. 1995, 95, 2457-2483; "Suzuki in Modern Arene Chemistry" (Ed.: D. Astruc), Wiley-VCH, Weinheim, 2002, 53-106, Chem. Rev. 2002, 102, 5; "Modern Arylation Methods" (Ed.: L. Ackermann), Wiley-VCH, Weinheim, 2009.

Generally, a usual catalyst for coupling reactions or for polycondensation reactions is used, preferably Pd-based. Preference is given, for example, to the use of tetrakis(triphenyl-phospine)palladium(0), [1,1'-bis(diphenylphosphino)ferrocene]-dichloropalladium(II) complex with dichloromethane, or ligand-catalyst combinations like the combination of tri-t-butylphos-phoniumtetrafluoroborat with tris(dibenzylideneacetone)dipalladium(0) or palladium(II) acetate, or combination of dicyclohexyl-[2-(2,6-dimethoxyphenyl)phenyl]phosphane with tris(dibenzylideneacetone)dipalladium(0) or palladium(II) acetate. More preferably tetrakis(triphenylphospine)palladium(0) is used.

The palladium compound is usually added in a ratio of from 1:10000 to 1:10, preferably from 1:1000 to 1:20, more preferably 1:1000 to 1:50. For the combinations of ligand and palladium catalyst the ligand is usually added in a ratio of from 1:1 to 1:10, based on the palladium compound.

Usually, the amount of the solvent is chosen in the range of from 1 to 10 l per mol of boronic acid derivative.

The reaction is generally carried out under an inert atmosphere such as nitrogen, or argon.

Further, it is preferred to carry out the reaction in the presence of an aqueous base, such as an alkali metal hydroxide, metal phosphate, or carbonate such as NaOH, KOH, K₃PO₄, Na₂CO₃, K₂CO₃, or Cs₂CO₃. Preferably Na₂CO₃ is used.

Usually, the molar ratio of the base to boronic acid (or boronic ester derivative) is chosen in the range of from 0.5:1 to 50:1, very especially in the range of 1:1 to 5:1.

The organic solvent is usually an aromatic hydrocarbon, a linear, branched, or cyclic ether, or a usual polar organic solvent, such as benzene, toluene, xylene, tetrahydrofuran, or dioxane, or mixtures thereof. If desired, water can be added to the organic reaction medium, in which case, depending on the organic solvent used, the reaction can be carried out in a single phase or in a two-phase mixture. Preferably a mixture of 1,2-dimethoxyethane and water is used.

Generally, the reaction temperature is chosen in the range of from 40 to 180°C, preferably at 40 to 140°C, more preferably under reflux conditions.

Generally, the reaction time is chosen in the range of from 0.5 to 80 hours, preferably from 2 hours to 60 hours, more preferably from 2 to 20 hours.

### Route B:

### Step (i)

The Suzuki reaction of compound (VII) with compound (IV), wherein Hal is preferably Cl or F, more preferably F, is generally carried out in the same way as described in Route A, Step (ii).

### Step (ii)

The N-arylation reaction of compound (VA) with compound (VIII) is generally carried out in the same way as described in Route A, Step (i).

### Route C:

### Step (i)

The Suzuki reaction of compound (VII) with compound (IVA) is generally conducted as described in Route A, Step (ii), preferably as described in Eur. J. Org. Chem. 2012, 6248-6259.

### Step (ii)

Reaction of compound (IXA) with compound (VIIIA) is generally carried in the presence of a strong organic acid such as, for example, trifluoromethanesulfonic acid, methanesulfonic acid, p-toluensulfonic acid, preferably methanesulfonic acid (see for example WO2017093958A1).

The reaction is generally carried out in a solvent or in melt, preferably in a solvent. Suitable solvents are organic solvents like (polar) aprotic solvents, for example tertiary carboxylic acid amides like dimethyl formamide (DMF), dimethyl acetamide (DMA), N-methyl-2-pyrrolidone (NMP), dimethyl sulfoxide (DMSO) and/or 1,3-dimethyl imidazolidone (DMI).

The reaction temperature is strongly dependent on the reactivity of compound (IXA) and of compound (VIIIA). The reaction is preferably carried out at a temperature of 20 to 220°C, more preferably 60 to 180°C.

The reaction time is generally 4 to 48 hours, preferably 8 to 30 hours, more preferably 16 to 24 hours.

### Step (iii)

The addition-cyclization reaction of compound (XIA) with compound (XA) is generally carried out in the presence of a base. Suitable bases are known to those skilled in the art and are preferably selected from the group consisting of alkali metal and alkaline earth metal hydroxides such as NaOH, KOH, Ca(OH)₂, alkali metal hydrides such as NaH, KH, alkali metal amides such as NaNH₂, alkali metal or alkaline earth metal carbonates such as K₂CO₃ or Cs₂CO₃, alkaline metal phosphates such as K₃PO₄, alkaline metal fluorides such as KF, CsF, and alkali metal alkoxides such as NaOMe, NaOEt. In addition, mixtures of the aforementioned bases are suitable. K₂CO₃, Cs₂CO₃, or K₃PO₄ are preferred.

The addition-cyclization reaction is typically carried out in a solvent. Suitable solvents are, for example, (polar) aprotic solvents such as dimethyl sulfoxide (DMSO), dimethylformamide (DMF), N-methyl-2-pyrrolidone (NMP) or dimethylacetamide (DMA).

The reaction temperature is strongly dependent on the reactivity of the aryl fluoride. The reaction (N-arylation) is preferably carried out at a temperature of -10 to 220°C, more preferably 60 to 180°C, even more preferably at 100°C to 160°C.

The reaction time is generally 4 to 48 hours, preferably 8 to 36 hours.

Exemplary examples for the preparation of the inventive metal complexes are shown in the experimental part of the present application.

### Organic electronic devices

It has been found that the inventive metal complexes of formulae (IA), (IB) and (IC), preferably of formula (IA) (in the following: "inventive metal complexes" or "inventive metal complex") are particularly suitable for use in applications in which charge carrier conductivity is required, especially for use in organic electronics applications, for example selected from switching elements such as organic transistors, e.g. organic FETs and organic TFTs, organic solar cells, light-emitting electrochemical cells (LEECs) and organic light-emitting diodes (OLEDs), preference being given to OLEDs.
The term organic EL device (organic electroluminescence device) is used interchangeable with the term organic light-emitting diode (OLED) in the following; i.e. both terms have the same meaning in the sense of the present application.
The present invention further relates to a material for an organic EL device comprising at least one inventive metal complex.

The organic transistor generally includes a semiconductor layer formed from an organic layer with charge transport capacity; a gate electrode formed from a conductive layer; and an insulating layer introduced between the semiconductor layer and the conductive layer. A source electrode and a drain electrode are mounted on this arrangement in order thus to produce the transistor element. In addition, further layers known to those skilled in the art may be present in the organic transistor. The layers with charge transport capacity may comprise the inventive metal complex.

The organic solar cell (photoelectric conversion element) generally comprises an organic layer present between two plate-type electrodes arranged in parallel. The organic layer may be configured on a comb-type electrode. There is no particular restriction regarding the site of the organic layer and there is no particular restriction regarding the material of the electrodes. When, however, plate-type electrodes arranged in parallel are used, at least one electrode is preferably formed from a transparent electrode, for example an ITO electrode or a fluorine-doped tin oxide electrode. The organic layer is formed from two sublayers, i.e. a layer with p-type semiconductor properties or hole transport capacity, and a layer formed with n-type semiconductor properties or charge transport capacity. In addition, it is possible for further layers known to those skilled in the art to be present in the organic solar cell. The layers with charge transport capacity may comprise the inventive metal complex.

The inventive metal complexes are generally notable for improved device performance such as high external quantum efficiency and/or or long device lifetime. The inventive metal complexes are therefore suitable with particular preference as emitter material in OLEDs.

The present invention therefore concerns an organic electronic device, comprising at least one inventive metal complex.

In a preferred embodiment, the organic electronic device is an OLED. The present application therefore further provides an OLED comprising at least one inventive metal complex. The inventive metal complex is used in the OLED preferably as an emitter material.

The present application therefore also provides for a light-emitting layer comprising at least one inventive metal complex, preferably as emitter material. More preferably, the light-emitting layer additionally comprises at least one host material. (In the sense of the present application, the terms matrix and host are used interchangeable).

### Organic EL device (OLED)

The organic EL device as one embodiment of the invention comprises one or more organic thin film layers including an emitting layer between a cathode and an anode, and at least one layer of the organic thin film layers comprises the inventive metal complex.
As examples of the organic thin film layers, an anode-side organic thin film layer (hole-transporting layer, hole-injecting layer, or the like), an emitting layer, a cathode-side organic thin film layer (electron-transporting layer, electron-injecting layer, or the like) provided between a cathode and an emitting layer, a spacing layer, a barrier layer or the like can be given. The examples are not limited thereto.
The inventive metal complex may be contained in any of the abovementioned layers, it is preferably contained in the emitting layer, more preferably as an emitter material.

The organic EL device of the invention may be a simple emitting device having a single emitting unit or a tandem emitting device having plural emitting units. Among them, the organic EL device may preferably be a phosphorescent emitting device.
As the representative device structure of a simple type organic EL device, the following device configuration can be given.

### (1) Anode/emitting unit/cathode

The emitting unit mentioned above may be a stacked type emitting unit comprising plural phosphorescent emitting layers or plural fluorescent emitting layers. In this case, in order to prevent diffusion of excitons generated in the phosphorescent emitting layer to the fluorescent emitting layer, a spacing layer may be provided between the emitting layers. The representative layer configuration of the emitting unit is given below.
(a) Hole-transporting layer/Emitting layer (/Electron-transporting layer)
(b) Hole-transporting layer/First phosphorescent emitting layer/Second phosphorescent emitting layer (/Electron-transporting layer)
(c) Hole-transporting layer/Phosphorescent emitting layer/Spacing layer/Fluorescent emitting layer (/Electron-transporting layer)
(d) Hole-transporting layer/First phosphorescent emitting layer/Second phosphorescent emitting layer/Spacing layer/Fluorescent emitting layer (/Electron-transporting layer)
(e) Hole-transporting layer/First phosphorescent emitting layer/Spacing layer/Second phosphorescent emitting layer/Spacing layer/Fluorescent emitting layer (/Electron-transporting layer)
(f) Hole-transporting layer/Phosphorescent emitting layer/Spacing layer/First fluorescent emitting layer/Second fluorescent emitting layer (/Electron-transporting layer)
(g) Hole-transporting layer/Electron barrier layer/Emitting layer (/Electron-transporting layer)
(h) Hole-transporting layer/Emitting layer/Hole barrier layer (/Electron-transporting layer)
(i) Hole-transporting layer/Fluorescent emitting layer/Triplet barrier layer (/Electron-transporting layer)
The emitting layer as mentioned above can emit different colors of light. In the layer configurations mentioned above, each emitting layer - in the case of the presence of more than one emitting layer - emits a different color of light. The inventive metal complex is preferably present in the layer configurations mentioned above as green to yellow, preferably green to yellow green phosphorescent emitter.
In the case of more than one emitting layer, between each emitting layer and the hole-transporting layer or the spacing layer, an electron barrier layer may be provided appropriately. Between each emitting layer and the electron transporting layer, a hole-barrier layer (a hole blocking layer) may be provided appropriately. Due to provision of an electron-barrier layer or a hole-barrier layer, electrons or holes can be confined within the emitting layer, whereby possibility of recombination of carriers in the emitting layer can be increased, and the life can be improved.
As the represented device configuration of a tandem organic EL device, the following device configuration can be given.

### (2) Anode/first emitting unit/intermediate layer/second emitting unit/cathode

In general, the intermediate layer is called an intermediate electrode, an intermediate conductive layer, a carrier-generating layer, an electron-withdrawing layer, and a known material configuration that supplies electrons to the first emitting unit and supplies holes to the second emitting unit can be used.

**FIG. 1** shows a schematic configuration of one example of the organic EL device of the invention. The organic EL device 1 comprises a substrate 2, an anode 3, a cathode 4 and an emitting unit 10 provided between the anode 3 and the cathode 4. The emitting unit 10 comprises an emitting layer 5 preferably comprising a host material and a dopant. A hole injecting and transporting layer 6 or the like may be provided between the emitting layer 5 and the anode 3 and an electron-injecting layer 8 and an electron transporting layer 7 or the like (electron injecting and transporting unit 11) may be provided between the emitting layer 5 and the cathode 4. An electron-barrier layer may be provided on the anode 3 side of the emitting layer 5 and a hole-barrier layer may be provided on the cathode 4 side of the emitting layer 5.

Due to such configuration, electrons or holes can be confined in the emitting layer 5, whereby possibility of generation of excitons in the emitting layer 5 can be improved.

The inventive metal complexes are preferably used as emitter molecules and/or host materials in the emitting layer, more preferably as emitter molecules. The inventive metal complexes may - in addition to use as emitter molecules and/or host materials in the emitting layer or instead of use in the emitting layer - also be used as a charge transport material in the hole-transporting.

In the organic electronic devices according to the present invention, a host that is combined with a fluorescent dopant is referred to as a fluorescent host and a host that is combined with a phosphorescent dopant is referred to as a phosphorescent host. The fluorescent host and the phosphorescent host are not distinguished only by the molecular structure thereof. That is, the phosphorescent host means a material constituting a phosphorescent emitting layer that contains a phosphorescent dopant and does not mean a material that cannot be used as a material constituting a fluorescent dopant. The same can be applied to a fluorescent host. Since the inventive metal complexes are preferably employed as phosphorescent emitters (dopants), preferred hosts for the inventive metal complexes are phosphorescent hosts, more preferably the phosphorescent hosts mentioned below.

### Substrate

The organic EL device is usually formed on a transparent substrate. The transparent substrate is a substrate for supporting the organic EL device, and is preferably a flat and smooth substrate having a 400-to-700-nm-visible-light transmittance of 50% or more. Specific examples thereof include glass plates and polymer plates. Examples of the glass plate include those obtained by using as raw materials soda-lime glass, barium/strontium-containing glass, lead glass, aluminosilicate glass, borosilicate glass, barium borosilicate glass, quartz, or the like. Examples of the polymer plate include those obtained by using as raw materials polycarbonate, acrylic polymer, polyethylene terephthalate, polyethersulfide, polysulfone, or the like.

### Anode

The anode of the organic EL device plays a role for injecting holes into its hole-transporting layer or emitting layer. It is effective to use one having a work function of 4.5 eV or more. As specific examples of the anode material, indium tin oxide alloy (ITO), tin oxide (NESA), indium zinc oxide, gold, silver, platinum, copper, and the like can be given. The anode can be formed by forming these electrode materials into a thin film by vapor deposition, sputtering or the like. In the case where emission from the emitting layer is taken out through the anode, the transmittance of the anode to the emission is preferably more than 10%. The sheet resistance of the anode is preferably several hundred Ω/□ or less. The film thickness of the anode, which varies depending upon the material thereof, is usually from 10 nm to 1 µm, preferably from 10 to 200 nm.

### Cathode

The cathode plays a role for injecting electrons into its electron-injecting layer, electron-transporting layer or emitting layer. The cathode is preferably formed of a material having a small work function. The cathode material is not particularly restricted. As specific examples of the cathode material, indium, aluminum, magnesium, a magnesium-indium alloy, a magnesium-aluminum alloy, an aluminum-lithium alloy, an aluminum-scandium-lithium alloy, a magnesium-silver alloy or the like can be given. As in the case of the anode, the cathode can be formed by forming the materials into a thin film by a deposition method, a sputtering method or the like. If necessary, emission can be outcoupled from the cathode side.

### Emitting layer

The present invention relates - in one preferred embodiment - to an organic electroluminescence device, wherein the light emitting layer comprises at least one inventive metal complex. The emitting layer is an organic layer having an emitting function, and where a doping system is used, it usually comprises a host material and a dopant material.
The host material has a function of accelerating recombination of electrons and holes and confining excitons within the emitting layer. The dopant material has a function of emitting efficiently excitons obtained by recombination.
In the case of a phosphorescent device, the host material has a function of confining excitons mainly generated by a dopant within the emitting layer.
Here, in the emitting layer, a double host (also referred to as a host/cohost) that adjusts the carrier balance in the emitting layer may be used, for example by combining an electron-transporting host and a hole-transporting host or by other methods. The emitting layer therefore preferably comprises at least one host material. In one embodiment of the present invention, the emitting layer comprises a first host material and a second host material. In a further embodiment, the emitting layer comprises one host material.
Double dopant may be used in which two or more types of dopant materials having a high quantum yield are incorporated, and each dopant emits light. Specifically, by allowing a host, a red dopant and a green dopant can be co-deposited, whereby yellow emission is realized. At least one of the dopants is preferably an inventive metal complex.

As for the emitting layer, by allowing plural emitting layers to be a stacked body, electrons and holes are accumulated in the interface of the emitting layers, whereby the recombination region is concentrated in the interface of the emitting layers. As a result, the quantum efficiency is improved.
Easiness in injection of holes to the emitting layer and easiness in injection of electrons to the emitting layer may differ. Further, the hole-transporting performance and the electron transporting performance indicated by the mobility of holes and electrons in the emitting layer may differ from each other.
The emitting layer can be formed by a known method such as a deposition method, a spin coating method, a LB method (Langmuir Blodgett method) or the like, for example. The emitting layer can also be formed by forming a solution obtained by dissolving a binder such as a resin and material compounds in a solvent into a thin film by a spin coating method and the like.
The emitting layer is preferably a molecular deposited film. The "molecular deposited film" means a thin film formed by deposition of a raw material compound in a vapor phase or a film formed by solidification of a raw material compound in a solution state or a liquid phase state. Normally, this molecular deposited film differs from a thin film (molecular accumulated film) formed by a LB method in aggregation structure or high-order structure, or differ in function derived from such difference in structure.

In a more preferred embodiment, the light-emitting layer is formed from 0.1 to 70% by weight, preferably 1 to 30% by weight, of at least one of the emitter materials and 30 to 99.9% by weight, preferably 70 to 99% by weight, of at least one of the matrix materials mentioned in the specification - preferably at least one inventive metal complex, more preferably as emitter material - where the sum total of the emitter material and of the matrix material adds up to 100% by weight.

For efficient light emission the triplet energy of the host material has to be about 0.2 eV larger than the triplet energy of the emitter (preferably the inventive metal complex) used. Hence, all host materials fulfilling this requirement are, in principle, suitable as host compound.

### (1) Phosphorescent emitting layer

The phosphorescent emitting layer usually comprises at least one emitter material and at least one host material. The phosphorescent host is a compound which confines the triplet energy of the phosphorescent dopant efficiently in the light emitting layer to cause the phosphorescent dopant to emit light efficiently.
A host material for phosphorescent emitting layer is usually selected from known phosphorescent host materials. Specific examples of the preferable phosphorescent host are, nitrogen-containing heteroaromatics, such as, indole derivatives, carbazole derivatives, pyridine derivatives, pyrimidine derivatives, triazine derivatives, quinoline derivatives, isoquinoline derivatives, quinazoline derivatives, nitrogen-containing dibenzothiophene derivatives, nitrogen-containing dibenzofuran derivatives, imidazole derivatives, such as benzimidazole derivatives, imidazopyridine derivatives, Benzimidazophenanthridine derivatives, benzimidazobenzimidazole derivatives; oxygen or sulfur containing heteroaromatics, such as thiophene derivatives, furan derivatives, benzothiophene derivatives, benzofuran derivatives, dibenzothiophene derivatives, dibenzofuran derivatives; aryl or heteroaryl substituted amine derivatives; metal complexes; aromatic hydrocarbon derivatives, such as benzene derivatives naphthalene derivatives, phenanthrene derivatives, triphenylene derivatives, fluorene derivatives, and so on, preferably, nitrogen containing heteroaromatics.

As mentioned above, according to one embodiment, the light-emitting layer comprises at least one emitter material and at least two host materials, i.e. a first and a second host material. Host materials, suitable as single host material and also as first and second host materials are mentioned above and below.

Specific examples for host materials are selected from above mentioned derivatives, preferably, nitrogen containing heteroaromatics, more preferably, following general formula (N-1). The present invention therefore further relates to an organic electroluminescence device, wherein the light emitting layer comprises a heterocyclic derivative represented by the general formula (N-1) and preferably at least one compound of formula (IA), (IB) or (IC). 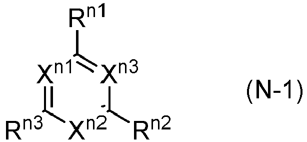
Xⁿ¹ to Xⁿ³ each independently represents CRⁿ⁴ or N,
Rⁿ¹ to Rⁿ⁴ each independently represents hydrogen, halogen atom, a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, or a substituted phosphoryl group,
in the case of at least one of Xⁿ¹ to Xⁿ³ represent CRⁿ⁴, two or more substituents selected among Rⁿ¹∼Rⁿ⁴ may be bonded to each other to form a ring structure.

In one embodiment of the present invention, the compound of formula (N-1) is preferably represented by the formula (N-21). 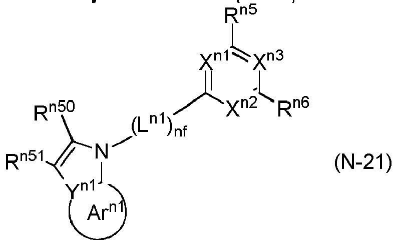 Wherein,
each of Xⁿ¹ to Xⁿ³, Rⁿ⁵ and Rⁿ⁶ is as defined in formula (N-1),
Lⁿ¹ represents a substituted or unsubstituted aryl group having 6 to 24 carbon atoms, or a substituted or unsubstituted heterocyclic group having 5 to 30 cyclic atoms,
nf is 0, 1, 2, 3 or 4, when f is 2, 3 or 4, the plural Lⁿ¹s may be same or different each other,
Yⁿ¹ is carbon atom or nitrogen atom,
Arⁿ¹ represents a substituted or unsubstituted aryl group having 6 to 24 carbon atoms which shares a carbon atom of an adjacent nitrogen-containing 5-membered ring and Yⁿ¹ and is fused to the nitrogen-containing 5-membered ring, or a substituted or unsubstituted heterocyclic group having 5 to 30 cyclic atoms which shares a carbon atom of an adjacent nitrogen-containing 5-membered ring and Yⁿ¹ and is fused to the nitrogen-containing 5-membered ring,
Rⁿ⁵⁰ and Rⁿ⁵¹ each independently represents hydrogen, halogen atom, a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, a substituted phosphoryl group or a cyano group, or R⁵⁰ and R⁵¹ may be bonded to each other to form a substituted or unsubstituted aryl group having 6 to 24 carbon atoms.

The compound represented by formula (N-21) is preferably represented by formula (N-22). 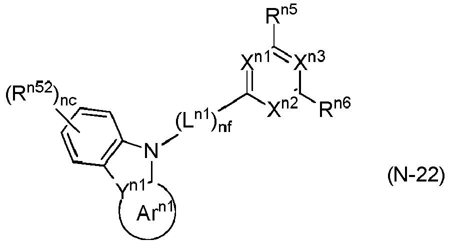 Wherein
Xⁿ¹ to Xⁿ³, Rⁿ⁵, Rⁿ⁶, Lⁿ¹, nf, Yⁿ¹ and Arⁿ¹ are as defined in formula (N-21),
Rⁿ⁵² represents hydrogen, halogen atom, a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, a substituted phosphoryl group or a cyano group,
nc is 0, 1, 2, 3 or 4, when c is 2, 3 or 4, the plural Rⁿ⁵²s may be same or different each other and adjacent Rⁿ⁵²s may be bonded to each other to form a ring structure.

The compound represented by formula (N-22) is preferably represented by formula (N-23). 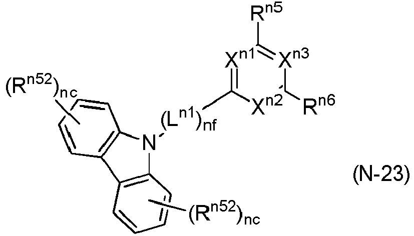 Wherein Xⁿ¹ to Xⁿ³, Rⁿ⁵, Rⁿ⁶, Lⁿ¹, nf, Rⁿ⁵² and nc are as defined in formula (N-22).

The compound represented by formula (N-23) is preferably represented by formula (N-24). 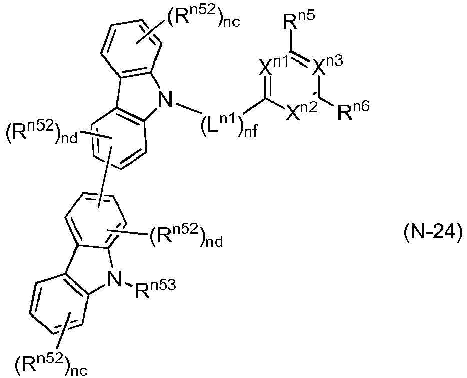
Wherein Xⁿ¹ to Xⁿ³, Rⁿ⁵, Rⁿ⁶, Lⁿ¹, nf, Rⁿ⁵² and nc are as defined in formula (N-23), nd is 0, 1, 2 or 3, when nd is 2 or 3, the plural Rⁿ⁵² are same or different each other,
Rⁿ⁵³ represents a substituted or unsubstituted alkyl group having 1 to 25 carbon atoms, a substituted or unsubstituted cycloalkyl group having 3 to 25 carbon atoms, a substituted or unsubstituted aryl group having 6 to 24 carbon atoms or a substituted or unsubstituted heterocyclic group having 5 to 30 cyclic atoms.

In another embodiment, the compound represented by formula (N-22) is preferably represented by formula N-25. 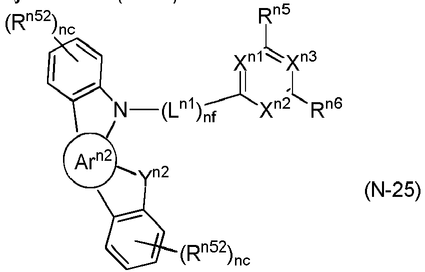
Wherein Xⁿ¹ to Xⁿ³, Rⁿ⁵, Rⁿ⁶, Lⁿ¹, nf, Rⁿ⁵² and nc are as defined in formula (N-22),
Yⁿ² represents CRⁿ⁵⁴Rⁿ⁵⁵, NRⁿ⁵⁵, oxygen atom or sulfur atom,
Rⁿ⁵⁴, Rⁿ⁵⁵ and Rⁿ⁵⁶ each independently represents a substituted or unsubstituted alkyl group having 1 to 25 carbon atoms, a substituted or unsubstituted cycloalkyl group having 3 to 25 carbon atoms, a substituted or unsubstituted aryl group having 6 to 24 carbon atoms or a substituted or unsubstituted heterocyclic group having 5 to 30 cyclic atoms,
Arⁿ² represents a substituted or unsubstituted aryl group having 6 to 24 carbon atoms which shares carbon atoms of two adjacent nitrogen-containing 5-membered rings and is fused to the two nitrogen-containing 5-membered rings, or a substituted or unsubstituted heterocyclic group having 5 to 30 cyclic atoms which shares carbon atoms of two adjacent nitrogen-containing 5-membered rings and is fused to the two nitrogen-containing 5-membered rings.

Yⁿ² in formula (N-25) preferably represents CRⁿ⁵⁴Rⁿ⁵⁵ or NRⁿ⁵⁶ (Rⁿ⁵⁴ to Rⁿ⁵⁶ are as defined in formula (N-25)).

The compound represented by formula (N-25) is preferably represented by any one of the following formulae N-26A to N-26F.

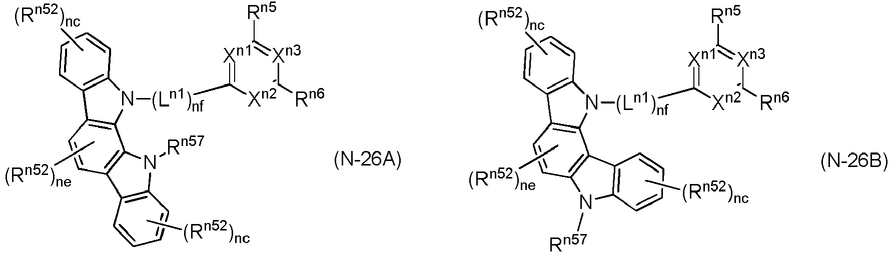

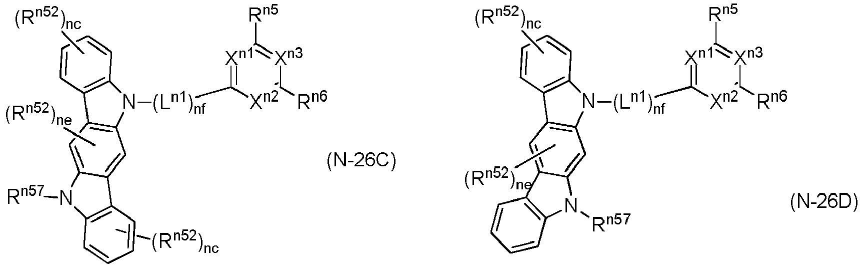

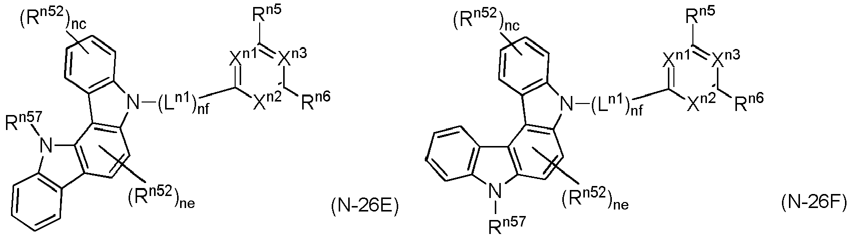

Wherein Xⁿ¹ to Xⁿ³, Rⁿ⁵, Rⁿ⁶, Lⁿ¹, nf, Rⁿ⁵² and nc are as defined in formula (N-25),
Rⁿ⁵⁷ represents a substituted or unsubstituted alkyl group having 1 to 25 carbon atoms, a substituted or unsubstituted cycloalkyl group having 3 to 25 carbon atoms, a substituted or unsubstituted aryl group having 6 to 24 carbon atoms or a substituted or unsubstituted heterocyclic group having 5 to 30 cyclic atoms,
e is 0, 1 or 2, when e is 2, the plural Rⁿ⁵²s may be same or different each other.

The compound represented by formula (N-25) is more preferably represented by any one of the following formulae (N-27A) to (N-27F). 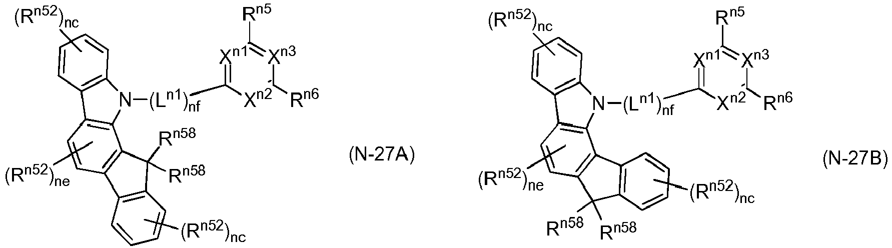 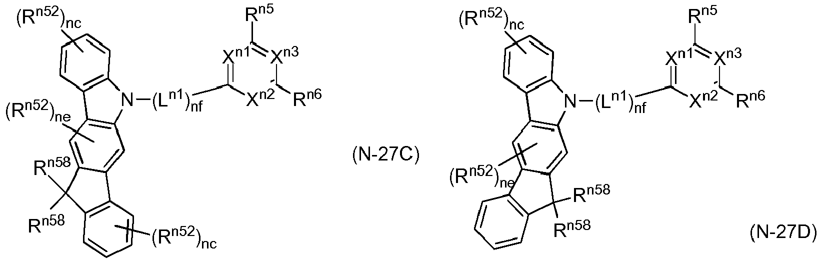 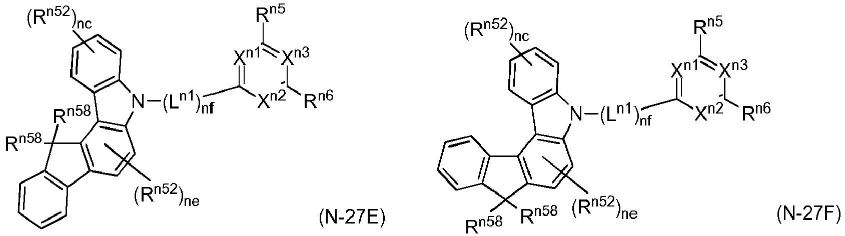
Wherein Xⁿ¹ to Xⁿ³, Rⁿ⁵, Rⁿ⁶, Lⁿ¹, nf, Rⁿ⁵² and nc are as defined in formula (N-25),
Rⁿ⁵⁸ represents a substituted or unsubstituted alkyl group having 1 to 25 carbon atoms, a substituted or unsubstituted cycloalkyl group having 3 to 25 carbon atoms, a substituted or unsubstituted aryl group having 6 to 24 carbon atoms or a substituted or unsubstituted heterocyclic group having 5 to 30 cyclic atoms,
ne is 0, 1 or 2, when ne is 2, the plural Rⁿ⁵²s may be same or different each other.

In another embodiment, the compound represented by formula (N-22) can be represented by formula (N-28). 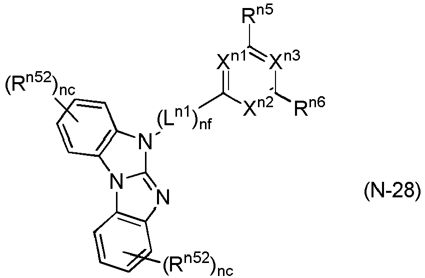 Wherein Xⁿ¹ to Xⁿ³, Rⁿ⁵, Rⁿ⁶, Lⁿ¹, nf, Rⁿ⁵² and nc are as defined in formula (N-22).

In another embodiment, the compound represented by formula (N-1) is preferably represented by formula N-30. 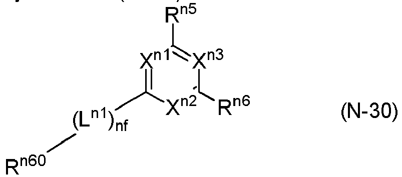
Wherein Xⁿ¹ to Xⁿ³, Rⁿ⁵ and Rⁿ⁶ are as defined in formula (N-1),
L1 represents a substituted or unsubstituted arylene group having 6 to 24 carbon atoms or a substituted or unsubstituted heteroarylene group having 5 to 30 cyclic atoms,
nf is 0, 1, 2, 3 or 4, when nf is 2, 3 or 4, the plural Lⁿ¹s may be same or different each other, Rⁿ⁶⁰ represents a substituted or unsubstituted fused-aryl group having 10 to 24 carbon atoms or a substituted or unsubstituted fused-heteroaryl group having 9 to 30 cyclic atoms.

Said substituted or unsubstituted fused-aryl group having 10 to 24 carbon atoms of Rⁿ⁶⁰ is preferably a mono-valent residue of the compound represented by formula (a1-1) or (a1-2). 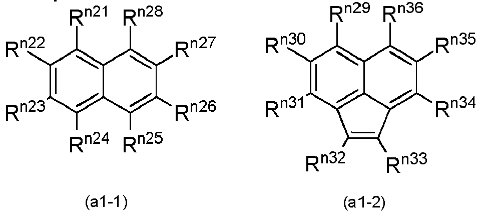
Wherein Rⁿ²¹ to Rⁿ³⁶ each independently represents hydrogen atom or substituent R^{b},
when plural R^{b}s exist, the plural R^{b}s may be same or different each other, and the plural R^{b}s may be bonded to each other to form a ring structure,
R^{b} represents hydrogen, a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, a substituted phosphoryl group or a cyano group.

Preferable examples of the compound represented by formula (a1-1) are as follows. 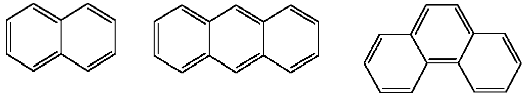 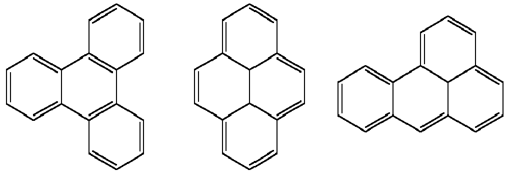 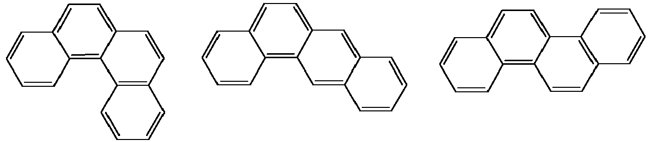 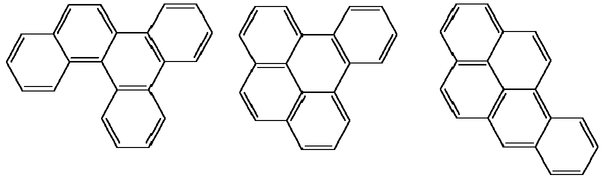 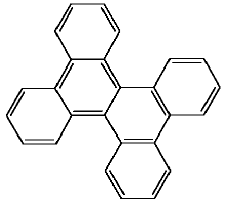 Among the above examples, a fused-aryl ring containing 4 or more rings, such as triphenylenyl group, is preferable.

Preferable examples of the compound represented by formula (a1-2) are as follows. 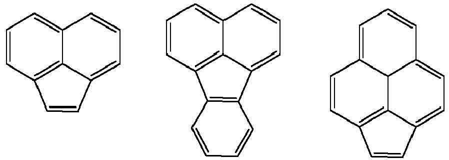 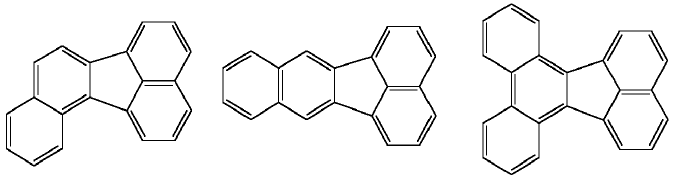 Among the above examples, a fused-aryl ring containing 4 or more rings, such as fluoranthenyl group is preferable.

As the fused-heteroaryl group having 9 to 30 cyclic atoms of Rⁿ⁶⁰, a fused-heteroaryl group having 9 to 30 cyclic atoms selected from the above-mentioned heteroaryl groups can be used. The substituted or unsubstituted fused-heteroaryl group having 9 to 30 cyclic atoms of Rⁿ⁶⁰ is preferably a mono-valent residue of the compound represented by formula (a2). 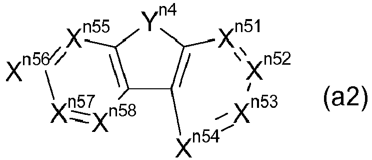
Wherein Xⁿ⁵¹ to Xⁿ⁵⁸ each independently represents CH, C(R^{b}) or N,
R^{b} represents a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, a substituted phosphoryl group or a cyano group,
when plural R^{b}s exist, the plural R^{b}s may be same or different each other, and the plural R^{b}s may be bonded to each other to form a ring structure,
Yⁿ⁴ represents oxygen atom, sulfur atom, -NR^{d}- or-C(R^{e})(R^{f})-,
R^{d}, R^{e} and R^{f} each independently represents hydrogen atom or substituent R^{b},
when both of R^{e} and R^{f} are R^{b}, the R^{b}s may be bonded to each other to form a ring structure.

The mono-valent residue of the compound represented by formula (a2) is preferably mono--valent residue of the compound represented by formula (a2-1). 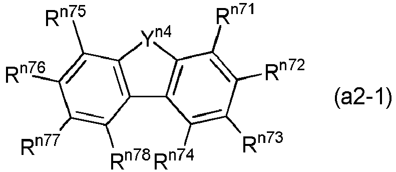
Wherein Yⁿ⁴ is as defined in formula (a2),
Rn71 to Rn78 each independently represents hydrogen atom or substituent R^{b},
R^{b} is as defined in formula (a2),
when plural R^{b}s exist, the plural R^{b}s may be same or different and may be bonded to each other to form a ring structure.

The compound represented by formula N-30 is preferably represented by formula (N-31). 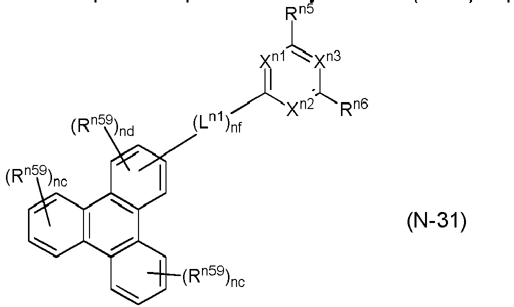
Wherein Xⁿ¹ to Xⁿ³, Rⁿ⁵, Rⁿ⁶, Lⁿ¹ and nf are as defined in formula (N-30),
Rⁿ⁵⁹ represents a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, a substituted phosphoryl group or a cyano group,
nc is 0, 1, 2, 3 or 4, nd is 0, 1, 2 or 3,
when nc is 2, 3 or 4, and/or when nd is 2 or 3, the plural Rⁿ⁵⁹s may be same or different, and the plural Rⁿ⁵⁹s may be bonded to each other to form a ring structure.

In another embodiment, the compound represented by formula (N-30) is preferably represented by formula (N-32). 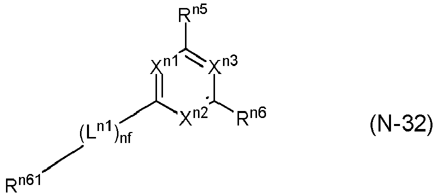
Wherein Xⁿ¹ to Xⁿ³, Rⁿ⁵, Rⁿ⁶, Lⁿ¹ and nf are as defined in formula (N-30),
Rⁿ⁶¹ represents a substituted or unsubstituted fused-heteroaryl group having 9 to 30 cyclic atoms and not containing nitrogen atom.
As the fused-heteroaryl group having 9 to 30 cyclic atoms and not containing nitrogen atom of Rⁿ⁶¹, a fused-heteroaryl group having 9 to 30 cyclic atoms and not containing nitrogen atom selected from the above-mentioned heteroaryl groups can be used.

The compound represented by formula N-32 is preferably represented by formula (N-33). 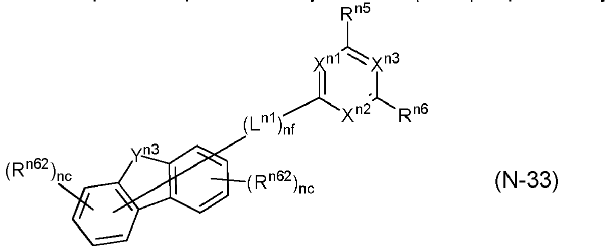
Wherein Xⁿ¹ to Xⁿ³, Rⁿ⁵, Rⁿ⁶, Lⁿ¹ and nf are as defined in formula (N-32),
Yⁿ³ represents oxygen atom, sulfur atom, -NR^{d}- or -C(R^{e})(R^{f})-,
Rⁿ⁶² represents a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, a substituted phosphoryl group or a cyano group,
nc is 0, 1, 2, 3 or 4, when nc is 2, 3 or 4, the plural Rⁿ⁶²s may be same or different, and the plural Rⁿ⁶²s may be bonded to each other to form a ring structure.

Further preferable heteroaromatics for the host are p-type host materials like specific nitrogen containing heteroaromatics with electron donating nitrogen atom(s), such as pyrrole derivatives, indole derivatives, carbazole derivatives, acridine derivatives, phenoxadine derivatives, pheno-thiazine derivatives, imidazole derivatives, benzimidazole derivatives, benzimidazobenzimidazole derivatives and so on, which may have additional substituents and additional fused ring structures, preferably carbazole derivatives, more preferably following general formula (P-1). 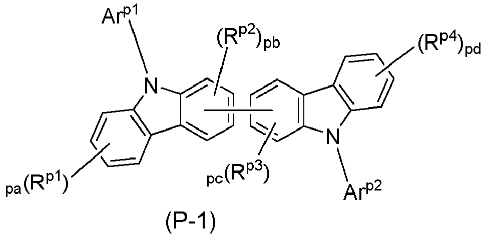
Ar^{p1} and Ar^{p2} each independently represents a substituted or unsubstituted aryl group having 6 to 24 carbon atoms, preferably, phenyl group, biphenyl group, terphenyl group, quarterphenyl group, naphthyl group, phenanthryl group or triphenylenyl group, or a substituted or unsubstituted heterocyclic group having 5 to 30 cyclic atoms, preferably, carbazoryl group, dibenzofuranyl group or dibenzothiophenyl group, or a substituent which consists of substituted or un substituted aryl group and substituted or unsubstituted heteroaryl group, preferably, aryl group and dibenzofuran group, aryl group and dibenzothiophene group or aryl group and carbazole group. R^{p1} to R^{p4} each independently represents halogen atom, a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, a substituted phosphoryl group or a cyano group, or R⁵⁰ and R⁵¹ may be bonded to each other to form a substituted or unsubstituted aryl group having 6 to 24 carbon atoms.
pa and pd each independently represents 0 to 4.
pb and pc each independently represents 0 to 3.

Suitable host materials are for example mentioned in WO2011/122132, WO2012/108389, WO2012/108388, WO2013/084881, WO2013/145923 and in WO2017/093958A1.

Examples for suitable host materials are:

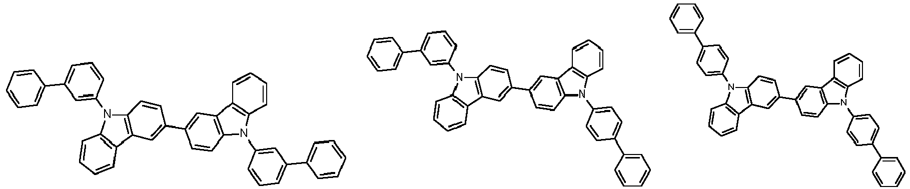

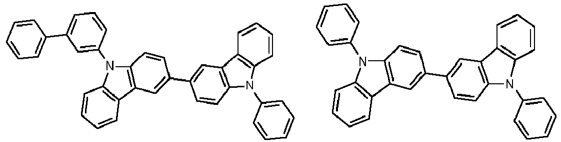

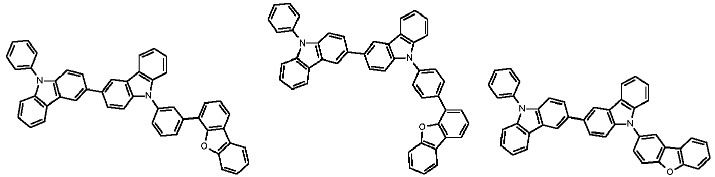

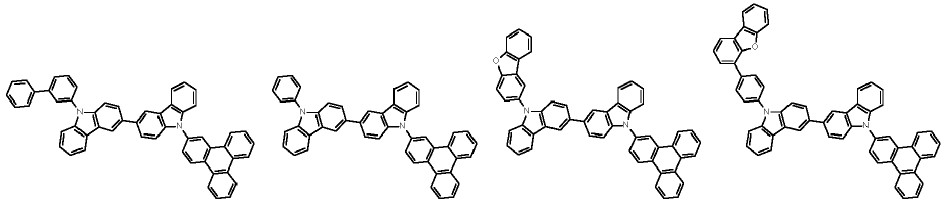

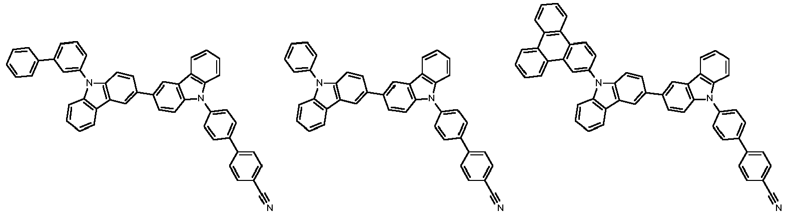

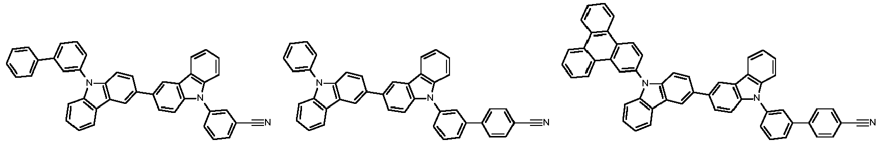

Further, aryl or heteroaryl substituted amine derivatives can be used for the host material.

Further, fused aryl derivatives or fused heteroaryl derivatives are useful for the host material.

According to another embodiment, the light-emitting layer comprises at least one emitter material and at least two host materials, wherein one of the host materials is a material selected from before mentioned known host materials and the other host material(s) is/are used as co-host(s). Suitable other host material(s) is/are selected from before mentioned general host materials.

In the case that two host materials are present in the emitting layer, the light-emitting layer is formed from 0.1 to 70% by weight, preferably 1 to 30% by weight, of the at least one emitter material and 30 to 99.9% by weight, preferably 70 to 99% by weight, of a first host and a second host, where the sum total of the at least one emitter material, the two host materials adds up to 100% by weight.
The content ratio of the compound of the first host material and the second host material as co-host in the light emitting layer is not particularly limited and may be selected accordingly, and the ratio of first host material: second host material is preferably 1:99 to 99:1, more preferably 10:90 to 90:10, each based on mass.

The at least one emitter material is preferably at least one inventive metal complex, preferably as a phosphorescent dopant.

A phosphorescent dopant (phosphorescent emitting material) that forms the emitting layer is a compound that can emit light from triplet excited state. The phosphorescent dopant is not limited as long as it can emit from triplet excited state. The phosphorescent dopant is preferably an organic metal complex containing at least one metal selected from Ir, Pt, Os, Au, Cu, Re and Ru and a ligand. It is preferred that the ligand have an ortho-metalated bond. In respect of a high phosphorescent quantum yield and capability of improving external quantum yield of an emitting device, the phosphorescent dopant is preferably a compound having a metal atom selected from Ir, Os and Pt. Further preferred is a metal complex such as an iridium complex, an osmium complex and a platinum complex, with an ortho-metalated complex being more preferable. Among them, an iridium complex and a platinum complex are more preferable. Most preferably, at least one inventive metal complex is employed as phosphorescent dopant.

When the inventive metal complex is used as an emitter material in the emitting layer, the emission wavelength of the inventive metal complex contained in the emitting layer is not particularly restricted. It is preferred that inventive metal complex contained in the emitting layer has a peak of an emission wavelength of 510 nm or more and 590 nm or less, preferably 520 nm or more and 590 nm and less, more preferably 520 nm or more and 550 nm and less. As for the emission color of the emitting layer green to yellow, preferably green to yellow green are preferable. By using the inventive metal complex as the emitter material, it is possible to obtain an organic EL device having a high efficiency.
In the organic EL device according to the invention, other compounds than the material for an organic EL device according to the invention can appropriately be selected according to the above-mentioned purpose.

The inventive metal complex and other light-emitting compounds may be used in combination with the host materials mentioned above in the same emitting layer.
When plural emitting layers are present, as the emitter material, preferably the phosphorescent emitter material, for one of these emitting layers, at least one inventive metal complex is used, and as the emitter material for the other emitting layers, other compounds than the inventive metal complexes may be used. The inventive metal complexes can be used in an organic layer other than the emitting layer. In that case, as the emitter material of the emitting layer, other compounds than the inventive metal complex may be used.

Typical metal complexes (dopants, especially phosphorescent dopants) for use in the inventive OLEDs, preferably as emitter material, in addition to the at least one inventive metal complex or - in the case that the inventive metal complexes are not used as emitter material - as sole emitter materials - are for example described in Baldo et al., Applied Physics Letters, vol. 75, No. 1, 5 July 1999, 4-6, US 2011/0227049 A1, US 2014/0203268 A1, US 2013/0341609, US 2013/0181190, US 2013/0119354, WO 2012/053627 A1 and WO 2013/112557.

### Electron-transporting layer

The electron-transporting layer is an organic layer that is formed between the emitting layer and the cathode and has a function of transporting electrons from the cathode to the emitting layer. When the electron-transporting layer is formed of plural layers, an organic layer that is nearer to the cathode is often defined as the electron-injecting layer. The electron-injecting layer has a function of injecting electrons from the cathode efficiently to the organic layer unit.
According to one embodiment, it is preferred that an electron-transporting layer further comprises further one or more layer(s) besides the electron injection layer to enhance efficiency and lifetime of the device, preferably between an electron injection layer and the emitting layer like a hole blocking layer, an exciton blocking layer or a triplet blocking layer.

According to one embodiment, it is preferred that an electron-donating dopant be contained in the interfacial region between the cathode and the emitting unit, i.e. forming the electron-transporting layer. Due to such a configuration, the organic EL device can have an increased luminance or a long life. Here, the electron-donating dopant means one having a metal with a work function of 3.8 eV or less. As specific examples thereof, at least one selected from an alkali metal, an alkali metal complex, an alkali metal compound, an alkaline earth metal, an alkaline earth metal complex, an alkaline earth metal compound, a rare earth metal, a rare earth metal complex and a rare earth metal compound or the like can be mentioned.

As the alkali metal, Na (work function: 2.36 eV), K (work function: 2.28 eV), Rb (work function: 2.16 eV), Cs (work function: 1.95 eV) and the like can be given. One having a work function of 2.9 eV or less is particularly preferable. Among them, K, Rb and Cs are preferable. Rb or Cs is further preferable. Cs is most preferable. As the alkaline earth metal, Ca (work function: 2.9 eV), Sr (work function: 2.0 eV to 2.5 eV), Ba (work function: 2.52 eV) and the like can be given. One having a work function of 2.9 eV or less is particularly preferable. As the rare-earth metal, Sc, Y, Ce, Tb, Yb and the like can be given. One having a work function of 2.9 eV or less is particularly preferable.

Examples of the alkali metal compound include an alkali oxide such as Li₂O, Cs₂O or K₂O, and an alkali halide such as LiF, NaF, CsF and KF. Among them, LiF, Li₂O and NaF are preferable. Examples of the alkaline earth metal compound include BaO, SrO, CaO, and mixtures thereof such as BaₓSr₁₋ₓO (0<x<1) and BaₓCa₁₋ₓO (0<x<1). Among them, BaO, SrO and CaO are preferable. Examples of the rare earth metal compound include YbF₃, ScF₃, ScO₃, Y₂O₃, Ce₂O₃, GdF₃ and TbF₃. Among these, YbF₃, SCF₃ and TbF₃ are preferable.

The alkali metal complexes, the alkaline earth metal complexes and the rare earth metal complexes are not particularly limited as long as they contain, as a metal ion, at least one of alkali metal ions, alkaline earth metal ions, and rare earth metal ions. Meanwhile, preferred examples of the ligand include, but are not limited to, quinolinol, benzoquinolinol, acridinol, phenanthridinol, hydroxyphenyloxazole, hydroxyphenylthiazole, hydroxydiaryloxadiazole, hydroxydiarylthiadiazole, hydroxyphenylpyridine, hydroxyphenylbenzimidazole, hydroxybenzotriazole, hydroxyfluborane, bipyridyl, phenanthroline, phthalocyanine, porphyrin, cyclopentadiene, β-diketones, azomethines, and derivatives thereof.

Regarding the addition form of the electron-donating dopant, it is preferred that the electron-donating dopant be formed in a shape of a layer or an island in the interfacial region. A preferred method for the formation is a method in which an organic compound (a light emitting material or an electron-injecting material) for forming the interfacial region is deposited simultaneously with deposition of the electron-donating dopant by a resistant heating deposition method, thereby dispersing the electron-donating dopant in the organic compound. The dispersion concentration of the organic compound: the electron-donating dopant (molar ratio) is 100:1 to 1:100, preferably 5:1 to 1:5.

In a case where the electron-donating dopant is formed into the shape of a layer, the light-emitting material or electron-injecting material which serves as an organic layer in the interface is formed into the shape of a layer. After that, a reductive dopant is solely deposited by the resistant heating deposition method to form a layer preferably having a thickness of from 0.1 nm to 15 nm. In a case where the electron-donating dopant is formed into the shape of an island, the emitting material or the electron-injecting material which serves as an organic layer in the interface is formed into the shape of an island. After that, the electron-donating dopant is solely deposited by the resistant heating deposition method to form an island preferably having a thickness of from 0.05 nm to 1 nm.

The ratio of the main component and the electron-donating dopant in the organic EL device according to the invention is main component: electron-donating dopant = 5 : 1 to 1 : 5 in terms of molar ratio, more preferably 2 : 1 to 1 : 2.

As the electron-transporting material used in the electron-transporting layer, an aromatic heterocyclic compound having one or more heteroatoms in the molecule may preferably be used. In particular, a nitrogen containing heterocyclic derivative is preferable.
According to one embodiment, it is preferable that the electron-transporting layer comprises a nitrogen containing heterocyclics metal chelate, such as 8-hydroxyquinolinolato aluminum, which is generally called as Alq₃.
According to the other embodiment, it is preferable that the electron-transporting layer comprising substituted or unsubstituted nitrogen containing heterocyclic derivative.
Specific examples of the preferable heterocyclic derivative for the elecrtron-transporting layer are, 6-membered azine derivatives; such as pyridine derivatives, pyrimidine derivatives, triazine derivatives, pyrazine derivatives, preferably pyrimidine derivatives or triazine derivatives; 6-membered fused azine derivatives, such as quinolone derivatives, isoquinoline derivatives, quinoxaline derivatives, quinazoline derivatives, phenanthroline derivatives, benzoquinoline derivatives, benzoisoquinoline derivatives, dibenzoquinoxaline derivatives, preferably quinolone derivatives, isoquinoline derivatives, phenanthroline derivatives; 5-membered heterocyclic derivatives, such as imidazole derivatives, oxazole derivatives, oxadiazole derivatives, triazole derivatives, thiazole derivatives, thiadiazole derivatives; fused imidazole derivatives, such as benzimidazole derivatives, imidazopyridine derivatives, naphthoimidazole derivatives, benzimidazophenanthridine derivatives, benzimidzobenzimidazole derivatives, preferably benzimidazole derivatives, imidazopyridine derivatives or benzimidazophenanthridine derivatives. According to the other embodiment, it is preferable the electron-transporting layer comprises phosphine oxide derivative represented as Arₚ₁Arₚ₂Ar_{P3}P=O.
Arₚ₁ to Arₚ₃ are the substituents of phosphor atom and each independently represent substituted or unsubstituted above mentioned aryl group or substituted or unsubstituted above mentioned heterocyclic group.
According to the other embodiment, it is preferable that the electron-transporting layer comprises aromatic hydrocarbon derivatives.
Specific examples of the preferable aromatic hydrocarbon derivatives for the electron-transporting layer are, oligo-phenylene derivatives, naphthalene derivatives, fluorene derivatives, fluoranthenyl group, anthracene derivatives, phenanthrene derivatives, pyrene derivatives, triphenylene derivatives, benzanthracene derivatives, chrysene derivatives, benzphenanthrene derivatives, naphthacene derivatives, benzochrysene derivatives, and so on, preferably anthracene derivatives, pyrene derivatives and fluoranthene derivatives.

The present invention therefore relates to an organic electroluminescence device, wherein an electron transporting layer is provided between the cathode and the light emitting layer.

The present invention therefore further relates to an organic electroluminescence device, wherein a hole blocking layer is provided between the electron transporting layer and the light emitting layer.

According to one embodiment, it is preferred that another electron transporting region is further comprised between the hole blocking layer and cathode. Said electron transporting region generally comprises one or more electron transporting layer(s).
Above mentioned electron injection materials, such as alkali metal compound or alkali metal complex, preferably comprising as one of electron transporting layer are present at the interface of cathode. The second electron transporting layer preferably present between hole blocking layer and said electron transporting layer comprising the electron injection material.
Above mentioned heterocyclic derivatives or fused aromatic derivatives are preferably used for the second electron transporting layer, more preferably heterocyclic derivatives represented by general formulae (ET-1), (ET-2), (ET-3) or (ET-4). 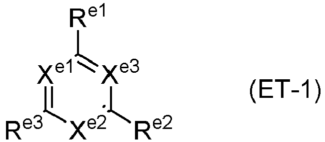
X^{e1} to X^{e3} each independently represents CR^{e4} or N, preferably more than two of X^{e1} to X^{e3} are N,
R^{e1} to R^{e4} each independently represents hydrogen, halogen atom, a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, or a substituted phosphoryl group,
in the case of at least one of X^{e1} to X^{e3} represent CR^{e4}, two or more substituents selected among R^{e1} to R^{e4} may be bonded to each other to form a ring structure. 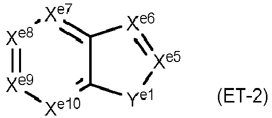
X^{e5} to X^{e10} each independently represents CR^{e5} or N, preferably at least X^{e6} is N,
Y^{e1} represents oxygen atom, sulfur atom, CR^{e6}R^{e7} or NR^{e8},
R^{e5} to R^{e8} each independently represents hydrogen, halogen atom, a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, or a substituted phosphoryl group,
two or more substituents selected among R^{e5} to R^{e8} may be bonded to each other to form a ring structure. 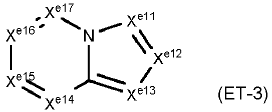
X^{e11} to X^{e17} each independently represents CR^{e9} or N, preferably at least one selected from X^{e11}, X^{e12} and X^{e13} is N,
R^{e9} each independently represents hydrogen, halogen atom, a substituted or unsubstituted alkyl group having 1 to 25 carbon atoms, a substituted or unsubstituted alkenyl group having 2 to 25 carbon atoms, a substituted or unsubstituted alkynyl group having 2 to 25 carbon atoms, a substituted or unsubstituted cycloalkyl group having 3 to 25 carbon atoms, a substituted or unsubstituted alkoxy group having 1 to 25 carbon atoms, a substituted or unsubstituted aryl group having 6 to 24 carbon atoms, a substituted or unsubstituted heterocyclic group having 5 to 30 cyclic atoms, a substituted or unsubstituted aryloxy group having 6 to 24 carbon atoms, a substituted or unsubstituted alkylthio group having 1 to 25 carbon atoms, a substituted or unsubsituted arylthio group having 6 to 24 carbon atoms, alkyl or aryl substituted silyl group, alkyl or aryl substituted carbonyl group, or a substituted phosphoryl group,
two or more substituents selected among R^{e9} may be bonded to each other to form a ring structure. 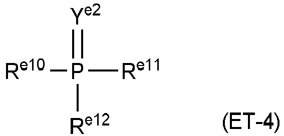
R^{e10} to R^{e12} each independently represents a substituted or unsubstituted aryl group having 6 to 24 carbon atoms, a substituted or unsubstituted heterocyclic group having 5 to 30 cyclic atoms, two or more substituents selected among R^{e10} to R^{e12} may be bonded to each other to form a ring structure, preferably at least one of R^{e10} to R^{e12} have additional substituted or unsubstituted aryl group having 6 to 24 carbon atoms, or substituted or unsubstituted heterocyclic group having 5 to 30 cyclic atoms,
Y^{e2} represents oxygen atom or sulfur atom.

### Hole-transporting layer

The hole-transporting layer is an organic layer that is formed between the emitting layer and the anode, and has a function of transporting holes from the anode to the emitting layer. If the hole-transporting layer is composed of plural layers, an organic layer that is nearer to the anode may often be defined as the hole-injecting layer. The hole-injecting layer has a function of injecting holes efficiently into the organic layer unit from the anode.
Said hole injection layer is generally used for stabilizing hole injection from anode to the hole transporting layer which generally consists of organic materials.
Organic material having good contact with anode or organic material with p-type doping is preferably used for the hole injection layer.
Acceptor materials, or fused aromatic hydrocarbon materials or fused heterocycles which have high planarity, are preferably used, acceptor materials are more preferably used for the hole injection layer.
Specific examples for acceptor materials are, the quinone derivatives with one or more electron withdrawing groups, such as F₄TCNQ(2,3,5,6-tetrafluoro-7,7,8,8-tetracyanoquinodimethane), 1,2,3-Tris[(cyano)(4-cyano-2,3,5,6-tetrafluorophenyl)methylene]cyclopropane, and so on; hexa-azatriphenylene derivatives with one or more electron withdrawing groups, such as hexa-azatriphenylene-hexanitrile; aromatic hydrocarbon derivatives with one or more electron withdrawing groups; aryl boron derivatives with one or more electron withdrawing groups, and so on.
p-doping usually consists of one or more p-dopant materials and one or more host materials. Host materials preferably have shallower HOMO level and p-dopants preferably have deeper LUMO level to enhance the carrier density of the layer. Aryl or heteroaryl amine derivatives are preferably used as the Host materials. Specific examples for the host material are the same as that for hole transporting layer which is explained below. Specific examples for p-dopants are the above mentioned acceptor materials, preferably the quinone derivatives with one or more electron withdrawing groups, such as F₄TCNQ, 1,2,3-Tris[(cyano)(4-cyano-2,3,5,6-tetrafluorophenyl)methylene]cyclopropane.
The ratio of the p-type dopant is preferably less than 20% of molar ratio, more preferably less than 10%, such as 1%, 3%, 5% and so on, in relation the host material..

The hole transporting layer is generally used for injecting and transporting holes efficiently, and aromatic or heterocyclic amine derivatives are preferably used.
Specific examples for materials for the hole transporting layer are represented as general formula (H),

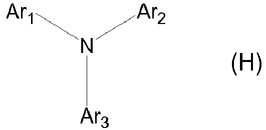

Ar₁ to Ar₃ each independently represents substituted or unsubstituted aryl group having 5 to 50 carbon atoms or substituted or unsubstituted heterocyclic group having 5 to 50 cyclic atoms, preferably phenyl group, biphenyl group, terphenyl group, naphthyl group, phenanthryl group, triphenylenyl group, fluorenyl group, spirobifluorenyl group, indenofluorenyl group, carbazolyl group, dibenzofuranyl group, dibenzothiophenyl group, carbazole substituted aryl group, dibenzofuran substituted aryl group or dibenzothiophene substituted aryl group; two or more substituents selected among Ar¹ to Ar³ may be bonded to each other to form a ring structure, such as carbazole ring structure, acridane ring structure and so on.
According to one embodiment, it is preferable that at least one of Ar₁ to Ar₃ have additional one aryl or heterocyclic amine substituent, more preferably Ar₁ has an additional aryl amino substituent, at the case of that it is preferable that Ar₁ represents substituted or unsubstituted biphenylene group, substituted or unsubstituted fluorenylene group.

A second hole transporting layer is preferably inserted between the first hole transporting layer and the emitting layer to enhance device performance by blocking excess electrons or excitons. Specific examples for the second hole transporting layer are the same as for the first hole transporting layer. It is preferable that the second hole transporting layer has higher triplet energy to block triplet excitons especially for phosphorescent green devices, such as biscarbazole derivatives, biphenylamine derivatives, triphenylenyl amine derivatives, fluorenyl amine derivatives, carbazole substituted arylamine derivatives, dibenzofuran substituted arylamine derivatives, dibenzothiophene substituted arylamine derivatives, and so on.

### Spacing layer

The spacing layer is a layer provided between the fluorescent emitting layer and the phosphorescent emitting layer when the fluorescent emitting layer and the phosphorescent emitting layer are stacked in order to prevent diffusion of excitons generated in the phosphorescent emitting layer to the fluorescent emitting layer or in order to adjust the carrier balance. Further, the spacing layer can be provided between plural phosphorescent emitting layers.

Since the spacing layer is provided between the emitting layers, the material for the spacing layer is preferably a material having both electron-transporting properties and hole-transporting properties. In order to prevent diffusion of the triplet energy in adjacent phosphorescent emitting layers, it is preferred that the spacing layer has a triplet energy of 2.6 eV or more. As a material used for the spacing layer, the same material as those used in the above-mentioned hole-transporting layer can be given.

### Barrier layer

It is preferred that the organic EL device according to the invention has a barrier layer such as an electron-barrier layer, a hole-barrier layer and/or a triplet barrier layer in a part that is adjacent to the emitting layer. Here, the electron-barrier layer is a layer that serves to prevent leakage of electrons from the emitting layer to the hole-transporting layer, and the hole-barrier layer is a layer that serves to prevent leakage of holes from the emitting layer to the electron-transporting layer.

The triplet barrier layer prevents diffusion of triplet excitons generated in the emitting layer to the surrounding layers, and has a function of preventing energy deactivation of triplet excitons on molecules in the electron-transporting layer other than the emitting dopant by confining the triplet excitons within the emitting layer.

When the triplet barrier layer is provided, in the phosphorescent emitting device, the following is considered. The triplet energy of the phosphorescent emitting dopant is taken as E^{T}_{d} and the triplet energy of the compound used as the triplet barrier layer is taken as E^{T}_{TB}. If the energy relationship E^{T}_{d} < E^{T}_{TB} is satisfied, in respect of energy, the triplet excitons of the phosphorescent emitting dopant are confined (i.e. the triplet excitons cannot be moved to other molecules), whereby the energy deactivation route other than emission on the dopant is cut off, leading to efficient emission. However, even when the relationship E^{T}_{d} < E^{T}_{TB} is established, if the energy difference ΔE^{T} = E^{T}_{TB} - E^{T}_{d} is small, it is thought that, in an environment at around room temperature where the device is actually driven, due to thermal energy of the surrounding area, the triplet excitons can move to other molecules by endothermically overcoming this energy difference ΔE^{T}. In particular, in the case of phosphorescent emission that has a longer exciton life as compared with fluorescent emission, effects of the endothermic move of excitons relatively tend to appear. Relative to the thermal energy at room temperature, a larger energy difference ΔE^{T} is preferable. The energy difference ΔE^{T} is further preferably 0.1 eV or more, and particularly preferably 0.2 eV or more.

The electron mobility of the material constituting the triplet barrier layer is desirably 10⁻⁶ cm²/Vs or more in a field intensity range of 0.04 to 0.5 MV/cm. As a method for measuring the electron mobility of an organic material, several methods that include the Time of Flight method are known. Here, the electron mobility means an electron mobility that is determined by the impedance spectroscopy.

The electron mobility of the electron-injecting layer is desirably 10⁻⁶ cm²/Vs or more in a field intensity range of 0.04 to 0.5 MV/cm. The reason is that, by this electron mobility, injection of electrons from the cathode to the electron-transporting layer is promoted, and as a result, injection of electrons to an adjacent barrier layer and emitting layer is promoted, enabling the device to be driven at a lower voltage.

The present invention further relates to an electronic equipment comprising the organic electroluminescence device according to the present invention.

The inventive organic EL device using the inventive metal complex can be used as an emitting device in a panel module used in various displays.

The inventive organic EL device using the inventive metal complex can be used as a display element of a TV, a mobile phone and a PC; or an electronic apparatus such as lightings or the like.

The inventive OLEDs (organic EL devices) can be used in all apparatus in which electroluminescence is useful. Suitable devices are preferably selected from stationary and mobile visual display units and illumination units. Stationary visual display units are, for example, visual display units of computers, televisions, visual display units in printers, kitchen appliances and advertising panels, illuminations and information panels. Mobile visual display units are, for example, visual display units in cellphones, tablet PCs, laptops, digital cameras, MP3 players, vehicles and destination displays on buses and trains. Further devices in which the inventive OLEDs can be used are, for example, keyboards; items of clothing; furniture; wallpaper. In addition, the present invention relates to a device selected from the group consisting of stationary visual display units such as visual display units of computers, televisions, visual display units in printers, kitchen appliances and advertising panels, illuminations, information panels, and mobile visual display units such as visual display units in cellphones, tablet PCs, laptops, digital cameras, MP3 players, vehicles and destination displays on buses and trains; illumination units; keyboards; items of clothing; furniture; wallpaper, comprising at least one inventive organic light-emitting diode or at least one inventive light-emitting layer.

The following examples are included for illustrative purposes only and do not limit the scope of the claims. Unless otherwise stated, all parts and percentages are by weight.

### Examples

All experiments were carried out in protective gas atmosphere. The percentages and ratios mentioned in the examples below - unless stated otherwise - are % by weight and weight ratios.

### I. Synthesis Examples

### Synthesis Example 1. Synthesis of complex (I)

### a) Synthesis of 5-(6-chloro-3-pyridyl)benzimidazolo[1,2-a]benzimidazole

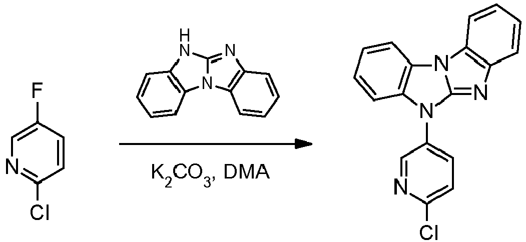

10.4 g (50.0 mmol) of 6H-benzimidazolo[1,2-a]benzimidazole (see synthesis for example in Bull. Soc. Chim. Belges 1987, 96, 787-92, WO2012130709, Org. Lett. 2012, 14, 452, Eur. J. Org. Chem. 2014, 5986-5997, and RSC Advances 2014, 4, 21904-21908), 13.2 g (0.10 mol) of 2-chloro-5-fluoropyridine, and 20.7 g (0.15 mol) of potassium carbonate were suspended in 200 ml of *N*,*N*-dimethylacetamide (DMA). The white suspension was heated first at 138°C during five hours, followed by heating at 156°C during two hours. The reaction mixture was cooled down to 70°C and filtered. The filtrate was further cooled down, the resulting precipitate filtered off and washed with ethyl acetate, followed by drying under vacuum, giving a first crop of solid material (8.3 g). The resulting filtrate was further cooled, then filtered after one hour, and the solid washed with ethanol, followed by drying under vacuum, giving another 2.3 g of solid material. A total of 10.6 g of a white solid was obtained, having a content of the title product of ca. 85%, with the bis-substituted product as the only side-product according to analysis (yield: ca. 57%). The product was used without further purification in the next step.
ESI-MS (positive, m/z): exact mass of C₁₈H₁₁ClN₄ = 318.07; found 319.1 [M+1]⁺.

### b) Synthesis of 5-(6-phenyl-3-pyridyl)benzimidazolo[1,2-a]benzimidazole

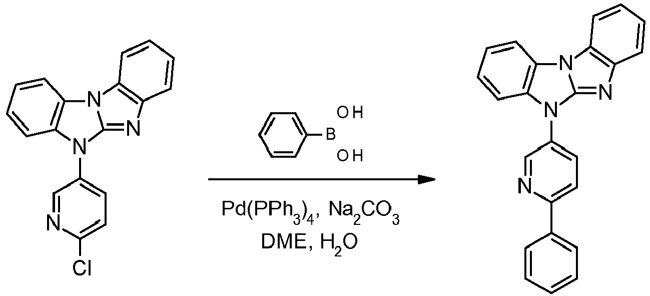

3.80 g (ca. 10 mmol, ca. 85% product content) of 5-(6-chloro-3-pyridyl)benzimidazolo[1,2-a]benzimidazole, 1.83 g (15.0 mmol) of benzeneboronic acid, and 4.24 g (40.0 mmol) of sodium carbonate were suspended in 40 ml of 1,2-dimethoxyethane (DME) and 20 ml of water. The white suspension was three times evacuated and backfilled with argon, followed by the addition of 116 mg (0.10 mmol) of tetrakis(triphenylphosphine)palladium(0). The reaction mixture was heated at 88°C during six hours. The beige suspension was treated with water and filtered. The solid was washed with water and further purified by MPLC with the *CombiFlash Companion* (silica gel, dichloromethane/0-10% gradient of ethyl acetate), giving the title product as a white solid (yield: 3.14 g (ca. 86%)).
¹H-NMR (400 MHz, CD₂Cl₂): δ = 7.33-7.62 (m, 7 H), 7.66-7.79, (m, 2 H), 7.88-7.97 (m, 2 H), 8.06 (d, 1 H), 8.16 (d, 2 H), 8.40 (dd, 1 H), 9.26 (d, 1 H).

### c) Synthesis of complex intermediate (I-c)

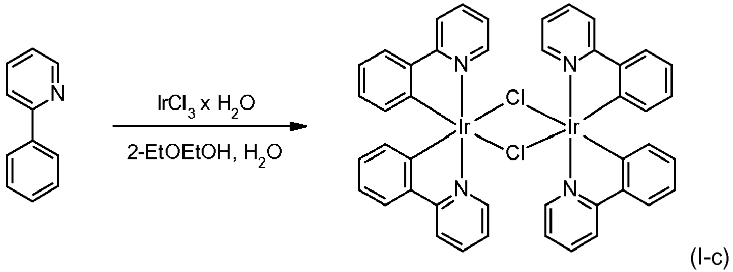

26.4 g (0.17 mol) of 2-phenylpyridine and 14.5 g (40 mmol) iridium(III)chloride hydrate (53.14% iridium content) were suspended under argon in 300 ml of 2-ethoxyethanol and 100 ml of water. The suspension was three times evacuated and backfilled with argon and heated at 94°C during 26 hours. The hot reaction mixture was filtered, and the solid washed with 100 ml of methanol. The resulting solid was three times taken up and washed with 50 ml of methanol, then filtered, and dried under vacuum, giving the title compound as a yellow solid (yield: 19.9 g (93%)).
¹H-NMR (400 MHz, CD₂Cl₂): δ = 5.92 (dd, 4 H), 6.65 (td, 4 H), 6.80-6.94 (m, 8 H), 7.60 (dd, 4 H), 7.84 (td, 4 H), 7.98 (dd, 4 H), 9.30 (dd, 4 H).

### d) Synthesis of complex intermediate (I-d)

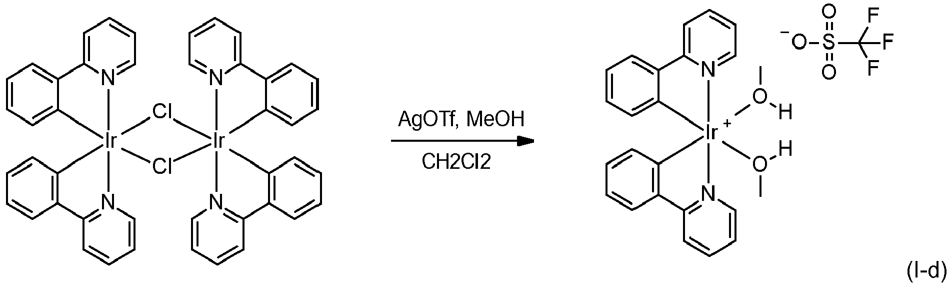

9.50 g (8.86 mmol) of complex intermediate (I-c) and 4.55 g (17.7 mmol) of silver trifluoromethanesulfonate were suspended under argon in 300 ml of dichloromethane and 15 ml of methanol and stirred at room temperature during four hours. The green suspension was filtered through a 3 cm layer of Hyflo® filter aid, and the Hyflo® filter aid layer washed with 200 ml of dichloromethane. The combined eluents were concentrated under vacuum, giving the title compound as a greenish yellow solid (yield: 12.4 g (98%)).
¹H-NMR (400 MHz, CD₃OD): δ = 6.10 (dd, 2 H), 6.69 (td, 2 H), 6.86 (td, 2 H), 7.46-7.57 (m, 2 H), 7.67 (dd, 2 H), 8.03 (td, 2 H), 8.13 (d, 2 H), 8.89 (d, 2 H).

### e) Synthesis of complex (I)

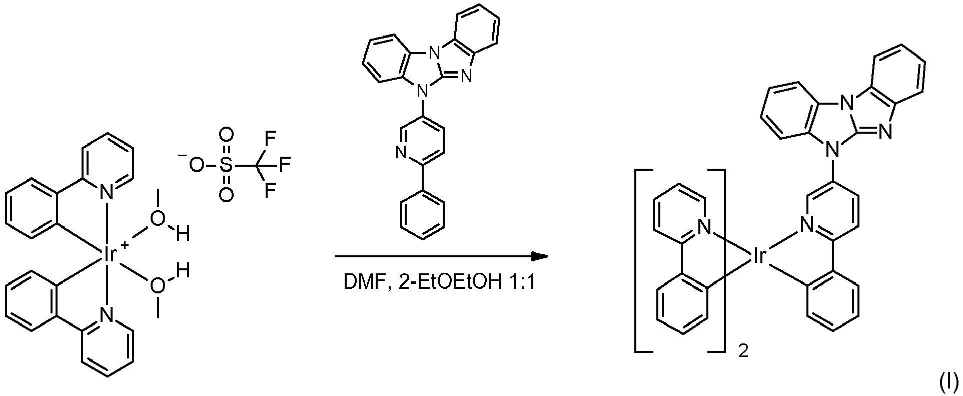

2.05 g (2.9 mmol) of complex intermediate (I-d) were dissolved under argon in 75 ml of *N,N-*dimethylformamide (DMF) and 75 ml of 2-ethoxyethanol. The yellow solution was treated with 3.10 g (8.60 mmol) of 5-(6-phenyl-3-pyridyl)benzimidazolo[1,2-a]benzimidazole, then three times evacuated and backfilled with argon, followed by heating at 129°C during 17 hours. The brownish yellow solution was diluted with 100 ml of ethanol and filtered through a 5 cm layer of silica gel followed by rinsing the silica gel layer with ethanol. A solid was precipitating out of the filtrate which was filtered off, and washed with plenty of ethanol and pentane, followed by drying under vacuum. The solid was further purified two times by MPLC with the *CombiFlash Compan-ion* (silica gel, 0-5% gradient of ethyl acetate), giving the title product as a yellow solid (yield: 0.88 g (35%)).
ESI-MS (positive, m/z): exact mass of C₄₆H₃₁IrN₆ = 860.22; found 861.3 [M+1]⁺.
¹H-NMR (400 MHz, CD₂Cl₂): δ = 6.81-7.05 (m, 11 H), 7.07 (d, 1 H), 7.26 (t, 1 H), 7.30-7.45 (m, 3 H), 7.57-7.89 (m, 10 H), 7.99 (d, 1 H), 8.03 (d, 1 H), 8.15 (d, 1 H), 8,.22 (d, 1 H), 8.41 (dd, 1 H).

### Synthesis Example 2. Synthesis of complex (II)

### a) Synthesis of 4-fluoro-2-phenyl-pyridine

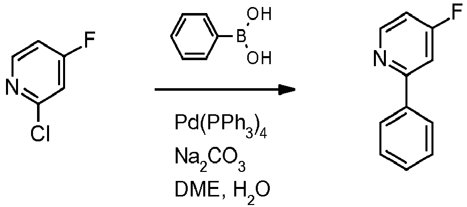

13.1 g (0.10 mol) of 2-chloro-4-fluoropyridine, 12.2 g (0.10 mol) of benzeneboronic acid and

42.4 g (0.40 mol) of sodium carbonate were dissolved in 100 ml of DME and 75 ml of water. The solution was three times evacuated and backfilled with argon, followed by the addition of 1.16 g (1.00 mmol) of tetrakis(triphenylphosphine)palladium(0). The brown emulsion was heated at 83°C during four hours. The reaction mixture was diluted with ethyl acetate, and the organic phase stirred with 100 ml of 5% aqueous NaCN solution during one hour. The organic phase was separated and further washed with water (3x 100 ml), dried over sodium sulfate and concentrated under vacuum. The resulting dark oil was further purified by bulb to bulb distillation (120°C, 0.1 mbar), giving the title product as a colorless oil (yield: 12.1 g (70%)).
ESI-MS (positive, m/z): exact mass of C₁₁H₈FN = 173.06; found 173.9 [M+1]⁺.
¹H-NMR (400 MHz, CD₂Cl₂): δ = 7.04 (ddd, 1 H), 7.46-7.59 (m, 4 H), 8.02-8.11 (m, 2 H), 8.69 (dd, 1 H).

### b) Synthesis of 5-(2-phenyl-4-pyridyl)benzimidazolo[1,2-a]benzimidazole

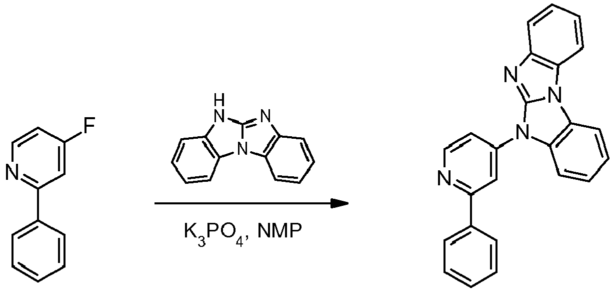

7.60 g (43.9 mmol) of 4-fluoro-2-phenyl-pyridine, 8.29 g (40.0 mmol) of 6H-benzimidazolo[1,2-a]benzimidazole (see synthesis for example in Bull. Soc. Chim. Belges 1987, 96, 787-92, WO2012130709, Org. Lett. 2012, 14, 452, Eur. J. Org. Chem. 2014, 5986-5997, and RSC Advances 2014, 4, 21904-21908), and 34.0 g (0.16 mol) of potassium phosphate were suspended in NMP, followed by heating at 184°C during 45 minutes. The dark suspension was poured into 300 ml of water under vigorous stirring. The solid was separated by filtration and washed with plenty of water, then dried under vacuum, and dissolved in 200 ml of dichloromethane. The clear solution was dried over sodium sulfate first, and the filtered through a 4 cm layer of silica gel, followed by rinsing the silica gel layer with 100 ml of dichloromethane. The combined fractions were concentrated under vacuum, and the resulting solid dissolved in hot ethanol. The solution was cooled down and treated with water until precipitation occurs. The solid was separated by filtration, washed with plenty of water and dried under vacuum, giving 11.1 g of the title product. The product was further purified by MPLC with the *CombiFlash Companion* (silica gel, dichloromethane/0-20% gradient of ethyl acetate), giving the title product as a white solid (yield: 5.73 g (40%)).
ESI-MS (positive, m/z): exact mass of C₂₄H₂₆N₄ = 360.14; found 361.2 [M+1]⁺.
¹H-NMR (400 MHz, CD₂Cl₂): δ = 7.34-7.62 (m, 7 H), 7.80 (d, 1 H), 7.85-7.95 (m, 3 H), 7.98 (dd, 1 H), 8.15-8.22 (m, 2 H), 8.51 (d, 1 H), 8.92 (d, 1 H).

### c) Synthesis of complex (II)

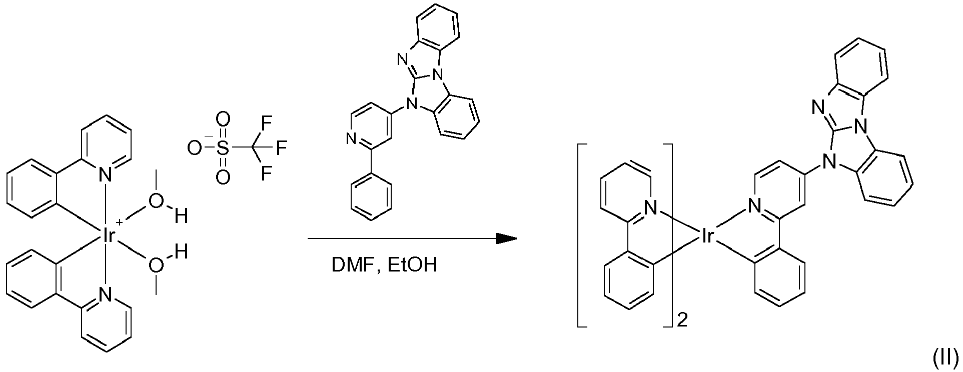

2.37 g (3.32 mmol) of complex intermediate (I-d) and 3.60 g (9.98 mmol) of 5-(2-phenyl-4-pyridyl)benzimidazolo[1,2-a]benzimidazole were suspended under argon in 100 ml of ethanol. The yellow suspension was three times evacuated and backfilled with argon, followed by heating at 76°C during 18 hours. The yellow suspension was cooled down to 50°C, filtered, and the solid washed with plenty of ethanol. The solid was stirred two times in acetone, and two times in ethyl acetate, followed by filtration and drying under vacuum. The solid was further purified by MPLC with the *CombiFlash Companion* (silica gel, dichloromethane/ethyl acetate), giving the title product as a yellow solid (yield: 0.46 g (16%)).
ESI-MS (positive, m/z): exact mass of C₄₆H₃₁IrN₆ = 860.22; found 861.4 [M+1]⁺.
¹H-NMR (400 MHz, CD₂Cl₂): δ = 6.79-7.09 (m, 11 H), 7.34-7.56 (m, 4 H), 7.63-7.88 (m, 10 H), 7.93 (d, 3 H), 7.96-8.07 (m, 2 H), 8.63 (d, 1 H).

### Synthesis Example 3. Synthesis of complex (III)

### a) Synthesis of 4-(trifluoromethyl)-5H-benzimidazolo[1,2-a]benzimidazole

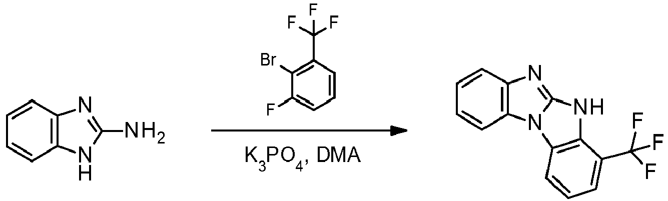

2.66 g (20.0 mmol) of 2-aminobenzimidazole, 4.85 g (20.0 mmol) of 2-bromo-3-fluorobenzotrifluoride, and 12.7 g (59.8 mmol) of potassium phosphate were suspended in 50 ml of DMA, followed by heating at 94°C during two hours, and then at 163°C during four hours. The beige suspension was poured into 200 ml of water. The solid was separated by filtration and washed two times with plenty of acetone, followed by drying under vacuum, giving the title product as a light beige solid (yield: 2.7 g (49%)).
ESI-MS (positive, m/z): exact mass of C₁₄H₈F₃N₃ = 275.07; found 276.1 [M+1]⁺.

### b) Synthesis of 6-(6-chloro-3-pyridyl)-4-(trifluoromethyl)benzimidazolo[1,2-a]benzimidazole

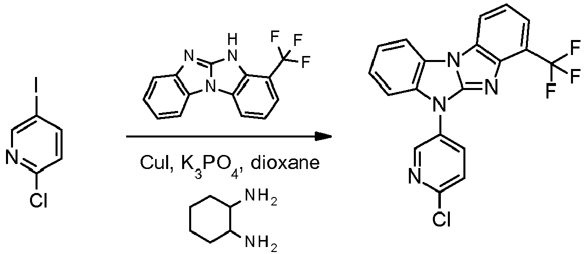

2.6 g (9.4 mmol) of 4-(trifluoromethyl)-5H-benzimidazolo[1,2-a]benzimidazole, 2.7 g (11.3 mmol) of 2-chloro-5-iodopyridine, 6.0 g (28.3 mmol) of potassium phosphate, and 180 mg (0.9 mmol) of copper(I) iodide were suspended in 20 ml of dioxane. The suspension was three times evacuated and backfilled with argon and treated with 7.5 g (65.7 mmol) of 1,2-diaminocyclohexane at 77°C, followed by heating at 104°C during six hours. The hot suspension was filtered and the solid washed with 100 ml of dioxane. The filtrate was cooled down to room temperature, treated with 300 ml of water, and stirred during 15 minutes. The suspension was filtered and the resulting solid dried under vacuum. The solid was further purified by MPLC with the *CombiFlash Companion* (silica gel, heptane/ethyl acetate), giving the title product as a white solid (yield: 1.03 g (28%)).
ESI-MS (positive, m/z): exact mass of C₁₉H₁₀ClF₃N₄ = 386.05; found 387.2 [M+1]⁺.
¹H-NMR (400 MHz, CD₂Cl₂): δ = 7.40-7.55 (m, 3 H), 7.61-7.72 (m, 3 H), 7.92-7.97 (m, 1 H), 8.10 (d, 1 H), 8.34 (dd, 1 H), 9.00 (d, 1 H).

### c) Synthesis of 6-(6-phenyl-3-pyridyl)-4-(trifluoromethyl)benzimidazolo[1,2-a]benzimidazole

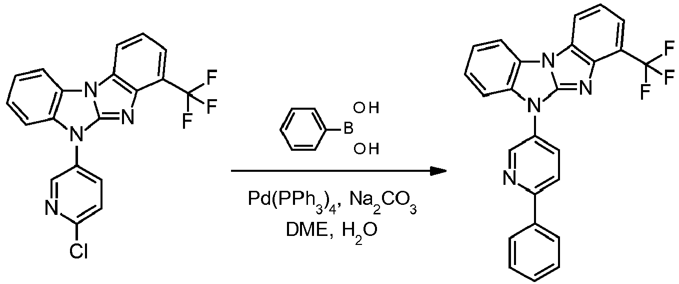

3.2 g (8.3 mmol) of 6-(6-chloro-3-pyridyl)-4-(trifluoromethyl)benzimidazolo[1,2-a]benzimidazole, 1.51 g (12.4 mmol) of benzeneboronic acid, and 3.5 g (33.0 mmol) of sodium carbonate were suspended in 40 ml of DME and 20 ml of water. The light yellow suspension was three times evacuated and backfilled with argon and treated with 190 mg (0.16 mmol) of tetrakis(triphenylphosphine)palladium(0). The light brown suspension was heated at 79°C during four hours, then cooled down to room temperature, treated with water, and filtered. The solid was dissolved in 100 ml of dichloromethane and stirred with 40 ml of 5% aqueous NaCN solution during one hour. The organic phase was washed with water (3x 100 ml) and dried over sodium sulfate. The solution was treated with 50 ml of ethanol and concentrated under vacuum until a suspension was formed. The suspension was filtered, the solid washed with 30 ml of ethanol and dried under vacuum, giving the title product as a white solid (yield: 3.2 g (91%).
ESI-MS (positive, m/z): exact mass of C₂₅H₁₅F₃N₄ = 428.12; found 429.3 [M+1]⁺.
¹H-NMR (400 MHz, CD₂Cl₂): δ = 7.39-7.62 (m, 6 H), 7.66-7.75 (m, 2 H), 7.91-7.99 (m, 1 H), 8.07-8.21 (m, 4 H), 8.38 (dd, 1 H), 9.25 (d, 1 H).

### d) Synthesis of complex (III)

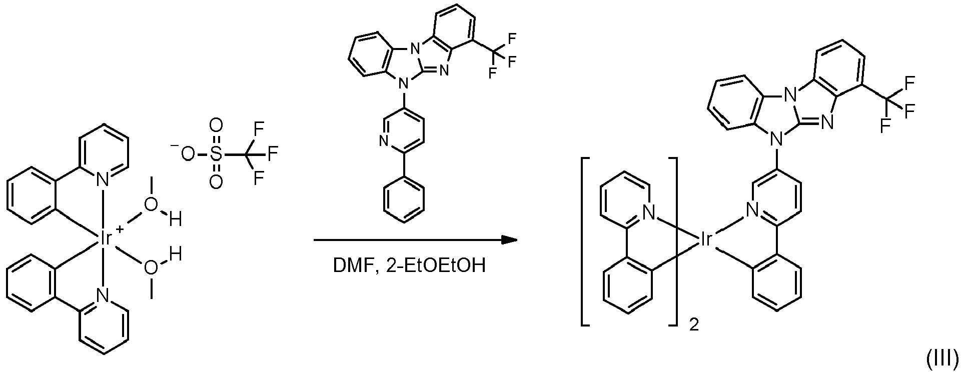

1.72 g (2.4 mmol) of complex intermediate (I-d) were dissolved under argon in 50 ml of DMF and 50 ml of 2-ethoxyethanol. The suspension was treated with 3.10 g (7.24 mmol) of 6-(6-phenyl-3-pyridyl)-4-(trifluoromethyl)benzimidazolo[1,2-a]benzimidazole, then three times evacuated and backfilled with argon, followed by heating at 129°C during 24 hours. The brownish yellow suspension was diluted with 100 ml of ethanol and filtered. The solid was dissolved in dichloromethane and filtered through a 5 cm layer of silica gel followed by rinsing the silica gel layer with a 95:5-mixture of dichloromethane/EtOH. The filtrate was concentrated under vacuum, and the solid further purified by MPLC with the *CombiFlash Companion* (silica gel, dichloromethane), giving the title product as a yellow solid (yield: 0.54 g (24%)).
ESI-MS (positive, m/z): exact mass of C₄₇H₃₀F₃IrN₆ = 928.21; found 929.3 [M+1]⁺.
¹H-NMR (400 MHz, CD₂Cl₂): δ = 6.80-6.93 (m, 7 H), 6.93-7.03 (m, 3 H), 7.06 (t, 1 H), 7.15 (d, 1 H), 7.33 (t, 1 H), 7.38-7.48 (m, 2 H), 7.56 (t, 1 H), 7.65-7.71 (m, 2 H), 7.71-7.83 (m, 4 H), 7.86 (d, 1 H), 7.92-8.02 (m, 3 H), 8.05 (d, 1 H), 8.20 (d, 1 H), 8.23 (d, 1 H), 8.32 (dd, 1 H).

### Synthesis Example 4. Synthesis of complex (IV)

### a) Synthesis of 6-phenylpyridin-3-amine

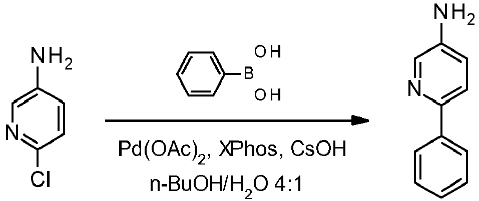

12.9 g (100 mmol) of 5-amino-2-chloropyridine, 18.3 g (150 mmol) of benzeneboronic acid, 0.45 g (2.00 mmol) of palladium(II) acetate, and 1.14 g (2.39 mmol) 2-dicyclohexylphosphino-2',4',6'-triisopropylbiphenyl (= XPhos) were dissolved under argon in 400 ml of n-butanol. The solution was three times evacuated and backfilled with argon and treated with 28.6 g (170 mmol) of cesium hydroxide and 100 ml of degassed water, followed by stirring at room temperature during six hours. The water phase was separated and the residual solution diluted with 100 ml of ethyl acetate. The solution was extracted with water (2x 200 ml), and the organic phase stirred with 100 ml of water and 1 g of NaCN during 30 minutes. The aqueous phase was separated and the organic phase washed with water (2x 200 ml), then dried over sodium sulfate, and concentrated under vacuum. The resulting oil was further purified by MPLC with the *CombiFlash Companion* (silica gel, dichloromethane/0-50% gradient of ethyl acetate), giving the title product as a yellowish oil with a GC-content of the product of 93% (yield: 15.9 g).

### b) Synthesis of N-(6-phenyl-3-pyridyl)-1H-benzimidazol-2-amine

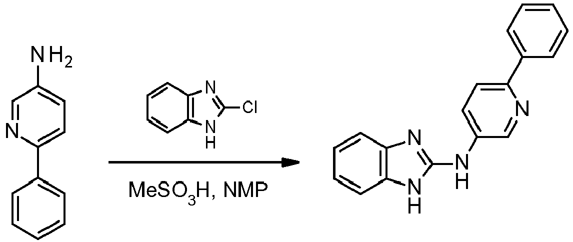

13.5 g (73.8 mmol, GC-content of 93%) of 6-phenylpyridin-3-amine and 10.2 g (66.8 mmol) of 2-chlorobenzimidazole were dissolved in 70 ml of NMP. 7.1 g (73.9 mmol) of methanesulfonic acid were slowly added and the suspension heated at 96°C during 19 hours, and then cooled down to room temperature. Diluted aqueous sodium bicarbonate solution was added slowly until a basic pH was reached. The mixture was diluted under stirring with 100 ml of water first, followed by the addition of 50 ml of ethanol, and stirring continued for one hour. The suspension was filtered and the solid washed with a 50 ml of a 1:2-mixture of ethanol and water. The solid was further washed with heptane (2x 50 ml), then dried under vacuum, giving the title product as a white solid (yield: 14.3 g (74%)).
ESI-MS (positive, m/z): exact mass of C₁₈H₁₄N₄ = 286.12; found 287.3 [M+1]⁺.
¹H-NMR (400 MHz, d₆-DMSO): δ = 6.96-7.10 (br. m, 2 H), 7.27-7.44 (br. s & m, 3 H), 7.47 (t, 2 H), 7.95 (d, 1 H), 8.04 (d, 2 H), 8.49 (dd, 1 H), 8.90 (d, 1 H), 9.79 (s, 1 H), 11.14 (s, 1 H).

### c) Synthesis of 4-methyl-5-(6-phenyl-3-pyridyl)benzimidazolo[1,2-a]benzimidazole

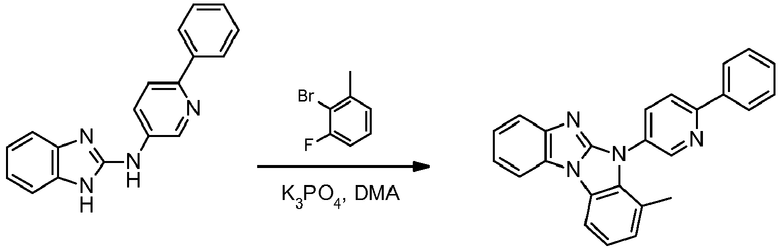

4.00 g (14.0 mmol) of N-(6-phenyl-3-pyridyl)-1H-benzimidazol-2-amine, 3.97 g (21.0 mmol) of 2-bromo-3-fluorotoluene, and 8.90 g (41.9 mmol) of potassium phosphate were suspended under argon in 50 ml of DMA, followed by heating at 92°C during seven hours first, and at 162°C during 24 hours. The dark suspension was cooled down to room temperature and treated with 100 ml water under stirring. The suspension was filtered and the solid washed with plenty of water and ethanol. The resulting solid was further purified by MPLC with the *CombiFlash Companion* (silica gel, dichloromethane/0-8% gradient of ethanol), followed by another MPLC run with the *CombiFlash Companion* (silica gel, dichloromethane/ethyl acetate), giving the title product as a white solid (2.80 g (53%)).
ESI-MS (positive, m/z): exact mass of C₂₅H₁₈N₄ = 374.15; found 375.2 [M+1]⁺.
¹H-NMR (400 MHz, CD₂Cl₂): δ = 2.23 (s, 3 H), 7.18 (d, 1 H), 7.31-7.41 (m, 3 H), 7.49-7.62 (m, 3 H), 7.66-7.72 (m, 1 H), 7.78 (d, 1 H), 7.89-7.95 (m, 1 H), 8.01-8.11 (m, 2 H), 8.14-8.21 (m, 2 H), 8.95 (dd, 1 H).

### d) Synthesis of complex (IV)

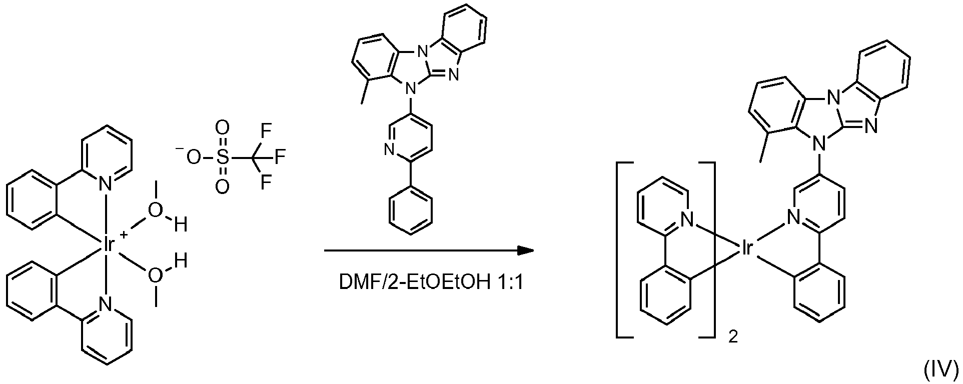

1.7 g (2.4 mmol) of complex intermediate (I-d) were dissolved under argon in 25 ml of DMF and 25 ml of 2-ethoxyethanol. The suspension was treated with 1.8 g (4.8 mmol) of 4-methyl-5-(6-phenyl-3-pyridyl)benzimidazolo[1,2-a]benzimidazole, then three times evacuated and backfilled with argon, followed by heating at 130°C during 20 hours. The brown solution was cooled down to room temperature, diluted with 50 ml of water, followed by stirring during 30 minutes. The suspension was filtered and the solid washed with ethanol (3x 30 ml), followed by drying under vacuum. The solid was further purified by MPLC with the *CombiFlash Companion* (silica gel, dichloromethane/0-5% gradient of ethyl acetate), giving the title product as a yellow solid (yield: 1.33 g (63%)).
ESI-MS (positive, m/z): exact mass of C₄₇H₃₃IrN₆ = 874.24; found 875.4 [M+1]⁺.
¹H-NMR (400 MHz, CD₂Cl₂): δ = 1.72 (br. s, 3 H), 6.75-7.09 (m, 12 H), 7.23-7.40 (m, 3 H), 7.49 (dt, 1 H), 7.55 (d, 1 H), 7.63-7.78 (m, 6 H), 7.79-7.91 (m, 4 H), 7.95-8.03 (m, 2 H), 8.17 (d, 1 H).

### Synthesis Example 5. Synthesis of complex (V)

### a) Synthesis of 5-(6-phenyl-3-pyridyl)-4-(trifluoromethyl)benzimidazolo[1,2-a]benzimidazole

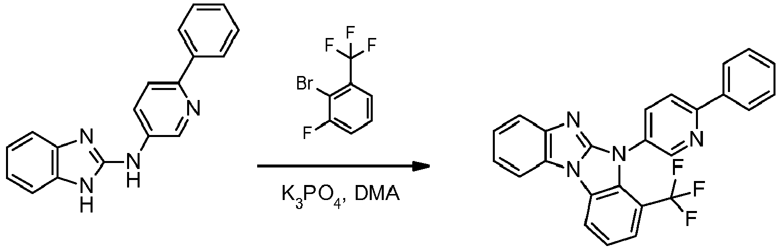

4.0 g (14 mmol) of *N*-(6-phenyl-3-pyridyl)-1H-benzimidazol-2-amine (see IV-c), 3.4 g (14 mmol) of 2-bromo-fluorobenzotrifluoride, and 8.9 g (42 mmol) of potassium phosphate were suspended in 50 ml of DMA, followed by heating at 131°C during four hours. The yellow suspension was cooled down and 100 ml of water were added. The suspension was filtered and the solid washed several times with water and ethanol. The resulting solid was stirred in 50 ml of ethanol under reflux, and the suspension cooled down and filtered. The solid was further purified by MPLC with the *CombiFlash Companion* (silica gel, dichloromethane/0-10% gradient of ethyl acetate), giving the title product as a white solid (yield: 2.4 g (39%)).
ESI-MS (positive, m/z): exact mass of C₂₅H₁₅F₃N₄ = 428.12; found 429.3 [M+1]⁺.
¹H-NMR (400 MHz, CD₂Cl₂): δ = 7.35-7.45 (m, 2 H), 7.51-7.62 (m, 4 H), 7.66-7.73 (m, 2 H), 7.92-7.98 (m, 1 H), 7.99-8.07 (m, 2 H), 8.12 (d, 1 H), 8.15-8.21 (m, 2 H), 8.87 (br. s, 1 H).

### b) Synthesis of complex (V)

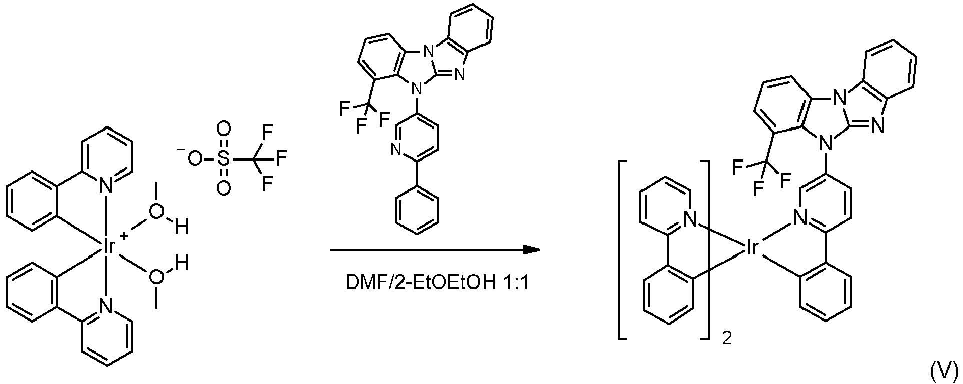

2.07 g (2.90 mmol) of complex intermediate (I-d) were dissolved under argon in 30 ml of DMF and 30 ml of 2-ethoxyethanol. The suspension was treated with 2.5 g (5.8 mmol) of 5-(6-phenyl-3-pyridyl)-4-(trifluoromethyl)benzimidazolo[1,2-a]benzimidazole, then three times evacuated and backfilled with argon, followed by heating at 129°C during 20 hours. The brown solution was cooled down to room temperature and diluted with 100 ml of ethanol, followed by stirring during 30 minutes. The suspension was filtered and the solid washed with ethanol (3x 30 ml). The solid was further purified two times by MPLC with the *CombiFlash Companion* (silica gel, dichloromethane/0-5% gradient of ethyl acetate), followed by another purification run by MPLC (silica gel, dichloromethane/0-2% gradient of ethanol), giving the title product as a yellow solid (yield: 1.02 g (38%)).
ESI-MS (positive, m/z): exact mass of C₄₇H₃₀F₃IrN₆ = 928.21; found 929.5 [M+1]⁺.
¹H-NMR (400 MHz, CD₂Cl₂): δ = 6.72-7.04 (m, 10 H), 7.09 (broad signal, 1 H), 7.31-7.43 (m, 2 H), 7.44-7.58 (m, 3 H), 7.59-7.94 (m, 11 H), 7.98 (d, 1 H), 8.05 (d, 1 H), 8.19 (d, 1 H).

### Synthesis Example 6. Synthesis of complex (VI)

### a) Synthesis of 4-methyl-6-phenyl-pyridin-3-amine

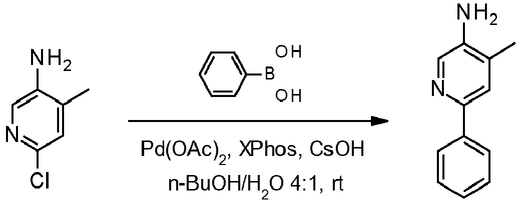

28.5 g (0.20 mol) of 5-amino-2-chloro-4-methylpyridine, 36.6 g (0.30 mol) of benzeneboronic acid, 0.9 g (4.0 mmol) of palladium(II) acetate, and 2.28 g (4.78 mmol) XPhos were dissolved under argon in 600 ml of n-butanol. The solution was three times evacuated and backfilled with argon and treated with 57.1 g (0.34 mol) of cesium hydroxide and 200 ml of degassed water, followed by stirring at room temperature during 22 hours. The water phase was separated and the residual phase diluted with 100 ml of ethyl acetate. The solution was extracted with water (2x 200 ml), and the organic phase stirred with 100 ml of water and 1 g of NaCN during one hour. The aqueous phase was separated and the organic phase washed with water (2x 200 ml), then dried over sodium sulfate, and concentrated under vacuum. The solid was dissolved in 50 ml of dichloromethane, and 200 ml of heptane were added. The solution was concentrated under vacuum until a suspension was formed. The suspension was filtered and the solid washed with heptane followed by drying under vacuum, giving the title compound as a white solid (yield: 24.6 g (67%)).
ESI-MS (positive, m/z): exact mass of C₁₂H₁₂N₂ = 184.10; found 185.2 [M+1]⁺.
¹H-NMR (400 MHz, CD₂Cl₂): δ = 2.27 (s, 3 H), 3.77 (br. s, 2 H), 7.32-7.38 (m, 1 H), 7.41-7.48 (m, 2 H), 7.50 (s, 1 H), 7.92-7.98 (m, 2 H), 8.11 (s, 1 H).

### b) Synthesis of N-(4-methyl-6-phenyl-3-pyridyl)-1H-benzimidazol-2-amine

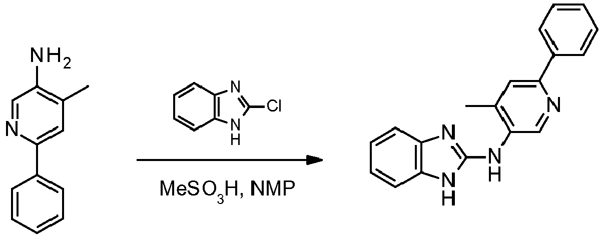

10.1 g (54.8 mmol) of 4-methyl-6-phenyl-pyridin-3-amine and 7.63 g (50.0 mmol) of 2-chlorobenzimidazole were dissolved in 100 ml of NMP. 5.28 g (54.9 mmol) of methanesulfonic acid were slowly added and the suspension heated at 104°C during 24 hours, and then cooled down to room temperature. Diluted aqueous sodium bicarbonate solution was added slowly until a basic pH was reached. The mixture was diluted under stirring with 100 ml of water first, followed by additional dilution with 50 ml of ethyl acetate. The suspension was filtered and the solid washed with water and ethanol, followed by drying under vacuum. The solid was further stirred in a mixture of dichloromethane and heptane, followed by filtration and drying, giving the title compound as a white solid (yield: 6.4 g (43%)).
ESI-MS (positive, m/z): exact mass of C₁₉H₁₆N₄ = 300.14; found 301.3 [M+1]⁺.
¹H-NMR (400 MHz, d₆-DMSO): δ = 2.39 (t, 3 H), 6.96-7.05 (m, 2 H), 7.29-7.36 (m, 2 H), 7.39 (t, 1 H), 7.48 (t, 2 H), 7.86 (s, 1 H), 7.86 (s, 1 H), 8.08 (d, 2 H), 8.74 (br. s, 1 H), 9.35 (s, 1 H), 10.98 (br. s, 1 H).

### c) Synthesis of 5-(4-methyl-6-phenyl-3-pyridyl)benzimidazolo[1,2-a]benzimidazole

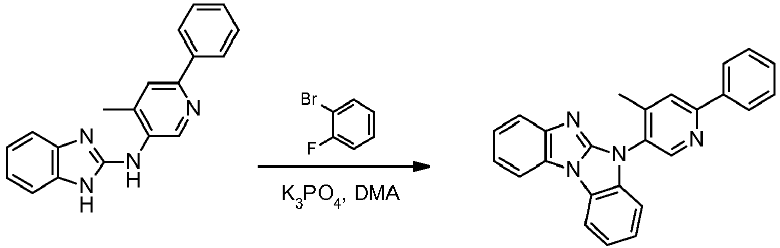

2.4 g (8.0 mmol) of N-(4-methyl-6-phenyl-3-pyridyl)-1H-benzimidazol-2-amine, 1.4 g (8.0 mmol) of 1-bromo-2-fluorobenzene, and 5.1 g (24 mmol) of potassium phosphate were suspended in 50 ml of DMA, followed by heating at 164°C during 12 hours. The dark suspension was filtered and washed with a small amount of DMA. The filtrate was treated with 50 ml of water first, and the mixture extracted with ethyl acetate (100 ml). The organic phase was washed with water (3x 100 ml), dried over sodium sulfate and concentrated under vacuum. The resulting solid was further dried under vacuum, giving the title compound as a white solid (yield: 2.05 g (68%)).
ESI-MS (positive, m/z): exact mass of C₂₅H₁₈N₄ = 374.15; found 375.2 [M+1]⁺.
¹H-NMR (400 MHz, CD₂Cl₂): δ = 2.40 (s, 3 H), 7.23 (d, 1 H), 7.33-7.49 (m, 4 H), 7.50-7.61 (m, 3 H), 7.68-7.73 (m, 1 H), 7.91-7.99 (m, 3 H), 8.12-8.19 (m, 2 H), 8.81 (s, 1 H).

### d) Synthesis of complex (VI)

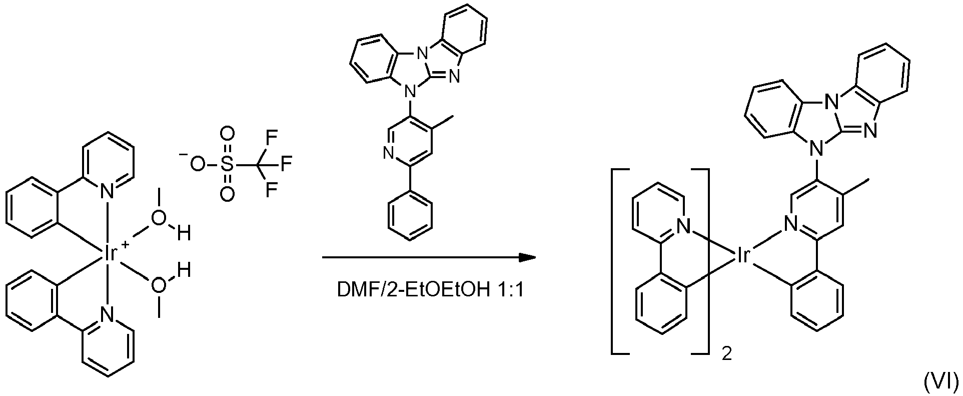

1.78 g (2.49 mmol) of complex intermediate (I-d) were dissolved under argon in 30 ml of DMF and 30 ml of 2-ethoxyethanol. The suspension was treated with 1.9 g (5.1 mmol) of 5-(4-methyl-6-phenyl-3-pyridyl)benzimidazolo[1,2-a]benzimidazole, then three times evacuated and backfilled with argon, followed by heating at 129°C during 23 hours. The slightly turbid brown solution was cooled down to room temperature and diluted with 100 ml of water. The suspension was filtered and the solid washed with ethanol. The solid was further purified by MPLC with the *CombiFlash Companion* (silica gel, dichloromethane/0-35% gradient of heptane), followed by a second purification run by MPLC (silica gel, dichloromethane/0-2% gradient of ethyl acetate), and a third purification run by MPLC (silica gel, dichloromethane/2% of ethyl acetate). The resulting solid was dissolved in 30 ml of dichloromethane and 30 ml of ethanol were added. The solution was concentrated under vacuum until a suspension was formed. The suspension was filtered and the solid washed with ethanol, followed by drying under vacuum, giving the title product as a yellow solid (yield: 0.78 g (36%)).
ESI-MS (positive, m/z): exact mass of C₄₇H₃₃IrN₆ = 874.24; found 875.4 [M+1]⁺.
¹H-NMR (400 MHz, CD₂Cl₂): δ = 2.48 (s, 3 H), 6.51 (d, 1 H), 6.68-6.75 (m, 1 H), 6.79-7.08 (m, 10 H), 7.22-7.30 (m, 1 H), 7.30-7.52 (m, 5 H), 7.60-7.92 (m, 9 H), 7.92-8.09 (m, 3 H).

### Synthesis Example 7. Synthesis of complex (VII)

### a) Synthesis of 4-methyl-5-(4-methyl-6-phenyl-3-pyridyl)benzimidazolo[1,2-a]benzimidazole

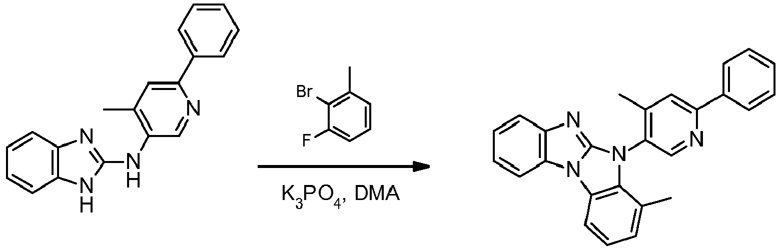

2.0 g (6.7 mmol) of N-(4-methyl-6-phenyl-3-pyridyl)-1H-benzimidazol-2-amine (see VI-b), 1.89 g (10.0 mmol) of 2-bromo-3-fluorotoluene, and 4.3 g (20 mmol) of potassium phosphate were suspended in 50 ml of DMA, followed by heating first at 92°C during three hours, and then at 164°C during 19 hours. The suspension was treated with 50 ml of water first, then filtered, and the resulting solid washed with water and plenty of ethanol. The solid was further purified by MPLC with the *CombiFlash Companion* (silica gel, dichloromethane/0-26% gradient of ethyl acetate), giving the title product as a white solid (yield: 1.05 g (40%)).
ESI-MS (positive, m/z): exact mass of C₂₆H₂₀N₄ = 388.17; found 389.3 [M+1]⁺.
¹H-NMR (400 MHz, CD₂Cl₂): δ = 2.12 (s, 3 H), 2.36 (s, 3 H), 7.15 (d, 1 H), 7.30-7.42 (m, 3 H), 7.49-7.62 (m, 3 H), 7.64-7.70 (m, 1 H), 7.80 (d, 1 H), 7.88-7.98 (m, 2 H), 8.12-8.21 (m, 2 H), 8.75 (s, 1 H).

### b) Synthesis of complex (VII)

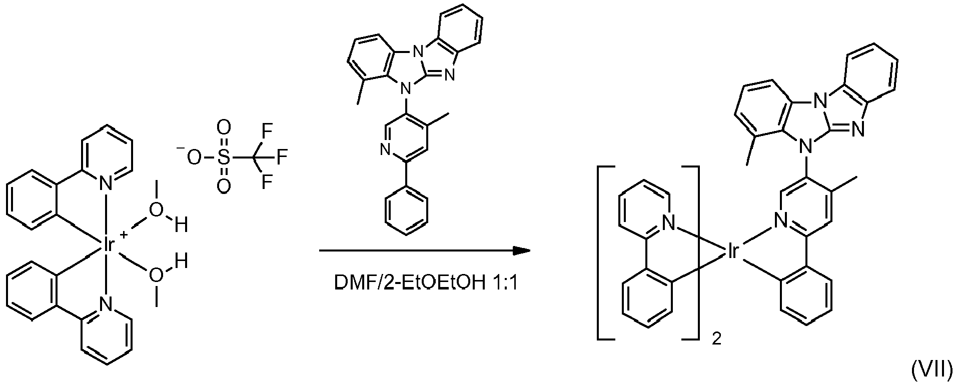

2.57 g (3.60 mmol) of complex intermediate (I-d) were dissolved under argon in 50 ml of DMF and 50 ml of 2-ethoxyethanol. The suspension was treated with 2.8 g (7.2 mmol) of 4-methyl-5-(4-methyl-6-phenyl-3-pyridyl)benzimidazolo[1,2-a]benzimidazole, then three times evacuated and backfilled with argon, followed by heating at 131°C during 19 hours. The brown solution was cooled down to room temperature, diluted with 150 ml of ethanol and the mixture stirred during one hour. The suspension was filtered, the solid washed with 200 ml of ethanol, followed by MPLC-purification with the *CombiFlash Companion* (silica gel, dichloromethane/0-2% gradient of ethyl acetate). The resulting solid was dissolved in 100 ml of dichloromethane and 50 ml of ethyl acetate and concentrated until a suspension was formed. The suspension was filtered and the solid washed with ethanol and heptane. The solid was dissolved in hot DMF and 50 ml of ethanol were added. The solution was cooled down and the suspension stirred at room temperature during 30 minutes. The suspension was filtered and the solid dried under vacuum, giving the title product as a yellow solid (yield: 0.98 g (31%)).
ESI-MS (positive, m/z): exact mass of C₄₈H₃₅IrN₆ = 888.26; found 889.5 [M+1]⁺.
¹H-NMR (400 MHz, CD₂Cl₂): δ = 1.24 (s, 3 H), 2.34 (s, 3 H), 6.68-6.90 (m, 7 H), 6.90-7.03 (m, 4 H), 7.04-7.10 (m, 1 H), 7.24 (t, 1 H), 7.28-7.52 (m, 4 H), 7.55 (s, 1 H), 7.63-7.76 (m, 5 H), 7.80 (d, 2 H), 7.86 (d, 1 H), 7.94-8.04 (m, 3 H).

### Comparative Synthesis Example 1. Synthesis of comparative complex (CC-1)

### a) Synthesis of 9-(6-chloro-3-pyridyl)carbazole

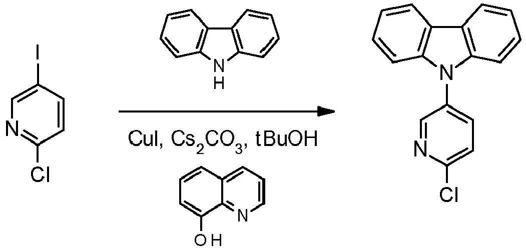

9.20 g (55.0 mmol) of carbazole, 12.0 g (50.1 mmol) of 2-chloro-5-iodopyridine, 1.09 g (7.51 mmol), 24.4 g (74.9 mmol) of cesium carbonate, 0.95 g (5.0 mmol) of copper(I) iodide, and 1.09 g (7.50 mmol) of 8-hydroxyquinoline were suspended under argon in 75 ml of *tert*-butanol. The suspension was heated at 83°C during 23 hours, then cooled down to room temperature and diluted with 150 ml of dichloromethane. The suspension was filtered and the remaining solid washed with dichloromethane. The filtrate solution was diluted with 200 ml of ethyl acetate followed by concentration under vacuum until almost all dichloromethane has been removed. The suspension was stirred at room temperature during 30 minutes, then filtered, and the solid washed with ethyl acetate, followed by drying under vacuum, giving the title product as a white solid (yield: 10.5 g (76%)).
ESI-MS (positive, m/z): exact mass of C₁₇H₁₁ClN₂ = 278.06; found 279.3 [M+1]⁺.
¹H-NMR (400 MHz, CD₂Cl₂): δ = 7.34-7.45 (m, 4 H), 7.45-7.54 (m, 2 H), 7.65 (d, 1 H), 7.95 (dd, 1 H), 8.20 (d, 2 H), 8.70 (d, 1 H).

### b) Synthesis of 9-(6-phenyl-3-pyridyl)carbazole

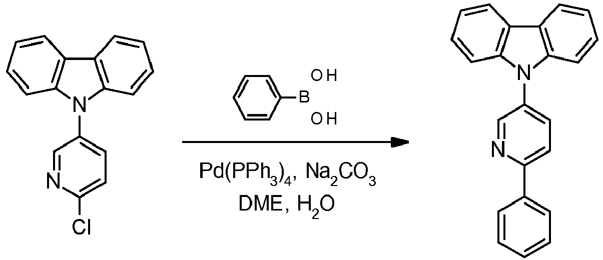

5.00 g (17.9 mmol) of 9-(6-chloro-3-pyridyl)carbazole, 3.28 g (26.9 mmol) of benzeneboronic acid, and 7.6 g (71.7 mmol) of sodium carbonate were suspended in 80 ml of DME and 40 ml of water. The yellowish suspension was three times evacuated and backfilled with argon, followed by the addition of 207 mg (0.18 mmol) of tetrakis(triphenylphosphine)palladium(0). The reaction mixture was heated at 78°C during 31 hours. The brown biphasic solution was cooled down and treated with water, followed by filtration. The solid was dried under vacuum first, then dissolved in 50 ml of dichloromethane and 50 ml of ethanol. The solution was concentrated under vacuum until almost all dichloromethane has been removed. The suspension was filtered and the solid washed with ethanol, giving the title product as a white solid (yield: 4.48 g (79%)).
ESI-MS (positive, m/z): exact mass of C₂₃H₁₆N₂ = 320.13; found 321.3 [M+1]⁺.
¹H-NMR (400 MHz, CD₂Cl₂): δ = 7.34-7.42 (m, 2 H), 7.46-7.64 (m, 7 H), 8.00-8.10 (m, 2 H), 8.15-8.26 (m, 4 H), 8.98 (d, 1 H).

### c) Synthesis of comparative complex (CC-1)

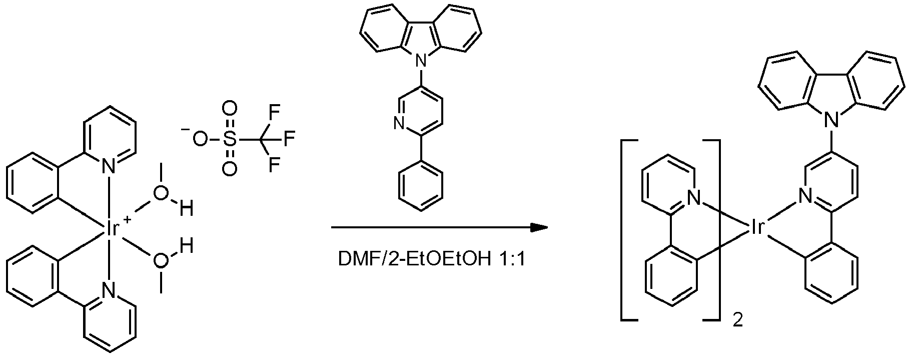

3.2 g (4.5 mmol) of complex intermediate (I-d) were dissolved under argon in 70 ml of DMF and 70 ml of 2-ethoxyethanol. The suspension was treated with 4.3 g (13.4 mmol) of 9-(6-phenyl-3-pyridyl)carbazole, then three times evacuated and backfilled with argon, followed by heating at 132°C during eight hours. The solution was cooled down to room temperature and treated with 350 ml of methanol, followed by stirring during 30 minutes. The suspension was filtered and the solid washed with plenty of methanol and ethanol giving a first batch of crude product (1.2 g). The filtrate was treated with water until a suspension formed, then filtered, and the solid washed with ethanol, giving a second batch of crude product (1.6 g). The two batches were further purified by MPLC-purification with the *CombiFlash Companion* (silica gel, heptane/ethyl acetate 4:1), giving the title product as a yellow solid (yield: 1.41 g (38%)).
ESI-MS (positive, m/z): exact mass of C₄₅H₃₁IrN₄ = 820.22; found 821.3 [M+1]⁺.
¹H-NMR (400 MHz, CD₂Cl₂): δ = 6.74-6.81 (m, 1 H), 6.83-7.06 (m, 10 H), 7.21 (d, 2 H), 7.28-7.36 (m, 2 H), 7.38-7.45 (m, 2 H), 7.46-7.57 (m, 2 H), 7.69-7.89 (m, 6 H), 7.92-8.03 (m, 3 H), 8.08-8.19 (m, 3 H).

### II. CV Examples

### Determination of HOMO/LUMO values from CV measurement

The oxidation/ reduction potentials were measured in DMF solution (1.0 mM) containing 0.1M of n -Bu₄NPF₆ as a supporting electrolyte at a scan rate of 100 mV/s. A glassy carbon electrode and a platinum wire were used as working and counter electrodes, respectively and Ag/AgCl was used as reference electrode. As referred to the reversible oxidation potential of ferro-cene/ferrocenium (Fc/Fc⁺) redox couple, the HOMO (from the onset oxidation potential) and LUMO (from the half-potential) energy levels were estimated according to the equation of Forrest (P. I. Djurovich et al., Org. Electronics 2009, 10, 515-520; B. W. D'Andrade et al., Org. Electronics 2005, 6, 11-20).

**Table 1**

| **Cpd.** | **Formula** | **HOMO, eV** | **LUMO, eV** |
|---|---|---|---|
| **I** | 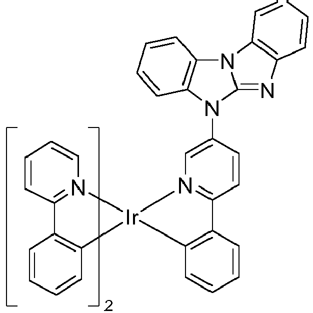 | -5.07 | -1.75 |
| | | | |
| **CC-1** | 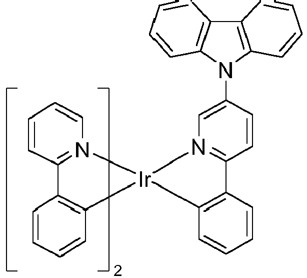 | -5.23 | -1.85 |
| **CC-2** | 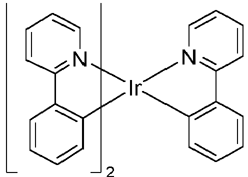 | -5.05 | -1.58 |
| **CC-3** | 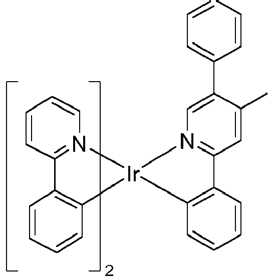 | -5.05 | -1.63 |

As evident from the above table, the inventive metal complex **I** shows surprisingly higher-lying HOMO/LUMO levels than the comparative compound **CC-1,** with a difference of 0.2 eV in the HOMO-level, and difference of 0.1 eV in the LUMO-level, although both compounds are carrying a nitrogen donor at the same position of the cycolometallating pyridine unit.
The HOMO level of the inventive metal complex **I** is comparable to the comparative examples **CC-2** and **CC-3** without nitrogen substitution at the pyridine unit, whereas the comparative complex CC-1 is significantly lower-lying.
As is evident from the device examples below difference HOMO/LUMO levels of the inventive metal complex **I** and the comparative compound **CC-1** is observed at the same CIE x,y color coordinates.

### III Device Examples

### Production of an OLED (general procedure)

A glass substrate with 120 nm-thick indium-tin-oxide (ITO) transparent electrode (manufactured by Geomatec Co., Ltd.) used as an anode is first cleaned with isopropanol in an ultrasonic bath for 10 min. To eliminate any possible organic residues, the substrate is exposed to an ultraviolet light and ozone for further 30 min. This treatment also improves the hole injection properties of the ITO. The cleaned substrate is mounted on a substrate holder and loaded into a vacuum chamber. Thereafter, the organic materials specified below are applied by vapor deposition to the ITO substrate at a rate of approx. 0.2-1 Å/sec at about 10⁻⁶ -10⁻⁸ mbar. As a hole injection layer, 5 nm-thick of compound A is applied. Then 100 nm-thick of compound B is applied as a first hole transporting layer and 60nm-thick of Compound C is applied as a second hole transporting layer on the first hole transporting layer. Subsequently, 5% by weight of the inventive compound I as an emitter, 47.5% by weight of Compound D as a first host and 47.5% by weight of Compound E as a second host are applied to form a 40 nm-thick phosphorescent-emitting layer. On the emitting layer, 30 nm-thick 50% by weight of compound F and 50% by weight of Liq are applied as an electron transport layer. Finally, 1 nm-thick Liq is deposited as an electron injection layer and 80 nm-thick Al is then deposited as a cathode to complete the device. The device is sealed with a glass lid and a getter in an inert nitrogen atmosphere with less than 1 ppm of water and oxygen.

### Compound A

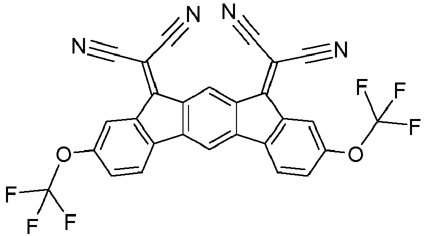

### Compound B

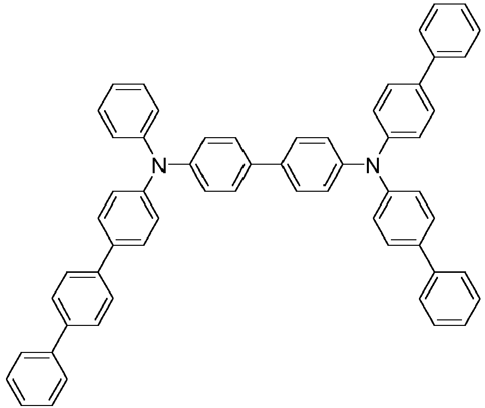

### Compound C

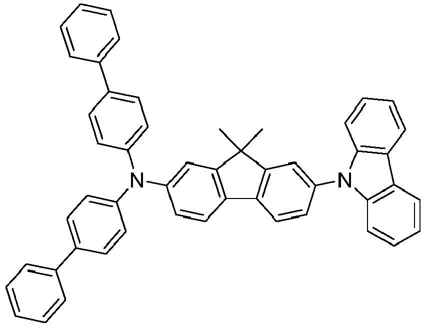

### Compound D

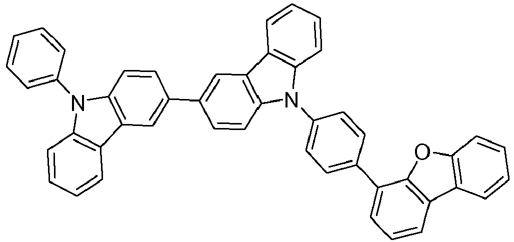

### Compound E

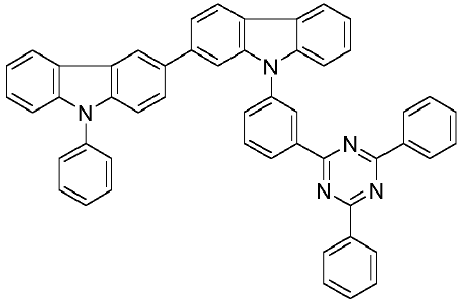

### Compound F

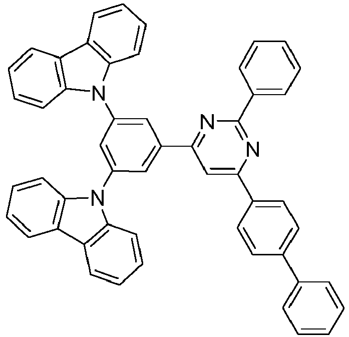

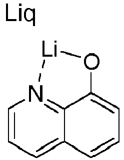

Inventive emitter example I and comparative example **CC-1, CC-2 and CC-3** were used to demonstrate the superior efficiency of the device with inventive vs. comparative compounds at the same color coordinates CIE x,y. The device external quantum efficiency (EQE) and current efficiency (CE) measured at 10 mA/cm² are shown in the Table 2 and 3.

### Device 1:

120nm ITO - 5nm **A** - 100nm **B** - 60 nm **C** - 40nm **D/E**/emitter (w/w) (47.5:47.5:5) - 30nm LiQ:**F** (w/w) (50:50) - 1nm LiQ - 80nm Al

**Table 2**

| Emitter | CE [cd/A] | EQE [%] | CIE x, y |
|---|---|---|---|
| **I** | 72.2 | 19.3 | 0.36, 0.61 |
| **CC-1** | 67.6 | 18.0 | 0.37, 0.61 |
| **CC-2** | 59.5 | 16.5 | 0.31, 0.63 |
| **CC-3** | 65.0 | 17.6 | 0.33, 0.63 |

As is evident from the above table the observed device EQE and CE of inventive emitter **I** are significantly higher vs. comparative emitter **CC-1, CC-2 and CC-3** at comparable CIE x,y color coordinates.

## Claims

1. A metal complex comprising at least one ligand of formulae (IA), (IB) or (IC) 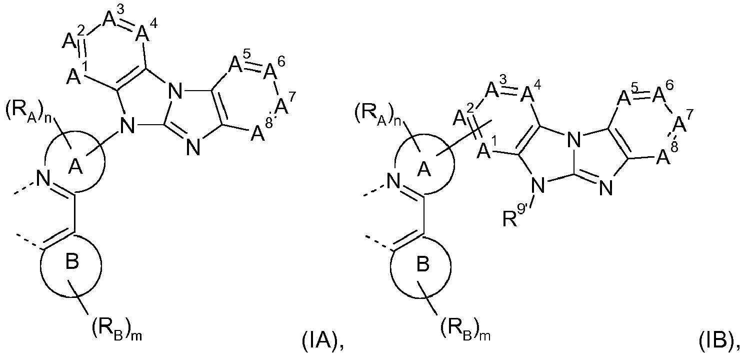 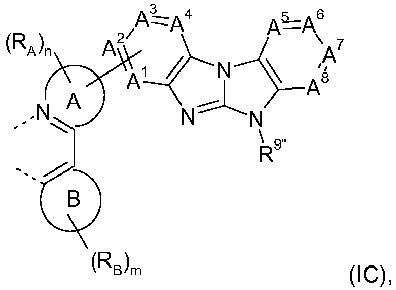 preferably of formula (IA),
wherein
ring A is a heterocyclic group having 5 to 30 ring atoms, preferably a five or six membered heterocyclic ring, more preferably a five or six membered heteroaromatic ring,
ring B is an aromatic hydrocarbon group having 6 to 30 ring atoms, preferably an aromatic hydrocarbon group having 5 or 6 ring carbon atoms or a heterocyclic group having 5 to 30 ring atoms, preferably a heterocyclic group having 5 or 6 ring atoms, more preferably a heteroaromatic group having 6 ring atoms,
wherein A-B represents a bonded pair of hydrocarbon or heterocyclic rings coordinated to the metal via a nitrogen atom on ring A and via an sp² hybridized carbon atom on ring B, R_{A} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 carbon atoms, a substituted or unsubstituted heterocyclic group having 5 to 30 ring atoms, CN, an -OR^{c'} group, an -SR^{c'} group or an SiR^{d'}R^{e'}R^{f'} group;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
n is 0, 1 or 2, preferably 0 or 1,
R_{B} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, a substituted or unsubstituted heterocyclic group having 5 to 30 ring atoms, CN, an -OR^{c'} group, an -SR^{c'} group, an SiR^{d'}R^{e'}R^{f'} group or NR^{c'}R^{d'};
and one of R_{B} may be -SR^{c'}, -OR^{c'} or -NR^{c'}R^{d'},
one of R_{A} and one of R_{B} may be connected to each other and form a bridge, for example 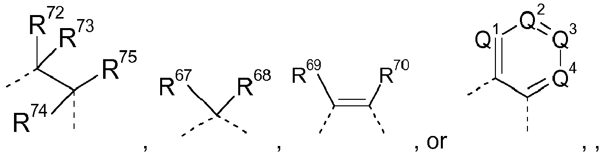 preferably 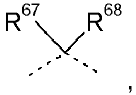 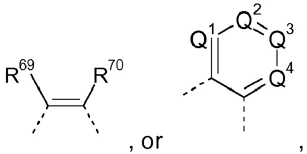 wherein
R⁶⁷, R⁶⁸, R⁶⁹, R⁷⁰ R⁷², R⁷³, R⁷⁴ and R⁷⁵ are each independently hydrogen, deuterium, C₁-C₄-alkyl, C₁-C₄-haloalkyl, substituted or unsubstituted phenyl, or substituted or unsubstituted heteroaryl having 5 or 6 ring atoms;
Q¹, Q², Q³ and Q⁴ are each independently CR⁷¹ or N, wherein preferably 0 or 1 group Q¹, Q², Q³ or Q⁴ are N and the remaining groups Q¹, Q², Q³ and Q⁴ are CR⁷¹;
R⁷¹ is hydrogen, deuterium, C₁-C₄-alkyl, C₁-C₄-fluoroalkyl, substituted or unsubstituted phenyl, or substituted or unsubstituted heteroaryl having 5 or 6 ring atoms;
m is 0, 1, 2 or 3, preferably 0, 1 or 2,
in the case that m is ≥ 2, two adjacent residues R_{B} may form together a ring, preferably a five or six membered ring, which is unsubstituted or substituted and may be fused with one or more, preferably one, further unsubstituted or substituted carbocyclic or heterocyclic five or six membered ring,
A¹ is CR¹ or N, A² is CR² or N, A³ is CR³ or N, A⁴ is CR⁵ or N, A⁵ is CR⁵ or N, A⁶ is CR⁶ or N, A⁷ is CR⁷ or N and A⁸ is CR⁸ or N, whereby preferably 0, 1 or 2, more preferably 0 or 1, most preferably 0 of A¹ to A⁸ are N,
wherein - in formula (IB) and (IC) A¹, A², A³ and A⁴ is CR¹, CR², CR³ respectively CR⁴, wherein one of R¹, R², R³ respectively R⁴ is a bonding site to the ring A,
R¹, R², R³, R⁴, R⁵, R⁶, R⁷ and R⁸ are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted heterocyclic group, having 5 to 30 ring atoms, CN, an -OR^{c'} group, an -SR^{c'} group or an SiR^{d'}R^{e'}R^{f'} group; provided that, two substituents selected from R¹, R², R³, R⁴ respectively from R⁵, R⁶, R⁷ and R⁸ may be bonded to each other to form a ring structure,
R^{9'}, R^{9"} are each independently a substituted or unsubstituted aromatic hydrocarbon group having 6 to 30 ring carbon atoms, or a substituted or unsubstituted heterocyclic group having 5 to 30 ring atoms, and
the metal is selected from Ir and Pt,
wherein the dotted lines are bonding sites.

2. The metal complex according to claim 1 comprising at least one ligand of formulae (IA-1), (IA-2), (IB-1), (IB-2), (IC-1) or (IC-2), preferably (IA-1) or (IA-2), 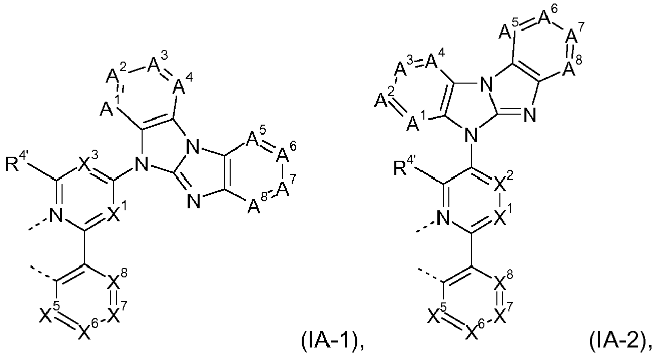 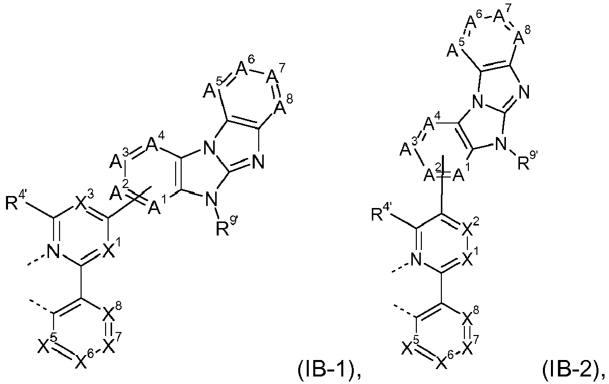 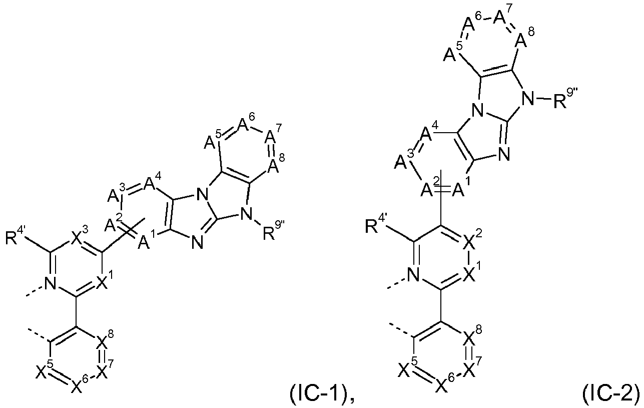 wherein
X¹ is CH or N, X² is CR^{2'} or N, X³ is CR^{3'} or N, X⁵ is CR^{5'} or N, X⁶ is CR^{6'} or N, X⁷ is CR^{7'} or N and X⁸ is CH or N, wherein 0, 1 or 2, preferably 0 or 1, more preferably 0 of X¹ to X8are N
X¹ and X⁸ may be connected to each other via a bridge, for example 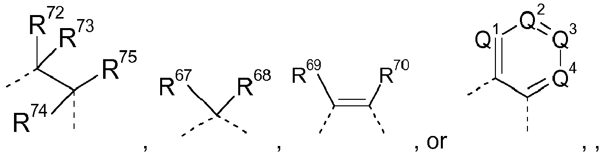 preferably 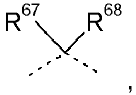 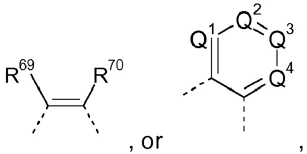 wherein
R⁶⁷, R⁶⁸, R⁶⁹, R⁷⁰, R⁷², R⁷³, R⁷⁴ and R⁷⁵ are each independently hydrogen, deuterium, C₁-C₄-alkyl, C₁-C₄-haloalkyl, substituted or unsubstituted phenyl, or substituted or unsubstituted heteroaryl having 5 or 6 ring atoms;
Q¹, Q², Q³ and Q⁴ are each independently CR⁷¹ or N, wherein preferably 0 or 1 group Q¹, Q², Q³ or Q⁴ are N and the remaining groups Q¹, Q², Q³ and Q⁴ are CR⁷¹;
R⁷¹ is hydrogen, deuterium, C₁-C₄-alkyl, C₁-C₄-fluoroalkyl, substituted or unsubstituted phenyl, or substituted or unsubstituted heteroaryl having 5 or 6 ring atoms;
wherein X⁵ and X⁶, X⁶ and X⁷ or X⁷ and X⁸ may together form a ring structure R^{2'} and R^{3'} are each independently defined as R_{A},
R^{4'} is H or C₁-C₄-alkyl, preferably H,
and
R^{5'}, R^{6'} and R^{7'} are each independently defined as R^{B}, preferably, R^{5'} is H,
wherein one of R^{2'} and R^{3'} is a bonding site,
wherein the dotted lines are bonding sites.

3. The metal complex according to claim 1 or 2 comprising at least one ligand of formulae (IA-1a), (IA-1b), preferably (IA-1b1), (IB-1a), (IB-1b), preferably (1B-1b1), (IC-1a), (IC-1b), preferably (IC-1b1), (IA-2a), (IA-2b), preferably (IA-2b1), (IB-2a), (IB-2b), preferably (1B-2b1), or (IC-2a), (IC-2b), preferably (IC-2b1) 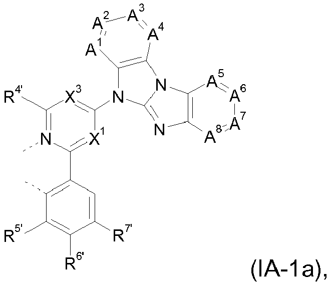 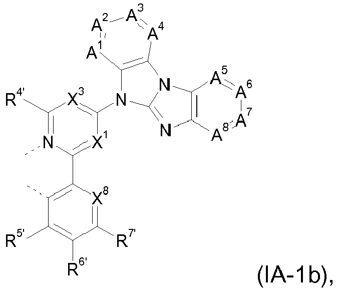 preferably 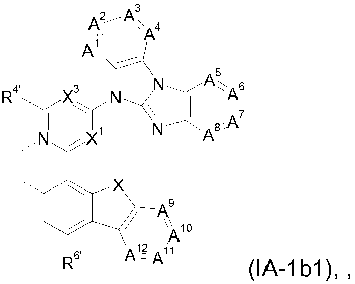 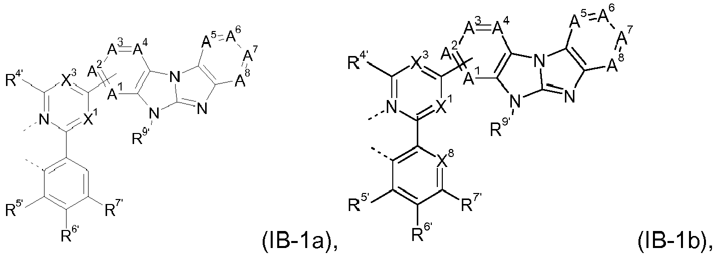 preferably 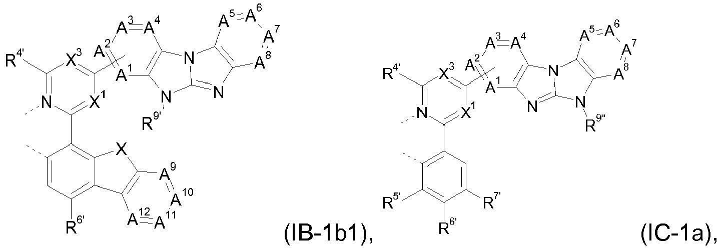 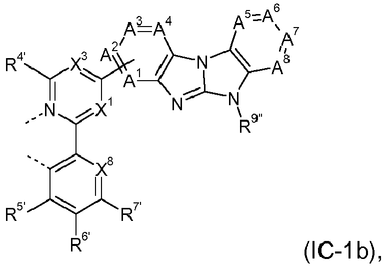 preferably 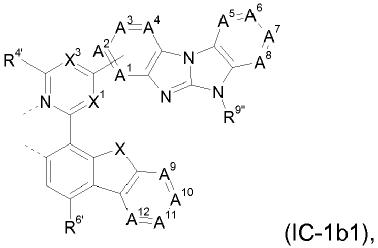 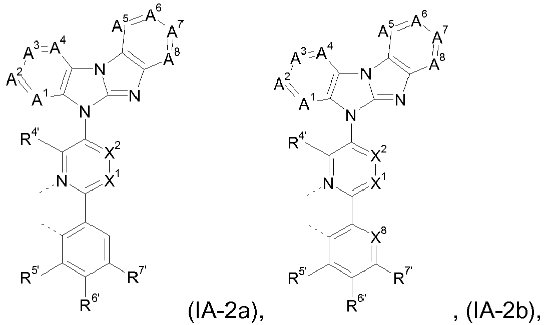 preferably 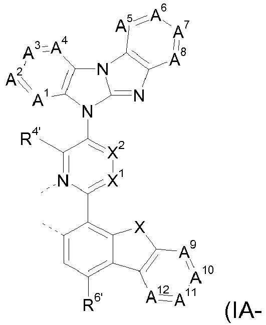 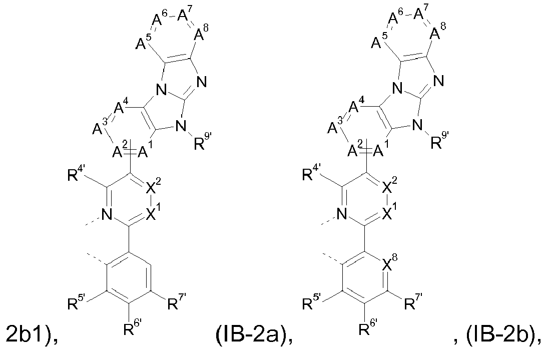 preferably 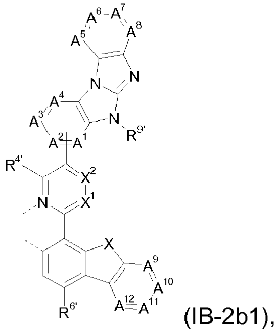 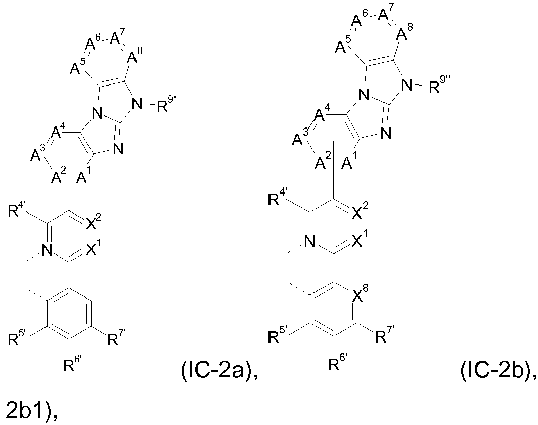 preferably 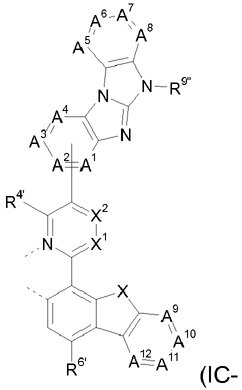
wherein A⁹ is CR⁹ or N, A¹⁰ is CR¹⁰ or N, A¹¹ is CR¹¹ or N, A¹² is CR¹² or N, wherein 0, 1 or 2, preferably 0 or 1, more preferably, 1 of A⁹, A¹⁰, A¹¹, A¹² are N, most preferably, A⁹ is N, X⁸ is CR^{8'}, wherein R^{8'} is H or forms a ring as defined below together with R^{7'};
R^{5'} is H or forms a ring as defined below together with R^{6'};
wherein R^{6'} and R^{7'} or R^{7'} and R^{8'} in formulae (IA-1b), (IB-1b), (IC-1b), (IA-2b), (IB-2b) and (IC-2b) together form a ring of the following formula: 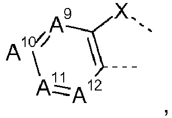 or R^{5'} and R^{6'} or R^{6'} and R^{7'} or R^{7'} and R^{8'} in formulae (IA-1b), (IB-1b), (IC-1b), (IA-2b), (IB-2b) and (IC-2b) together form a ring of the following formula: 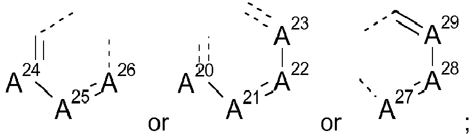
A²⁰ is CR²⁰ or N, A²¹ is CR²¹ or N, A²² is CR²² or N, A²³ is CR²³ or N, A²⁴ is CR²⁴ or N, A²⁵ is CR²⁵ or N, A²⁶ is CR²⁶ or N, A²⁷ is CR²⁷ or N, A²⁸ is CR²⁸ or N and A²⁹ is CR²⁹ or N, wherein 0 or 1, preferably 0 of A^{20'}, A²¹, A²² and A²³, respectively of A²⁴, A²⁵ and A²⁶, respectively of A²⁷, A²⁸ and A²⁹ are N,
R⁹, R¹⁰, R¹¹ and R¹², R²⁰, R²¹, R²², R²³, R²⁴, R²⁵, R²⁶, R²⁷, R²⁸ and R²⁹ are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted five or six membered heteroaromatic ring, an -OR^{c'} group, an -SR^{c'} group or an SiR^{d'}R^{e'}R^{f'} group; preferably hydrogen, deuterium, a substituted or unsubstituted alkyl group having 1 to 30 carbon atoms, a substituted or unsubstituted cycloalkyl group having 3 to 30 ring carbon atoms,
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
and
X is O or S,
wherein the dotted lines are bonding sites.

4. The metal complex according to any one of claims 1 to 3 having one of the formulae (IIA), (IIB) or (IIC), preferably of formula (IIA), 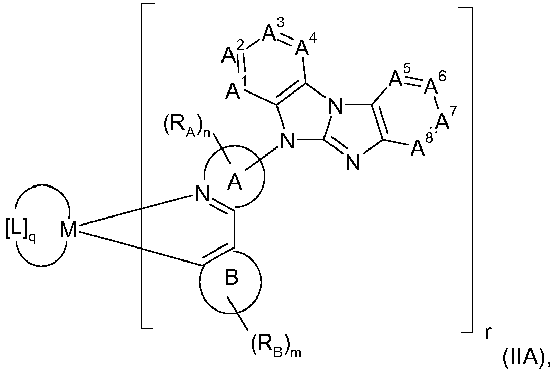 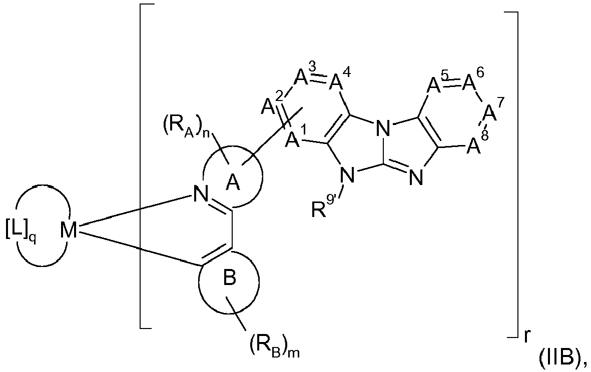 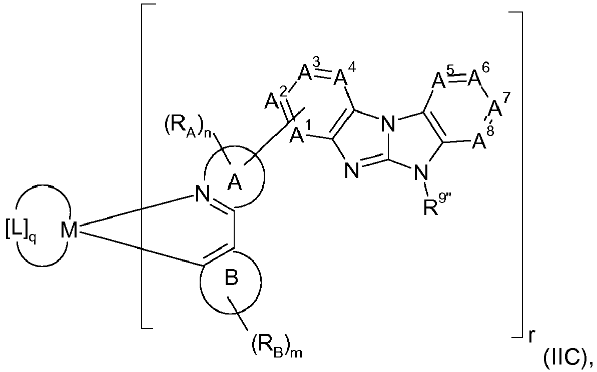 wherein
M is Pt or Ir, preferably Ir;
if M is Ir, r is 1, 2 or 3, preferably 1, q is 0,1 or 2 and the sum of r + q = 3;
in the case that q = 2, the ligands L may be the same of different, preferably the same; and in the case that r is 2 or 3, the r ligands may be the same or different, preferably the same;
if M is Pt, r is 1 or 2, q is 0 or 1; and the sum of r + q = 2;
in the case that r is 2, the r-ligands may be the same or different, preferably the same; and L is a monoanionic bidentate ligand.

5. The metal complex according to claim 4, having one of the following formulae (IIA-1), (IIA-2), (IIB-1), (IIB-2), (IIC-1) or (IIC-2), preferably (IIA-1) or (IIA-2),

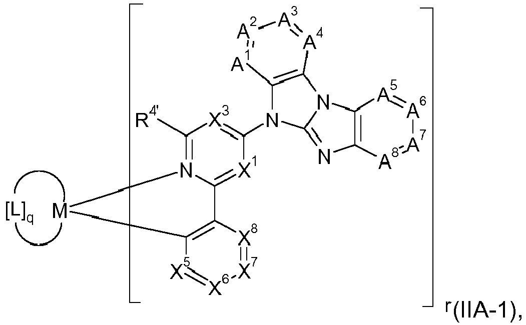

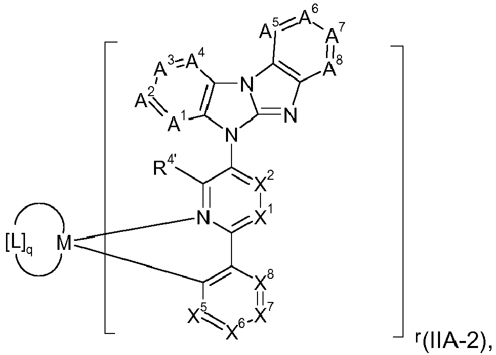

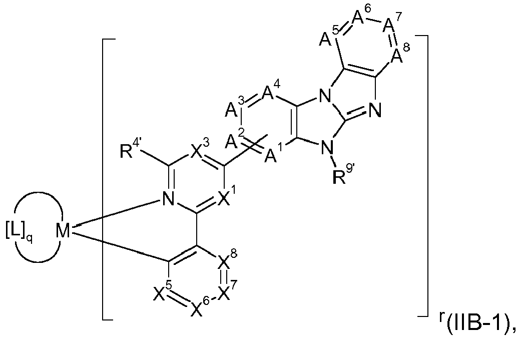

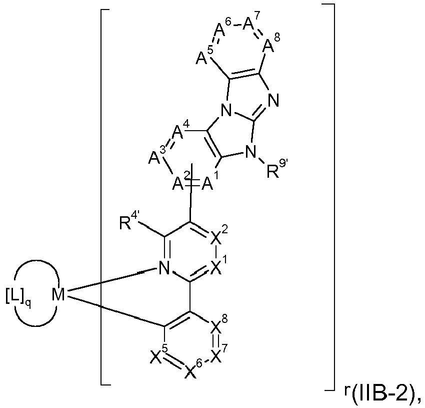

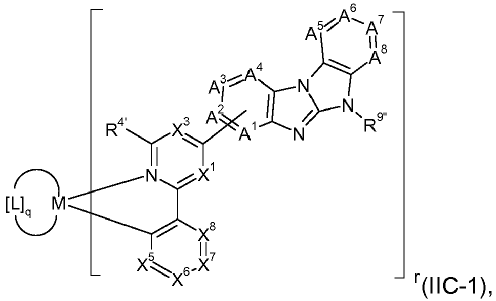

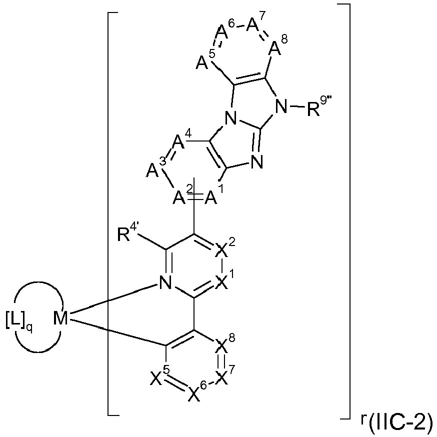

6. The metal complex according to claim 4, wherein L is 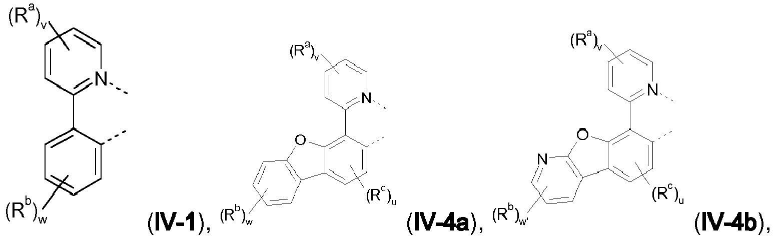 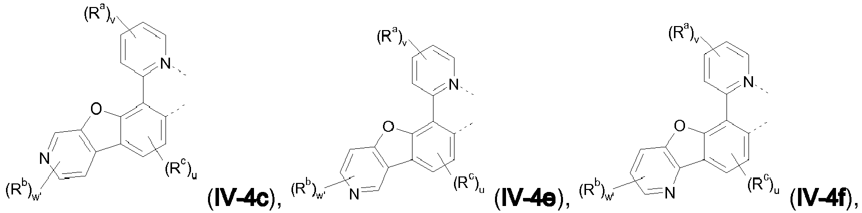 wherein
R^{a}, R^{b} and R^{c} are each independently hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted five or six membered heteroaromatic ring, an -OR^{c'} group, an -SR^{c'} group or an SiR^{d'}R^{e'}R^{f'} group; provided that, two or more adjacent substituents R^{a} or R^{b} in ligands (IV-1), (IV-2) and (IV-3) may be bonded to each other to form a ring structure;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
v and w are each independently 0, 1, 2, 3 or 4, preferably 0, 1 or 2;
w' is 0, 1, 2 or 3, preferably 0, 1 or 2;
u is 0, 1 or 2, preferably 0 or 1;
wherein the dotted lines are bonding sites.

7. An organic electronic device comprising at least one metal complex according any one of claims 1 to 6.

8. The organic electronic device according to claim 7, wherein the organic electronic device is selected from organic light-emitting diodes (OLEDs), organic photovoltaic cells (OPVs), organic field-effect transistors (OFETs) and light-emitting electrochemical cells (LEDs).

9. A light-emitting layer comprising at least one metal complex according to any one of claims 1 to 6.

10. The light emitting layer according to claim 9, comprising at least one metal complex according to any one of claims 1 to 6 and at least one host material.

11. An apparatus selected from the group consisting of stationary visual display units such as visual display units or computers, televisions, visual display units and printers, kitchen appliances and advertising panels, illuminations, information panels, and mobile visual display units such as visual display units in cell phones, tablets, PCs, laptops, digital cameras, MP3 players, vehicles and destination displays from busses and trains; illumination units; keyboards; items of clothing; furniture; wallpaper; comprising the organic electronic device according to claim 7 or 8 or the emitting layer according to claim 9 or 10.

12. Use of the metal complex according to any one of claims 1 to 6 for electrophotographic photoreceptors, photoelectric converters, solar cells (organic photovoltaics), switching elements, organic light-emitting field-effect transistors (OLE-FETs), image sensors, dye lasers and electric luminescent devices.

13. A compound of formulae (IA*), (IB*) or (IC*) 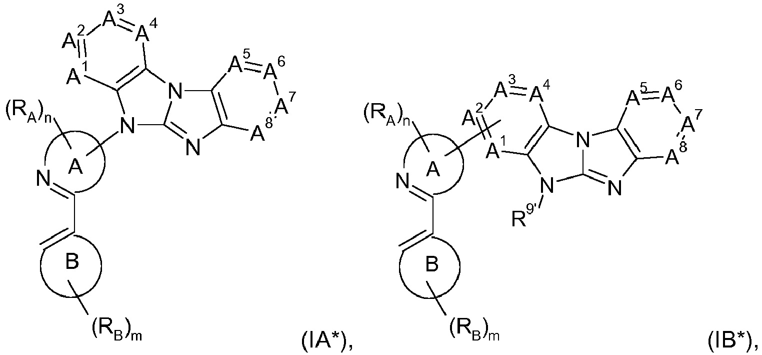 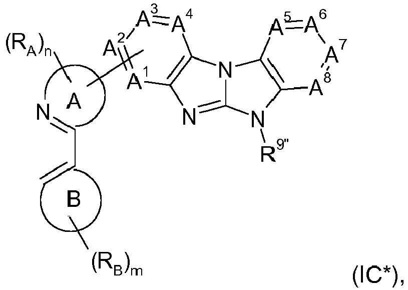 preferably of formula (IA*),
wherein
ring A is a heterocyclic group having 5 to 30 ring atoms, preferably a five or six membered heterocyclic ring, more preferably a five or six membered heteroaromatic ring,
ring B is an aromatic hydrocarbon group having 6 to 30 ring atoms, preferably an aromatic hydrocarbon group having 5 or 6 ring carbon atoms or a heterocyclic group having 5 to 30 ring atoms, preferably a heterocyclic group having 5 or 6 ring atoms, more preferably a heteroaromatic group having 6 ring atoms,
wherein A-B represents a bonded pair of hydrocarbon or heterocyclic rings coordinated to the metal via a nitrogen atom on ring A and via an sp² hybridized carbon atom on ring B, R_{A} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 carbon atoms, a substituted or unsubstituted heterocyclic group having 5 to 30 ring atoms, an -OR^{c'} group, an-SR^{c'} group or an SiR^{d'}R^{e'}R^{f'} group;
R^{c'}, R^{d'}, R^{e'} and R^{f'} are each independently a substituted or unsubstituted aromatic hydrocarbon group having 6 to 30 ring carbon atoms, a substituted or unsubstituted heterocyclic group having 5 to 30 ring atoms;
n is 0, 1 or 2, preferably 0 or 1,
R_{B} is hydrogen, deuterium, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, a substituted or unsubstituted heterocyclic group having 5 to 30 ring atoms, an -OR^{c'} group, an -SR^{c'} group or an SiR^{d'}R^{e'}R^{f'} group;
and one of R_{B} may be -SR^{a'}, -OR^{a'} or -NR^{a'}R^{b'},
one of R_{A} and one of R_{B} may be connected to each other and form a bridge, for example an alkane-diyl bridge, an alkene-diyl bridge, an arylene-bridge or a heteroarylene bridge, R^{a'}, R^{b'} are each independently a substituted or unsubstituted aromatic hydrocarbon group having 6 to 30 ring carbon atoms, a substituted or unsubstituted heterocyclic group having 5 to 30 ring atoms,
m is 0, 1, 2 or 3, preferably 0, 1 or 2,
in the case that m is ≥ 2, two adjacent residues R_{B} may form together a ring, preferably a five or six membered ring, which is unsubstituted or substituted and may be fused with one or more, preferably one, further unsubstituted or substituted carbocyclic or heterocyclic five or six membered ring,
A¹ is CR¹ or N, A² is CR² or N, A³ is CR³ or N, A⁴ is CR⁵ or N, A⁵ is CR⁵ or N, A⁶ is CR⁶ or N, A⁷ is CR⁷ or N and A⁸ is CR⁸ or N, whereby preferably 0, 1 or 2, more preferably 0 or 1, most preferably 0 of A¹ to A⁸ are N,
wherein - in formula (IB) and (IC) A¹, A², A³ and A⁴ is CR¹, CR², CR³ respectively CR⁴, wherein one of R¹, R², R³ respectively R⁴ is a bonding site to the ring A, R¹, R², R³, R⁴, R⁵, R⁶, R⁷ and R⁸ are each independently hydrogen, deuterium, a substituted or unsubstituted alkyl group having 1 to 30 carbon atoms, a substituted or unsubstituted cycloalkyl group having 3 to 30 ring carbon atoms, a substituted or unsubstituted aromatic hydrocarbon group having 6 to 30 ring carbon atoms, or a substituted or unsubstituted heterocyclic group, having 5 to 30 ring atoms, provided that, two substituents selected from R¹, R², R³, R⁴ respectively from R⁵, R⁶, R⁷ and R⁸ may be bonded to each other to form a ring structure,
R^{9'}, R^{9"} are each independently a substituted or unsubstituted aromatic hydrocarbon group having 6 to 30 ring carbon atoms, or a substituted or unsubstituted heterocyclic group having 5 to 30 ring atoms.
